(19) Europäisches Patentamt
European Patent Office
Office européen des brevets

(11) EP 2 472 330 B1

(12) **EUROPEAN PATENT SPECIFICATION**

(45) Date of publication and mention of the grant of the patent:
**25.01.2017 Bulletin 2017/04**

(51) Int Cl.:
***G03F 7/105*** *(2006.01)*
***C09C 1/36*** *(2006.01)*
***H01L 27/146*** *(2006.01)*
*G03F 7/033* *(2006.01)*

(21) Application number: **11191304.2**

(22) Date of filing: **30.11.2011**

(54) **Black radiation-sensitive composition, black cured film, solid-state imaging element, and method of producing black cured film**

Schwarze strahlungsempfindliche Zusammensetzung, schwarzer gehärteter Film, Festkörperabbildungselement und Verfahren zum Herstellen eines schwarzen gehärteten Films

Composition sensible au rayonnement noire, film durci noir, élément d’imagerie semi-conducteur et procédé de fabrication du film durci noir

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.12.2010 JP 2010294044**

(43) Date of publication of application:
**04.07.2012 Bulletin 2012/27**

(73) Proprietor: **Fujifilm Corporation**
**Minato-ku**
**Tokyo (JP)**

(72) Inventors:
- **Muro, Naotsugu**
  **Shizuoka-ken (JP)**
- **Kubota, Makoto**
  **Shizuoka-ken (JP)**

(74) Representative: **Hoffmann Eitle**
**Patent- und Rechtsanwälte PartmbB**
**Arabellastraße 30**
**81925 München (DE)**

(56) References cited:
**EP-A1- 2 492 716**
**WO-A1-2011/049090**
**JP-A- 2001 115 043**
**JP-A- 2004 204 175**
**JP-A- 2006 182 627**
**US-A1- 2008 318 018**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

BACKGROUND

Technical Field

The present invention relates to a black radiation-sensitive composition, a black cured film, a solid-state imaging element, and a method of producing a black cured film.

Related Art

High-resolution imaging units are mounted on digital cameras and the like. Imaging units are generally equipped with a solid-state imaging element, such as a charge coupled device (CCD) image sensor or a complementary metal-oxide semiconductor (CMOS) image sensor. In a solid-state imaging element (hereinbelow, also referred to as an "image sensor"), optical black area (i.e., dark current measurement area) peripheral circuits are arranged at the periphery of a light receiving unit including many photoelectric conversion elements, and charge transport, dark current measurement, signal amplification or the like is carried out at the area. When light enters the area, a noise occurs and image quality of an image sensor diminishes. In order to prevent these problems, a light blocking unit (i.e., black matrix) is formed on the light incident side of the area.

A black matrix is formed from a radiation-sensitive composition containing a dispersion composition, in which a light blocking black color material is dispersed, a polymerizable compound, a photopolymerization initiator, and other components. The black matrix is produced by forming a pattern using the composition by photolithography, etc.

As a composition for forming a black matrix for a solid-state imaging element, a radiation-sensitive composition containing a black color material, such as carbon black or titanium black, is known.

Conventionally, carbon black has been mainly used as a light blocking black matrix. However, in order to enhance a light blocking property with carbon black, it is necessary to increase the filling amount of carbon black. Therefore, a dispersion composition or a radiation-sensitive composition having a high concentration of carbon black as a light blocking material is required for forming a pattern of a light blocking layer. However, there have been problems such as when the content of carbon black is increased in order to obtain a high light blocking property, dispersion of carbon black becomes difficult or pattern formability is deteriorated.

As a black color material that exhibits a high light blocking property even in a thin film, use of titanium black is suggested. For example, Japanese Patent Application Laid-Open (JP-A) No. 2007-115921 discloses a light blocking film forming composition in which titanium black is used as a material for blocking light at the periphery of a solid-state imaging element.

Further, in order to obtain a high light blocking property of titanium black, various suggestions have been made regarding surface treatment of titanium black. For example, JP-A No. 2002-285007 discloses a black resin composition containing titanium black particles that are coated with silicon dioxide micro particles.

However, since titanium black has a large specific gravity, there are problems in that titanium black is difficult to be dispersed, and titanium black tends to precipitate after being dispersed over time. As such, stability over time of the compositions described in JP-A No. 2007-115921 and JP-A No. 2002-285007 is insufficient.

Further, since a radiation-sensitive composition containing titanium black has a light blocking property, when the composition is used for forming a patterned light blocking film by photolithography, there is a problem in that an exposure light does not easily penetrate the composition layer, thereby easily generating residual materials (hereinbelow, it is appropriately referred to as "residues" in the detailed description) originating from a radiation-sensitive composition at the periphery of a light blocking film.

US-A-2008/318018 discloses a black resin composition for a display device comprising a black titanium oxynitride represented by composition formula $TiN_xO_y$-$nSiO_2$ (wherein x and y each are a real number of larger than 0 but less than 2, and n is a real number within the range of $0 \leq n \leq 0.05$), which contains nitrogen in an amount of 17-23 wt.%. The black titanium oxynitride has a specific surface area of 5 to 30 $m^2/g$ and a crystalline size as measured with an X-ray diffractometer of 17 to 25 nm.

The invention has been made in view of the circumstances as set forth above, and aims to achieve the following objectives.

An object of the invention is to provide a black radiation-sensitive composition for a solid-state imaging element, the composition exhibiting excellent stability over time, and generating a suppressed amount of residues originating from a radiation-sensitive composition at an area outside a region at which a cured film is to be formed, when the composition is used for forming a black cured film, such as a light blocking film; to provide a black cured film formed from the black radiation-sensitive composition and a method of producing the same; and to provide a solid-state imaging element having the black cured film and capable of forming a high-quality image.

Means for Solving the Problems

The inventors have found made intensive studies and, as a result, found that the problems can be solved by the following embodiments.

<1> A black radiation-sensitive composition comprising:

(D) a photopolymerizable compound comprising at least one compound represented by Formula (Z-4) or Formula (Z-5):

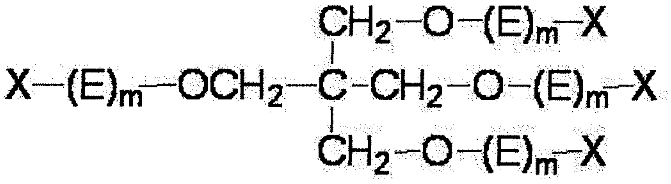

(Z-4)

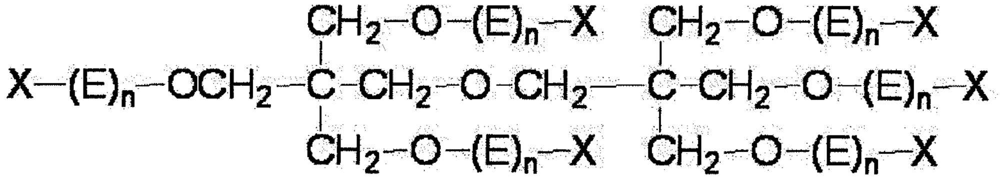

(Z-5)

wherein each E independently represents $-((CH_2)_yCH_2O)$ - or $-((CH_2)_yCH(CH_3)O)$-; each y independently represents an integer from 0 to 10; each X independently represents an acryloyl group, a methacryloyl group, a hydrogen atom or a carboxyl group; in Formula (Z-4) the sum of the acryloyl group/s and the methacryloyl group/s is 3 or 4, each m independently represents an integer from 0 to 10, and the sum of all m's is an integer from 0 to 40 provided that any one of X is a carboxyl group when the sum of all m's is 0; and in Formula (Z-5) the sum of the acryloyl group/s and the methacryloyl group/s is 5 or 6, each n independently represents an integer from 0 to 10, and the sum of all n's is an integer from 0 to 60 provided that any one of X is a carboxyl group when the sum of all n's is 0;
(E) a photopolymerization initiator; and
a titanium black dispersion composition comprising:

(A) particles comprising titanium black and Si atoms dispersed within the composition;
(B) a dispersant; and
(C) an organic solvent;

wherein 90% or more of the particles have a particle diameter in the range of 16-30 nm and the mass ratio (Si/Ti) of Si atoms to Ti atoms in the component (A) is from 0.20 to 0.50;
wherein the particle diameter of the dispersed particles is measured by dropping a liquid sample consisting of a 100-fold dilution of the titanium black dispersion composition in propylene glycol monomethyl ether acetate on carbon foil; drying the sample; obtaining a transmission electron microscope image of the dried sample; and calculating the particle diameter of each of 400 particles by determining the projected outer surface area of each particle and calculating the diameter of a sphere having the same outer surface; and
wherein the Si/Ti ratio is calculated by elemental analysis of a solution obtained by drying a sample of the titanium black dispersion composition by heating in an oxygen atmosphere; dissolving 20 mg of the dried sample in 0.1 mL of HF, 1 mL of 10 % aq. $HNO_3$, 1 mL of 5% aq. $H_2SO_4$ and 1 mL of 3% aq. HCl with the aid of microwave dissolution conducted at 180°C; and dissolving the obtained mixture in 100 mL of water ready for elemental analysis.

<2> A black radiation-sensitive composition according to <1> above, wherein the photopolymerizable initiator comprises an oxime compound.
<3> A black radiation-sensitive composition according to <1> or <2> above, further comprising a fluorinated surfactant.
<4> A black cured film obtainable by curing the black radiation-sensitive composition according to any of <1> to <3> above.

<5> A solid-state imaging element comprising the black cured film according to <4> above.

<6> A method of producing a black cured film, the method comprising:

forming a black radiation-sensitive composition layer by applying the black radiation-sensitive composition according to any one of <1> to <3> above onto a silicon substrate;

exposing the black radiation-sensitive composition layer to light in a patterned manner; and

forming a pattern by developing the exposed black radiation-sensitive composition layer.

Effect of the Invention

According to the invention, it is possible to provide a black radiation-sensitive composition for a solid-state imaging element, the composition exhibiting excellent stability over time, and generating a suppressed amount of residues originating from a radiation-sensitive composition at an area outside a region at which a cured film is to be formed, when the composition is used for forming a black cured film, such as a light blocking film; a black cured film formed from the black radiation-sensitive composition and a method of producing the same; and a solid-state imaging element having the black cured film and capable of forming a high-quality image.

DETAILED DESCRIPTION OF THE INVENTION

Hereinbelow, the black radiation-sensitive composition for a solid-state imaging element of the invention are explained in detail.

<Black radiation-sensitive composition for solid-state imaging element>

The black radiation-sensitive composition comprises a titanium black dispersion composition (hereinbelow, also simply referred to as "dispersion composition") which is a titanium black dispersion composition for forming a light blocking film of a solid-state imaging element. The dispersion composition contains (A) particles containing titanium black and Si atoms, (B) a dispersant, and (C) an organic solvent, and 90% or more of the particles have a particle diameter in the range of from 16 nm to 30 nm and the mass ratio of Si atoms to Ti atoms in the particles (Si/Ti) is from 0.20 to 0.50.

The black radiation-sensitive composition for a solid-state imaging element of the invention (hereinbelow, also simply referred to as a "radiation-sensitive composition") is a radiation-sensitive composition which contains the titanium black dispersion composition of the invention, (D) a photopolymerizable compound comprising at least one compound represented by Formula (Z-4) or Formula (Z-5):

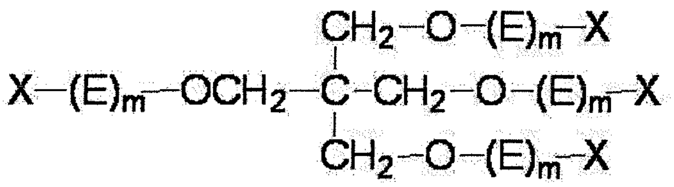

(Z-4)

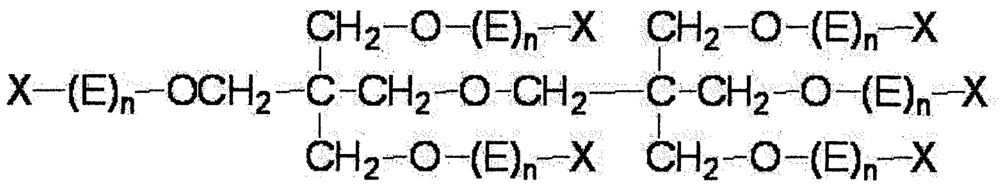

(Z-5)

wherein each E independently represents $-((CH_2)_yCH_2O)-$ or $-((CH_2)_yCH(CH_3)O)-$; each y independently represents an integer from 0 to 10; each X independently represents an acryloyl group, a methacryloyl group, a hydrogen atom or a carboxyl group; in Formula (Z-4) the sum of the acryloyl group/s and the methacryloyl group/s is 3 or 4, each m independently represents an integer from 0 to 10, and the sum of all m's is an integer from 0 to 40 provided that any one of X is a carboxyl group when the sum of all m's is 0; and in Formula (Z-5) the sum of the acryloyl group/s and the methacryloyl group/s is 5 or 6, each n independently represents an integer from 0 to 10, and the sum of all n's is an integer from 0 to 60 provided that any one of X is a carboxyl group when the sum of all n's is 0; and

(E) a photopolymerization initiator.

The radiation-sensitive composition of the invention is suitably used for forming a light blocking film which is formed on a silicon substrate of a solid-state imaging element, an anti-reflection film, a light blocking film arranged at the periphery of an effective pixel region of a solid-state imaging element (imaging unit), and other types of films.
Hereinbelow, the components contained in the titanium black dispersion composition or the radiation-sensitive composition of the invention are explained.

(A) Particles comprising titanium black and Si atoms disposed within the composition.

The titanium black dispersion composition and the radiation-sensitive composition of the invention contain (A) particles containing titanium black and Si atoms (hereinbelow, also simply referred to as "particles").
In the dispersion composition of the invention, it is necessary that 90% or more of the particles have a particle diameter in the range of from 16 nm to 30 nm and the mass ratio of Si atoms to Ti atoms in the particles (i.e., Si/Ti) is from 0.20 to 0.50.
The radiation-sensitive composition of the invention contains particles originating from the dispersion composition of the invention. It is also necessary that 90% or more of the particles, contained in the radiation-sensitive composition or a cured film obtained by curing the composition (i.e., light blocking film), have a particle diameter of from 16 nm to 30 nm and the mass ratio of Si atoms to Ti atoms in the particles (i.e., Si/Ti) is from 0.20 and 0.50.
According to the invention, the particle diameter of the particles refers to a diameter of a particle that constitutes the particles, and it corresponds to a diameter of a circle having an area equal to a projected area of an outer surface of the particle. The projected area of the particle is obtained by measuring the area resulting from an electron microscopic image and calibrating the area against the magnification ratio.
As described herein, the particles of the invention include a material in the form of primary particles and a material in the form of an aggregate (secondary particles).
According to the invention, 90% or more of the particles are particles having a particle diameter in the range of from 16 nm to 30 nm. The particle diameter is preferably in the range of from 17 nm to 27 nm, and more preferably in the range of from 17 nm to 23 nm.
Further, the mass ratio of Si atoms to Ti atoms (Si/Ti) in the particles of the invention is in the range of from 0.20 to 0.50, preferably in the range of from 0.25 to 0.47, and more preferably in the range of from 0.30 to 0.45.
When the particle diameter and the Si/Ti of the particles fall within the ranges as described above, the titanium black dispersion composition containing the particles can be easily produced and its stability over time can be improved. Further, when a light blocking film is formed from a radiation-sensitive composition containing the titanium black dispersion composition by photolithography, generation of residues can be suppressed.
The particles of the invention can be produced by, for example, a method of heating a mixture solution containing titanium oxide, silica particles and a dispersant at high temperature (from 750°C to 1100°C) under an oxygen atmosphere, and then reducing the mixture.
More specifically, for example, the particles of the invention can be suitably obtained by a method of preparing a mixture solution containing titanium oxide, silica particles and a dispersant as raw materials, heating the mixture at a temperature of from 750°C to 1100°C (preferably from 850°C to 1000°C) under an oxygen atmosphere, purging with nitrogen, and then reducing the resultant with an ammonia gas.
By appropriately selecting the amount of the silica particles used in this method, the particle diameter of the finally obtained particles can be controlled to be within the range of from 16 nm to 30 nm.
The dispersant may be, for example, (B) a dispersant contained in the titanium black dispersion composition and the radiation-sensitive composition as described below.
In order to adjust the Si/Ti ratio of the particles to be within the range of from 0.20 to 0.50, the following process can be employed.
For example, in a method of obtaining a dispersion composition by dispersing a mixture of titanium oxide and silica particles and subjecting the dispersion composition at high temperature, as mentioned above, the Si/Ti ratio can be adjusted by changing the mixing ratio between titanium oxide and silica particles.
Further, for example, the Si/Ti ratio in the particles can be adjusted according to a method described in paragraph [0005] and paragraphs [0016] to [0021] of JP-A No. 2008-266045.
With regard to the particles contained in a cured film (light blocking film) obtained by curing the radiation-sensitive composition of the invention, 90% or more of the particles have a particle diameter in the range of from 16 nm to 30 nm. Further, the mass ratio of Si atoms to Ti atoms (Si/Ti) in the particles is in the range of from 0.20 to 0.50. The preferred range of the particle diameter and the Si/Ti are also the same as that defined above.
Since 90% or more of the particles containing titanium black and Si atoms are particles having a particle diameter in the range of from 16 nm to 30 nm, and the mass ratio of Si atoms to Ti atoms (Si/Ti) in the particles is in the range of from 0.20 to 0.50, the dispersion composition and the radiation-sensitive composition containing the particles of the invention exhibit favorable stability over time. Further, when a light blocking film is formed by using the radiation-sensitive

composition, generation of residues originating from a radiation-sensitive composition in an area outside a region at which the light blocking film is to be formed is suppressed. The residues include components originating from the radiation-sensitive composition, for example, titanium black, a resin component, and the like.

Although the details as to how the dispersion composition and the radiation-sensitive composition of the invention exhibit favorable stability over time remain unclear, it is assumed that adsorption of a dispersant contained in the composition with respect to titanium black contained in the particles is optimized as a result of including Si atoms existing in the particles at a certain mass ratio.

Further, although the details as to how the amount of generation of residues during formation of a cured film remains unclear, it is assumed that aggregation of the particles in the radiation-sensitive composition is effectively reduced because of the fact that 90% or more of the particles having a small particle diameter of from 16 nm to 30 nm, and adsorption of the dispersant with respect to titanium black in the particles is optimized as mentioned above, whereby a film in which the particles are finely and uniformly dispersed can be formed, and generation of residues originating from the aggregates of the particles is reduced, when the radiation-sensitive composition is used for forming a cured film.

Further, since titanium black exhibits an excellent light blocking property against light in the broad wavelength range of from the ultraviolet region to the infrared region, the light blocking film formed from the dispersion composition or the radiation-sensitive composition of the invention exhibits an excellent light blocking property.

In order to determine whether or not 90% of the particles contained in the titanium black dispersion or the radiation-sensitive resin composition of the invention has a particle diameter in the range of from 16 nm to 30 nm, the following method (A-1) is employed.

In order to determine whether or not 90% of the particles contained in the cured film (light blocking film), which is obtained by curing the radiation-sensitive resin composition of the invention, has a particle diameter in the range of 16 nm to 30 nm, the following method (A-2) is employed.

<Method (A-1)>

A sample liquid is obtained by diluting by 100 times the titanium black dispersion or the radiation-sensitive resin composition with propylene glycol monomethyl ether acetate (hereinbelow, also referred to as "PGEMA"). The obtained sample liquid is dropped on a carbon foil and dried. An image is taken for morphological observation with a transmission electron microscope. A projected area of an outer surface of four-hundred particles is obtained from the photographic image. The diameter of a circle corresponding to the projected area of each particle is calculated, and the particle size distribution is evaluated.

<Method (A-2)>

A cured film is scraped off from a substrate on which the light blocking film has been formed, and the cured film is placed on a quartz board and heated for 60 min at 500°C under an oxygen flow of 100 mL/min with an electric furnace, thereby obtaining a powder. The powder obtained by the heat treatment is diluted by 100 times with propylene glycol monomethyl ether acetate to prepare a sample liquid. The sample liquid is then dropped on a carbon foil and dried. An image is taken for morphological observation with a transmission electron microscope. A projected area of an outer surface of four-hundred particles is obtained from the photographic image. The diameter of a circle corresponding to the projected area of each particle is calculated, and the particle size distribution is evaluated.

In order to determine whether or not the mass ratio of Si atoms to Ti atoms (Si/Ti) in the particles of the titanium black dispersion composition or the radiation-sensitive composition of the invention is in the range of from 0.20 to 0.50, the following method (B-1) or the following method (B-2) is employed.

<Method (B-1)>

The titanium black dispersion composition or the radiation-sensitive composition is heated under an oxygen atmosphere, and titanium black particles are collected.

20 mg of the titanium black dispersion composition or the radiation-sensitive composition is weighed, and 0.1 mL of HF, 1 mL of $HNO_3$ (10% aq.), 1 mL of $H_2SO_4$ (5% aq.) and 1 mL of HCl (3% aq.) are added thereto. Microwave dissolution is carried out at a liquid temperature of 180°C.

Thereafter, 100 mL of $H_2O$ is added to the mixture liquid, and the resultant is subjected to element analysis with an ICP-OES analyzer (trade name: ATTOM, manufactured by SII NanoTechnology Inc.) The Si/Ti ratio by mass is calculated from the results obtained by the element analysis.

<Method (B-2)>

The titanium black dispersion composition or the radiation-sensitive composition is heated at 700°C under an oxygen atmosphere with a small rotary kiln (manufactured by Motoyama Inc.) After maintaining for 30 minutes and cooling to obtain 2 g of a powder, it is placed on a tungsten plate with a thickness of 0.2 mm, and this is placed in a vacuum chamber equipped with an electron beam heating system. With a vacuum level of $10^{-5}$ Torr or less, heat treatment is carried out for 30 seconds at 1000°C by electron beam heating. The atomic weight of Si and the atomic weight of Ti of the powder after being subjected to heat treatment are determined with a field emission scanning electron microscope S-4800 (trade name, manufactured by Hitachi Technologies) and an energy dispersive fluorescence X ray detector INCA ENERGY PENTAFETX3 (trade name, manufactured by Oxford Instruments), whereby the Si/Ti ratio is calculated.
Further, in order to determine whether or not the particles contained in a cured film (light blocking film), which is obtained by curing the radiation-sensitive composition of the invention, has a mass ratio of Si atoms to Ti atoms (Si/Ti) within 0.20 to 0.50 in the particles, the following method (C) is employed.

<Method (C)>

A cross section of a light blocking film is obtained by splitting a substrate on which a light blocking film is formed, and the cross section is measured with an energy dispersive fluorescence X ray analyzer to determine the Si atomic mass and the Ti atomic mass at a surface of the light blocking film, and the ratio thereof is evaluated as the Si/Ti ratio in the light blocking film.
As for the energy dispersive fluorescence X ray analyzer used for this method, a scanning electron microscope S-4800 (trade name, manufactured by Hitachi Technologies) and an energy dispersive fluorescence X ray detector INCA ENERGY PENTAFETX3 (trade name, manufactured by Oxford Instruments), as described above, may be used.
Hereinbelow, titanium black is explained in greater detail.
Titanium black used in the invention is black particles including titanium atoms. Preferably, it is black particles such as low-order titanium oxide or titanium oxynitride.
The surface of titanium black may be modified, if necessary, for the purpose of improving dispersibility, suppressing aggregation, and the like. Specifically, the surface of titanium black may be modified by coating with silicon oxide, titanium oxide, germanium oxide, aluminum oxide, magnesium oxide, zirconium oxide, or the like. Alternatively, the surface of titanium black may be treated with a water repellent substance described in JP-A No. 2007-302836.
Examples of commercial products of titanium black include TITANIUM BLACK 10S, 12S, 13R, 13M, 13M-C, 13R, 13R-N, and 13M-T (trade names, all manufactured by Mitsubishi Materials Corporation) and TILACK D (trade name, manufactured by AKO KASEI CO., LTD.)
Examples of the method of preparing titanium black include, but not limited thereto, a method in which a mixture of titanium dioxide and metal titanium is reduced by heating the same in a reductive atmosphere (for example, a method described in JP-A No. 49-5432); a method in which ultra fine titanium dioxide obtained by carrying out high-temperature hydrolysis of titanium tetrachloride is reduced in a reductive atmosphere containing hydrogen (for example, a method described in JP-A No. 57-205322); a method in which titanium dioxide or titanium hydroxide is reduced at high temperature in the presence of ammonia (for example, a method described in JP-A No. 60-65069 or JP-A No. 61-201610); and a method in which a vanadium compound is attached to titanium dioxide or titanium hydroxide, and then the resultant is reduced at high temperature in the presence of ammonia (for example, a method described in JP-A No. 61-201610).
It is preferable that each particle of titanium black used in the invention has a small primary particle diameter, in addition to a small average primary particle diameter.
The radiation-sensitive composition of the invention may contain either a single type of titanium black, or two or more kinds thereof in combination.
Further, as long as the effect of the invention is not inhibited, for the purpose of adjusting dispersibility and a coloring power, etc., a black pigment formed from a complex oxide of Cu, Fe, Mn, V, Ni or the like, cobalt oxide, iron oxide, carbon black, and aniline black, etc. may be used as the particles either singly or in combination of two or more kinds, in addition to titanium black.
In that case, it is preferable that 50% by mass or more of the total particles are titanium black particles.
As desired, for the purpose of adjusting a light blocking property, etc., other coloring materials (e.g., organic pigment or dye, etc.) may be used in combination with the particles containing titanium black and Si atoms, as long as the effect of the invention is not inhibited, as described later.
The content of the particles in the titanium black dispersion composition with respect to the total solid content of the dispersion composition is preferably from 5% by mass to 60% by mass, and more preferably from 10% by mass to 50% by mass.
Further, the content of the particles in the radiation-sensitive composition with respect to the total solid content of the radiation-sensitive composition is preferably from 2.5% by mass to 30% by mass, and more preferably from 5%

by mass to 20% by mass.

The total solid content of the dispersion composition and the total solid content of the radiation-sensitive composition refer to the mass of the total dispersion composition or the total radiation-sensitive composition from which an organic solvent is excluded.

In the invention, it is necessary that the mass ratio of Si atoms to Ti atoms (Si/Ti) in the particles is in the range of from 0.20 to 0.50.

Hereinbelow, a material used for introducing Si atoms into the particles is explained.

In order to introduce Si atoms into the particles, a Si-containing material, such as silica, may be used.

Examples of silica that can be used in the invention include precipitated silica, fumed silica, colloidal silica, and synthetic silica, which may be appropriately selected and used.

Silica can be obtained as a commercially available product, and examples thereof include HS-101, HS-102, HS-103, HS-104, HS-105, HS-106, HS-107, HS-201, HS-202, HS-203, HS-204, HS-205, HS-301, HS-302, HS-303, HS-304, HS-305 (trade names, manufactured by Nippon Steel Materials Co., Ltd.); HIPRESICA SS, HIPRESICA TS, HIPRESICA BS, HIPRESICA SP, HIPRESICA FQ (trade names, manufactured by UBE-NITTO KASEI CO., LTD.); CAB-O-SIL (registered trademark) LM-150, CAB-O-SIL (registered trademark) LM-150, and CAB-O-SIL (registered trademark) S-17D, manufactured by Cabot Corporation.

Since a reduction in a light blocking property may be caused when the particle diameter of silica particles is approximately the same as the film thickness of a light blocking film, it is preferable to use micro particle type silica as silica particles. Examples of the micro particle type silica include AEROSIL (registered trademark) 90, AEROSIL (registered trademark) 130, AEROSIL (registered trademark) 150, AEROSIL (registered trademark) 200, AEROSIL (registered trademark) 300, AEROSIL (registered trademark) 380, AEROSIL (registered trademark) OX 50, AEROSIL (registered trademark) EG 50, AEROSIL (registered trademark) TT 600, AEROSIL (registered trademark) 200 SP, AEROSIL (registered trademark) 300 SP, AEROPERL (registered trademark) 300/30, AEROSIL (registered trademark) R 972, AEROSIL (registered trademark) R 974, AEROSIL (registered trademark) R 104, AEROSIL (registered trademark) R 106, AEROSIL (registered trademark) R 202, AEROSIL (registered trademark) R 805, AEROSIL (registered trademark) R 812, AEROSIL (registered trademark) R 812 S, AEROSIL (registered trademark) R 816, AEROSIL (registered trademark) R 7200, AEROSIL (registered trademark) R 8200, AEROSIL (registered trademark) R 9200, AEROSIL (registered trademark) MOX 80, AEROSIL (registered trademark) MOX 170, AEROSIL (registered trademark) COK 84, AEROSIL (registered trademark) RY 50, AEROSIL (registered trademark) NY 50, AEROSIL (registered trademark) RY 200, AEROSIL (registered trademark) RY 200, AEROSIL (registered trademark) RX 50, AEROSIL (registered trademark) NAX 50, AEROSIL (registered trademark) RX 200, AEROSIL (registered trademark) RX 300, AEROSIL (registered trademark) R 504, AEROPERL (registered trademark) 300/30, VP AEROPERL (registered trademark) P 25/20M05 (manufactured by Evonik Degussa Corporation); S6, MA1004, MA1006, MA1010, MA1013, MX030W, MX050W, MX100W, KE-E30, KE-E40, KE-E50, KE-E70, KE-E150, KE-P10, KE-P30, KE-P50, KE-P100, KE-P150, KE-P250 (trade name, manufactured by (trade name, manufactured by JGC Catalysts and Chemicals Ltd.); HS-101, HS-102, HS-103, HS-104, HS-105, HS-106, HS-107, HS-201, HS-202, HS-203, HS-204, HS-205, HS-301, HS-302, HS-303, HS-304, and HS-305 (trade names, manufactured by Nippon Steel Materials Co., Ltd.); HIPRESICA SS, HIPRESICA TS, HIPRESICA BS, HIPRESICA SP, and HIPRESICA FQ (trade name, manufactured by UBE-NITTO KASEI CO., LTD.); and CAB-O-SIL, LM-150, CAB-O-SIL LM-150, and CAB-O-SIL S-17D (trade name, manufactured by Cabot Corporation). However, the invention is not limited to these products.

(B) Dispersant

The titanium black dispersion composition and the radiation-sensitive composition contain (B) a dispersant.

Examples of the dispersant that can be used in the invention include a polymer dispersant (for example, a polyamidoamine and a salt thereof, a polycarboxylic acid and a salt thereof, a high molecular weight unsaturated acid ester, a modified polyurethane, a modified polyester, a modified poly(meth)acrylate, a (meth)acrylate copolymer, and a naphthalenesulfonic acid-formalin condensate), a polyoxyethylene alkylphosphate, a polyoxyethylene alkylamine, an alkanol amine, and a pigment derivative.

The dispersant used in the invention can be further classified into a straight chained polymer, a terminal end-modified polymer, a graft polymer, and a block polymer, based on the structure of the resin.

The dispersant used in the invention adheres to a surface of the particles such as titanium black or a surface of an optionally used pigment etc., and functions to prevent re-aggregation of titanium black or the like. Accordingly, preferable structures of the dispersant include a terminal end-modified polymer, a graft polymer, and a block polymer, each of which have an anchor moiety with respect to a surface of titanium black or a pigment.

In addition, the dispersant exhibits an effect of modifying a surface of the particles, thereby promoting adsorption of the dispersion resin thereto.

Specific examples of the dispersant used in the invention include: DISPERBYK-101 (trade name, polyamidoamine phosphate), 107 (trade name, carboxylate), 110 (trade name, acid group-containing copolymer), 130 (trade name, polyamide), 161, 162, 163, 164, 165, 166, 170, 180 (trade name, high molecular weight copolymer), BYK-P104 and P105 (trade name, high molecular weight unsaturated polycarboxylic acid), manufactured by BYK Chemie GmbH; EFKA 4047, 4050, 4010, 4165 (trade name, polyurethane compound), EFKA4330, 4340 (trade name, block copolymer), 4400, 4402 (trade name, modified polyacrylate), 5010 (polyester amide), 5765 (trade name, high molecular weight polycarboxylic acid salt), 6220 (trade name, fatty acid polyester), 6745 (trade name, phthalocyanine derivative), 6750 (trade name, azo pigment derivative), manufactured by EFKA; AJISPER PB821, PB822, manufactured by Ajinomoto Fine Techno Co., Inc.; FLOWLEN TG-710 (urethane oligomer), POLYFLOW No. 50E, No. 300 (trade name, acrylate copolymer), manufactured by Kyoeisha Chemical Co., Ltd.; DISPARLON KS-860, 873SN, 874, #2150 (trade name, aliphatic polyvalent carboxylic acid), #7004 (trade name, polyether ester), DA-703-50, DA-705, DA-725, manufactured by Kusumoto Chemicals Ltd.; DEMOL RN, N (trade name, naphthalenesulfonic acid-formalin polycondensation product), DEMOL MS, C, SN-B (trade name, aromatic sulfonic acid-formalin polycondensation product), HOMOGENOL L-18 (trade name, high molecular polycarboxylic acid), EMULGEN 920, 930, 935, 985 (trade name, polyoxyethylene nonylphenyl ether), ACETAMIN 86 (trade name, stearylamine acetate) manufactured by Kao Corporation; SOLSPERSE 5000 (phthalocyanine derivative), 22000 (trade name, azo pigment derivative), 13240 (polyester amine), 3000, 17000,27000 (trade name, polymer having a functional group at a terminal thereof), 24000, 28000, 32000, 38500 (graft polymer), manufactured by Lubrizol Corporation; and NIKKOL T106 (trade name, polyoxyethylene sorbitan monooleate) and MYS-IEX (trade name, polyoxyethylene monostearate), manufactured by Nikko Chemicals Co., Ltd. In addition, an amphoteric dispersant such as HINOACT T-8000E (trade name, manufactured by Kawaken Fine Chemicals Co., Ltd.) may also be used.

The dispersant may be used alone, or as a combination of two or more thereof.

(Graft copolymer: Specific resin A)

In the invention, it is also preferable to use a graft copolymer as the dispersant (hereinbelow, also referred to as "specific resin A"). By using a graft copolymer, as the dispersant, dispersibility and storage stability can be further improved.

The acid value of specific resin A is preferably in the range of from 5.0 mgKOH/g to 200 mgKOH/g, more preferably in the range of from 10 mgKOH/g to 150 mgKOH/g, and still more preferably in the range of from 60 mgKOH/g to 150 mgKOH/g.

When the acid value of specific resin A is 200 mgKOH/g or less, detachment of pattern during development in a process of forming a light blocking film can be efficiently suppressed, and when the acid value of specific resin A is 5.0 mgKOH/g or more, favorable alkali developability can be obtained. Further, when the acid value of specific resin A is 60 mgKOH/g or more, precipitation of titanium black can be more efficiently inhibited, the number of coarse particles can be lowered, and stability over time of the titanium black dispersion composition or the radiation-sensitive composition can be further improved.

In the invention, the acid value of specific resin A can be calculated, for example, from an average content of acid groups in the dispersant. A resin having a desired acid value can be obtained by changing the content of a monomer unit containing an acid group, which may be included as a constituent of specific resin A.

The weight average molecular weight of specific resin A in the invention is preferably from 10,000 to 300,000, more preferably from 15,000 to 200,000, still more preferably from 20,000 to 100,000, and particularly preferably from 25,000 to 50,000, from the viewpoint of suppressing detachment of a pattern during development, and from the viewpoint of developability, when a light blocking film is prepared.

In addition, the weight average molecular weight of specific resin A may be measured by gel permeation chromatography (GPC), for example.

The graft copolymer preferably has a graft chain having the total number of atoms, except hydrogen atoms, of from 40 to 10,000. The graft chain refers to a chain starting from the root of the main chain of a copolymer to a terminal of the group branched from the main chain.

Specific resin A is a dispersion resin which can impart dispersibility to titanium black particles. Since specific resin A exhibits excellent dispersibility, and affinity to a solvent due to its graft chain, it imparts excellent dispersibility and dispersion stability over time to titanium black particles. When the specific resin is used in a radiation-sensitive composition, generation of residues during alkali development can be suppressed since the specific resin exhibits an affinity due to its graft chain with respect to a polymerizable compound or other resins that may be used in combination. Therefore, residues are hardly produced in alkaline development.

Further, by introducing an alkali soluble partial structure such as a carboxylic group into the specific resin, the specific resin can function as a resin that imparts developability, which is necessary for carrying out pattern formation by alkali development.

In that case, in the titanium black dispersion composition of the invention, the dispersion resin itself, which is

necessary for dispersing titanium black particles, exhibits alkali solubility as a result of introducing an alkali soluble partial structure into the graft copolymer. A radiation-sensitive composition containing a titanium black dispersion as described above exhibits favorable light blocking properties at an exposed portion, and exhibits improved alkali developability at an unexposed portion.

The longer the graft chain is, the higher the steric repulsion effect is and the more the dispersibility is improved. On the other hand, when the graft chain is too long, adsorbability with respect to titanium black is lowered and dispersibility is lowered. Thus, the graft copolymer to be used in the invention preferably has the total number of atoms except hydrogen atoms per graft chain of from 40 to 10,000, more preferably from 50 to 2,000, and further preferably from 60 to 500.

The polymer structure of the graft polymer may be any one of poly(meth)acryl, polyester, polyurethane, polyurea, polyamide, and polyether structures or the like. In order to improve the interaction of a graft moiety with a solvent and further increase the dispersibility, the graft chain preferably has a poly(meth)acryl, polyester, or polyether structure, more preferably a polyester or polyether structure.

The structure of a macromonomer having such a polymer structure as a graft chain is not particularly limited as long as it has a substituent which can react with a polymer main chain portion and satisfies the requirement of the invention. Preferably, a macromonomer having a reactive double bonding group may be suitably used.

Examples of commercial products of the macromonomer to be suitably used for synthesis of specific resin A include: AA-6 (trade name, manufactured by TOAGOSEI CO., LTD.), AA-10 (trade name, manufactured by TOAGOSEI CO., LTD.), AB-6 (trade name, manufactured by TOAGOSEI CO., LTD.), AS-6 (manufactured by TOAGOSEI CO., LTD.), AN-6 (trade name, manufactured by TOAGOSEI CO., LTD.), AW-6 (trade name, manufactured by TOAGOSEI CO., LTD.), AA-714 (trade name, manufactured by TOAGOSEI CO., LTD.), AY-707 (trade name, manufactured by TOAGOSEI CO., LTD.), AY-714 (trade name, manufactured by TOAGOSEI CO., LTD.), AK-5 (trade name, manufactured by TOAGOSEI CO., LTD.), AK-30 (trade name, manufactured by TOAGOSEI CO., LTD.), AK-32 (trade name, manufactured by TOAGOSEI CO., LTD.), BLEMMER PP-100 (trade name, manufactured by NOF CORPORATION), BLEMMER PP-500 (trade name, manufactured by NOF CORPORATION), BLEMMER PP-800 (trade name, manufactured by NOF CORPORATION), BLEMMER PP-1000 (trade name, manufactured by NOF CORPORATION), BLEMMER 55-PET-800 (manufactured by NOF CORPORATION), BLEMMER PME-4000 (trade name, manufactured by NOF CORPORATION), BLEMMER PSE-400 (trade name, manufactured by NOF CORPORATION), BLEMMER PSE-1300 (trade name, manufactured by NOF CORPORATION), and BLEMMER 43 PAPE-600 B (trade name, manufactured by NOF CORPORATION). Among these, AA-6 (manufactured by TOAGOSEI CO., LTD.), AA-10 (trade name, manufactured by TOAGOSEI CO., LTD.), AB-6 (trade name, manufactured by TOAGOSEI CO., LTD.), AS-6 (trade name, manufactured by TOAGOSEI CO., LTD.), AN-6 (trade name, manufactured by TOAGOSEI CO., LTD.) and BLEMMER PME-4000 (trade name, manufactured by NOF CORPORATION) are preferably used.

It is preferable that the graft moiety of specific resin A to be used in the invention includes a structural unit represented by at least one of the following formula (1) to formula (4), and more preferably includes a structural unit represented by at least one of the following formula (1A), formula (2A), formula (3A), formula (3B), and formula (4).

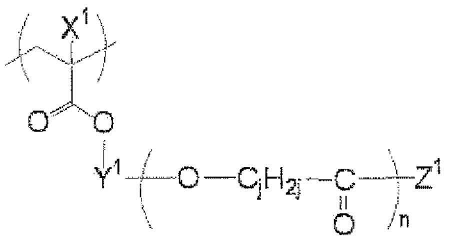
(1)

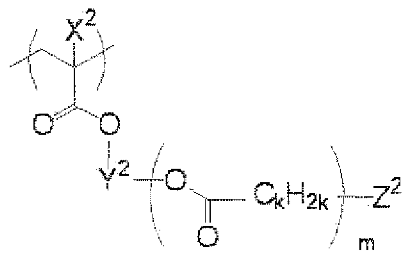
(2)

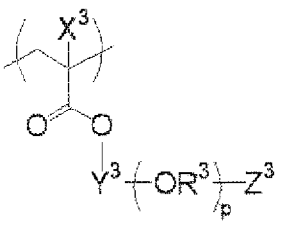
(3)

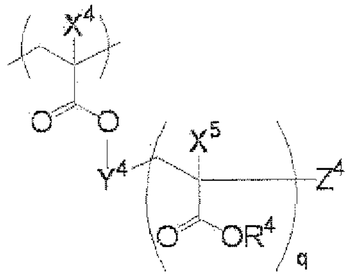
(4)

In formula (1) to formula (4), $X^1$, $X^2$, $X^3$, $X^4$ and $X^5$ each independently represents a hydrogen atom or a monovalent organic group. From the viewpoint of the limitations of synthesis, $X^1$, $X^2$, $X^3$, $X^4$ and $X^5$ preferably each

independently represents a hydrogen atom or an alkyl group having 1 to 12 carbon atoms, more preferably a hydrogen atom or a methyl group, and particularly preferably a methyl group.

In formula (1) to formula (4), $Y^1$, $Y^2$, $Y^3$ and $Y^4$ each independently represents a divalent linking group, and the structure of the divalent linking group is not particularly restricted. Specific examples of the divalent linking group represented by $Y^1$, $Y^2$, $Y^3$ and $Y^4$ include the linking groups represented by (Y-1) to (Y-20) shown below. In the following structures, A and B each represent a bonding site to a terminal group at the left side and a terminal group at the right side in formula (1) to formula (4), respectively. Among the structures shown below, (Y-2) and (Y-13) are more preferable from the viewpoint of ease of synthesis.

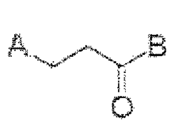
(Y-1)

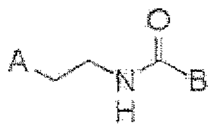
(Y-2)

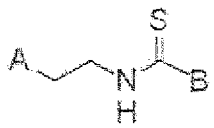
(Y-3)

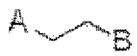
(Y-4)

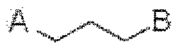
(Y-5)

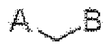
(Y-6)

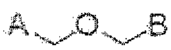
(Y-7)

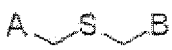
(Y-8)

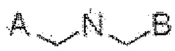
(Y-9)

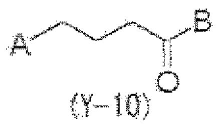
(Y-10)

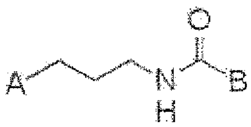
(Y-11)

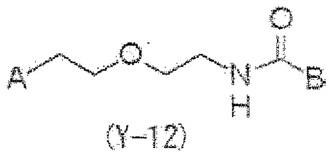
(Y-12)

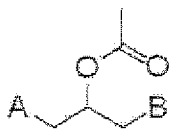
(Y-13)

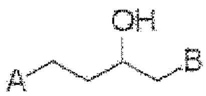
(Y-14)

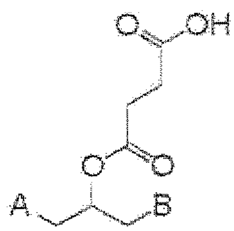
(Y-15)

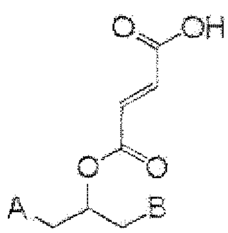
(Y-16)

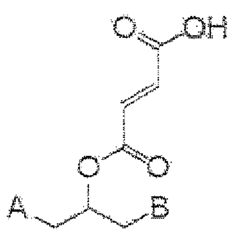
(Y-17)

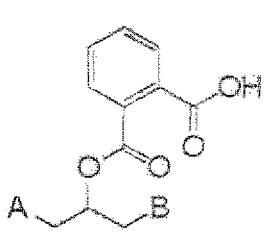
(Y-18)

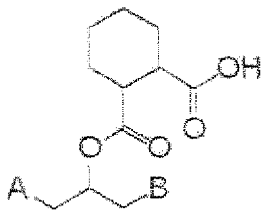

(Y-19)

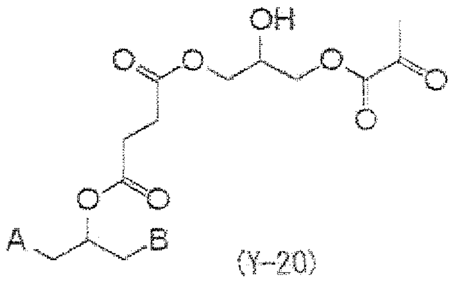

(Y-20)

In formula (1) to formula (4), $Z^1$, $Z^2$, $Z^3$ and $Z^4$ each independently represent a monovalent organic group, and the structure thereof is not particularly limited. Specific examples of the monovalent organic group include an alkyl group, a hydroxyl group, an alkoxy group, an aryloxy group, a heteroaryloxy group, an alkylthio ether group, an arylthio ether group, a heteroaryl thioether group, and an amino group. Among them, it is preferable that an organic group represented by $Z^1$, $Z^2$, $Z^3$ or $Z^4$ has a stereo-repulsion effect from the viewpoint of improving dispersibility, and it is preferable that an organic group represented by $Z^1$ to $Z^3$ independently represents an alkyl group having 5 to 24 carbon atoms or an alkoxy group having 5 to 24 carbon atoms. Among them, the organic group represented by $Z^1$ to $Z^3$ is particularly preferably each independently an alkoxy group having a branched alkyl group having 5 to 24 carbon atoms or an alkoxy group having a cyclic alkyl group having 5 to 24 carbon atoms. Further, the organic group represented by $Z^4$ is preferably each independently represents an alkyl group having 5 to 24 carbon atoms, more preferably a branched alkyl group having 5 to 24 carbon atoms or a cyclic alkyl group having 5 to 24 carbon atoms.

In formula (1) to formula (4), n, m, p and q each independently represent an integer from 1 to 500.

In formula (3), when p is from 2 to 500, the two or more of $R^3$ in the graft copolymer may be the same or different from each other. In formula (4), when q is from 2 to 500, the two or more of $X^3$ and the two or more of $R^4$ in the graft copolymer may be the same or different from each other.

Further, in formula (1) and formula (2), j and k each independently represent an integer from 2 to 8. In formula. (1) and formula (2), j and k are preferably an integer from 4 to 6, and most preferably 5, from the viewpoint of dispersion stability and developability.

In formula (3), $R^3$ represents a branched or linear alkylene group, preferably having 1 to 10 carbon atoms, and more preferably an alkylene group having 2 or 3 carbon atoms.

In formula (4), $R^4$ represents a hydrogen atom or a monovalent organic group, and its structure is not particularly limited. Preferably, $R^4$ is a hydrogen atom, an alkyl group, an aryl group or a heteroaryl group, more preferably a hydrogen atom or an alkyl group. When $R^4$ is an alkyl group, the alkyl group is preferably a linear alkyl group having 1 to 20 carbon atoms, a branched alkyl group having 3 to 20 carbon atoms, or a cyclic alkyl group having 5 to 20 carbon atoms. Sill more preferably, it is a linear alkyl group having 1 to 20 carbon atoms. Particularly preferably, it is a linear alkyl group having 1 to 6 carbon atoms.

In specific resin A, the structural unit represented by formula (1) to formula (4) is included preferably at a ratio by mass of from 10% to 90%, more preferably from 30% to 70%, with respect to the total mass of specific resin A. When the content of the structural unit represented by formula (1) to formula (4) is within these ranges, dispersibility of titanium black particles is high, and developability when used for forming a light blocking film is favorable.

Specific resin A may include two or more kinds of graft moieties having different structures from one another.

From the viewpoints of dispersion stability and developability, the structural unit represented by formula (1) is more preferably a structural unit represented by the following formula (1A).

From the viewpoints of dispersion stability and developability, the structural unit represented by formula (2) is more preferably a structural unit represented by the following formula (2A).

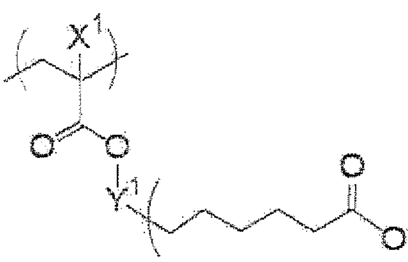

(1A)

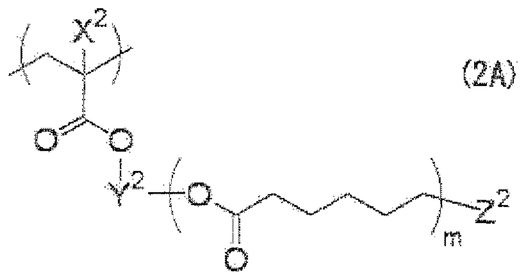

(2A)

In formula (1A), $X^1$, $Y^1$, $Z^1$ and n have the same definitions as $X^1$, $Y^1$, $Z^1$ and n in formula (1), respectively, and preferable ranges thereof are also the same.

In formula (2A), $X^2$, $Y^2$, $Z^2$ and m have the same definitions as $X^2$, $Y^2$, $Z^2$ and m in formula (2), respectively, and preferable ranges thereof are also the same.

Further, from the viewpoints of dispersion stability and developability, the structural unit represented by formula (3) is more preferably a structural unit represented by the following formula (3A) or formula (3B).

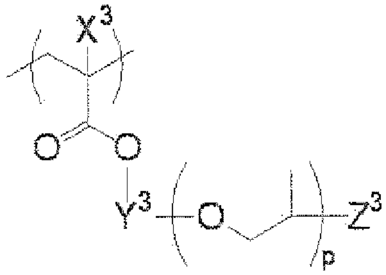

(3A)

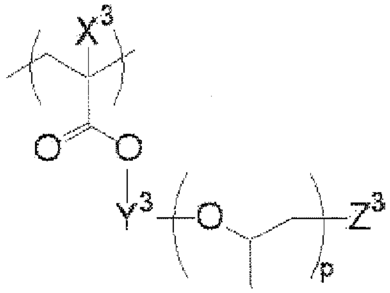

(3B)

In formula (3A) or formula (3B), $X^3$, $Y^3$, $Z^3$ and p have the same definitions as $X^3$, $Y^3$, $Z^3$ and p in formula (3), respectively, and preferable ranges thereof are also the same.

More preferably, specific resin A has a structural unit represented by formula (1A).

In addition to a graft moiety, a functional group that can interact with titanium black particles may be introduced into specific resin A.

Examples of the functional group that can interact with titanium black particles include an acid group, a basic group, a coordinating group, and a functional group having reactivity. The functional group can be introduced into specific resin A in the form of a structural unit having an acid group, a structural unit having a basic group, a structural unit having a coordinating group, or a structural unit having reactivity.

Examples of the acid group, which is a functional group that can interact with titanium black particles, include a carboxylic acid group, a sulfonic acid group, a phosphoric acid group, and a phenolic hydroxyl group. A carboxylic acid group, which exhibits favorable adsorbability to titanium black particles and high dispersibility, is particularly preferable. In specific resin A, the acid group may be used alone, or as a combination of two or more kinds thereof.

Introduction of an acid group into specific resin A also brings in another advantage of improving alkali developability.

The content of the structural unit having an acid group that can be introduced into specific resin A as a copolymerization component is suitably from 0.1 mol% to 50 mol%, and from the viewpoint of suppressing a decrease in image strength caused by alkali development, the content is particularly preferably from 1 mol% to 30 mol%.

Examples of the basic group, which is a functional group that can interact with titanium black particles, include a primary amino group, a secondary amino group, a tertiary amino group, a heterocycle containing an N atom, and an amide group. A tertiary amino group, which exhibits favorable adsorbability to a pigment and high dispersibility, is particularly preferable. The basic group may be used alone, or as a combination of two or more of kinds thereof.

The content of a structural unit having a basic group, when it is introduced as a copolymerization component into specific resin A, is suitably from 0.01 mol% to 50 mol% with respect to the total structural units in specific resin A. From the viewpoint of preventing inhibition of developability, the content is preferably from 0.01 mol% to 30 mol%.

Examples of the coordinating group and the functional group having reactivity, which can interact with titanium

black particles, include an acetylacetoxy group, a trialkoxysilyl group, an isocyanate group, an acid anhydride, and an acid chloride. An acetylacetoxy group, which exhibits favorable adsorbability to a pigment and high dispersibility, is particularly preferable. These functional groups may be used singly, or as a combination of two or more kinds thereof.

The content of the structural unit having a coordinating group or the structural unit having reactivity, which can be introduced as a copolymerization component into specific resin A, is suitably from 0.5 mol% to 50 mol% with respect to the total structural units in specific resin A. In particular, the content is preferably from 1 mol% to 30 mol% from the viewpoint of preventing inhibition of developability.

When specific resin A has a functional group that may form an interaction with titanium black particles, in addition to a graft moiety, the method of introducing the functional group into specific resin A is not particularly limited. However, a structural unit obtained from a monomer represented by any one of the following formula (i) to formula (iii) is preferably used for the introduction.

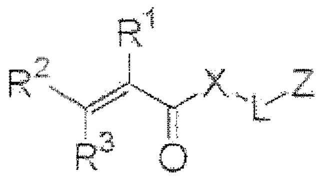

(i)

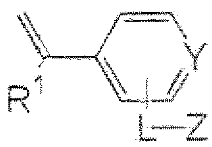

(ii)

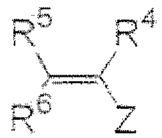

(iii)

In formula (i) to formula (iii), $R^1$, $R^2$ and $R^3$ each independently represent a hydrogen atom, a halogen atom (e.g., a fluorine atom, a chlorine atom or a bromine atom) or an alkyl group having 1 to 6 carbon atoms (e.g., a methyl group, an ethyl group or a propyl group).

More preferably $R^1$, $R^2$ and $R^3$ are each independently a hydrogen atom or an alkyl group having 1 to 3 carbon atoms, and most preferably a hydrogen atom or a methyl group. $R^2$ and $R^3$ are particularly preferably a hydrogen atom.

X in formula (i) represents an oxygen atom (-O-) or an imino group (-NH-), and is preferably an oxygen atom.

Further, Y in formula (ii) represents a methine group or a nitrogen atom.

L in formula (i) and formula (ii) represents a single bond or a divalent linking group. Examples of the divalent linking group include a divalent aliphatic group (e.g., an alkylene group, a substituted alkylene group, an alkenylene group, a substituted alkenylene group, an alkynylene group of a substituted alkynylene group), a divalent aromatic group (e.g., an arylene group or a substituted arylene group), a divalent heterocyclic group, and a combination of any one of these groups with any one of an oxygen atom (-O-), a sulfur atom (-S-), an imino group (-NH-), a substituted imino bond ($-NR^{31}-$, wherein $R^{31}$ represents an aliphatic group, an aromatic group or a heterocyclic group) or a carbonyl bond (-CO-).

The divalent aliphatic group may have a cyclic or branched structure. The aliphatic group is preferably an aliphatic group having 1 to 20 carbon atoms, more preferably an aliphatic group having 1 to 15 carbon atoms, and still more preferably an aliphatic group having 1 to 10 carbon atoms. A saturated aliphatic group is more preferable than an unsaturated aliphatic group. The aliphatic group may have a substituent, and examples of the substituent include a halogen atom, a hydroxyl group, an aromatic group and a heterocyclic group.

The divalent aromatic group is preferably a divalent aromatic group having 6 to 20 carbon atoms, more preferably a divalent aromatic group having 6 to 15 carbon atoms, and most preferably a divalent aromatic group having 6 to 10 carbon atoms. The aromatic group may have a substituent, and examples of the substituent include a halogen atom, a hydroxyl group, an aliphatic group, an aromatic group and a heterocyclic group.

The divalent heterocyclic group preferably has a five- or six-membered ring as a heterocyclic ring thereof. In addition to the heterocyclic ring, the divalent heterocyclic group may have another heterocyclic ring, an aliphatic ring or an aromatic ring that is condensed thereto. The heterocyclic group may have a substituent, and examples of the substituent include a halogen atom, a hydroxyl group, an oxo group (=O), a thioxo group (=S), an imino group (=NH), a substituted imino group ($=N-R^{32}$, wherein $R^{32}$ represents an aliphatic group, an aromatic group or a heterocyclic group),

an aliphatic group, an aromatic group, and a heterocyclic group.

L is preferably a single bond or a divalent linking group including an alkylene group or an oxyalkylene structure. The oxyalkylene structure is preferably an oxyethylene structure or an oxypropylene structure. Alternatively, L may include a polyoxyalkylene structure including two or more oxyalkylene structures in series. The polyoxyalkylene structure is preferably a polyoxyethylene structure or a polyoxypropylene structure. The polyoxyethylene structure is represented by $-(OCH_2CH_2)_n-$, wherein n is preferably an integer of 2 or more, and more preferably an integer from 2 to 10.

In formula (i) to formula (iii), Z represents a functional group that can interact with titanium black particles, in addition to the graft moiety, and is preferably a carboxylic acid group or a tertiary amino group, and more preferably a carboxylic acid group.

In formula (iii), $R^4$, $R^5$, and $R^6$ each independently represent a hydrogen atom, a halogen atom (e.g., a fluorine atom, a chlorine atom or a bromine atom), an alkyl group having I to 6 carbon atoms (e.g., a methyl group, an ethyl group or a propyl group), Z or -L-Z (L and Z have the same definitions as L and Z described above), respectively. The preferable ranges thereof are also the same.

$R^4$, $R^5$ and $R^6$ are each preferably a hydrogen atom or an alkyl group having 1 to 3 carbon atoms, and more preferably a hydrogen atom.

In the invention, the monomer represented by formula (i) is preferably a compound in which $R^1$, $R^2$ and $R^3$ each independently represent a hydrogen atom or a methyl group, L represents a divalent linking group including an alkylene group or an oxyalkylene structure, X represents an oxygen atom or an imino group, and Z represents a carboxylic acid group.

The monomer represented by formula (ii) is preferably a compound in which $R^1$ represents a hydrogen atom or a methyl group, L represents an alkylene group, Z represents a carboxylic acid group, and Y represents a methine group.

The monomer represented by formula (iii) is preferably a compound in which $R^4$, $R^5$ and $R^6$ each independently represent a hydrogen atom or a methyl group, L represents a single bond or an alkylene group, and Z represents a carboxylic acid group.

Hereinbelow, representative examples of the monomer (compound) represented by formula (i) to formula (iii) will be described.

Specifically, examples of the monomer include: methacrylic acid; crotonic acid; isocrotonic acid; a reaction product of a compound having an addition-polymerizable double bond and a hydroxyl group in the molecule (e.g., 2-hydroxyethyl methacrylate) and a succinic anhydride; a reaction product of a compound having an addition-polymerizable double bond and a hydroxyl group in the molecule and a phthalic anhydride; a reaction product of a compound having an addition-polymerizable double bond and a hydroxyl group in the molecule and a tetrahydroxyphthalic anhydride; a reaction product of a compound having an addition-polymerizable double bond and a hydroxyl group in the molecule and a trimellitic anhydride; a reaction product of a compound having an addition-polymerizable double bond and a hydroxyl group in the molecule and a pyromellitic anhydride; acrylic acid; acrylic acid dimer; acrylic acid oligomer; maleic acid; itaconic acid; fumaric acid; 4-vinylbenzoic acid; vinylphenol; and 4-hydroxyphenyl methacrylamide.

The content of the functional group that can interact with titanium black particles, such as a monomer having an acid group, is preferably from 0.05% by mass to 90% by mass, more preferably from 1.0% by mass to 80% by mass, and further preferably from 10% by mass to 70% by mass, with respect to specific resin A from the viewpoint of interaction with titanium black particles, dispersion stability, and penetration with respect to a developer.

For the purpose of improving various performances such as image strength, specific resin A to be included in the titanium black dispersion composition according to the invention may further contain other structural units having various functions, for example, a structural unit having a functional group which has an affinity to (C) an organic solvent used for the dispersion composition, as a copolymerization component, in addition to the structural unit having a graft moiety (i.e., a structural unit having a graft chain) and the functional group that can interact with titanium black particles, unless the effects of the invention are impaired.

Examples of the copolymerization component which may be used in specific resin A include radical polymerizable compounds selected from acrylic acid esters, methacrylic acid esters, styrenes, acrylonitriles, and methacrylonitriles.

Any one of the copolymerization components may be used singly, or as a combination of two or more kinds thereof. The content of the copolymerization component used in specific resin A is suitably from 0 mol% to 90 mol%, and particularly preferably from 0 mol% to 60 mol%. When the content is within the ranges above, sufficient pattern formability is maintained.

Examples of the solvents to be used in the synthesis of specific resin A include ethylene dichloride, cyclohexanone, methyl ethyl ketone, acetone, methanol, ethanol, propanol, butanol, ethylene glycol monomethyl ether, ethylene glycol monoethyl ether, 2-methoxyethylacetate, 1-methoxy-2-propanol, 1-methoxy-2-propyl acetate, N,N-dimethylformamide, N,N-dimethylacetamide, dimethyl sulfoxide, toluene, ethyl acetate, methyl lactate, and ethyl lactate. Any one of these solvents may be used singly, or as a mixture of two or more kinds thereof.

Specific examples of specific resin A include the following Exemplary Compound 1 to Exemplary Compound

54. The figures added to each structural unit (main chain part) indicate the percentage of the structural unit by mass.

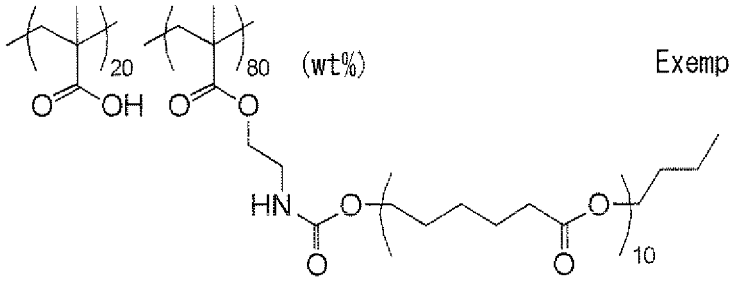

Exemplary Compound 1

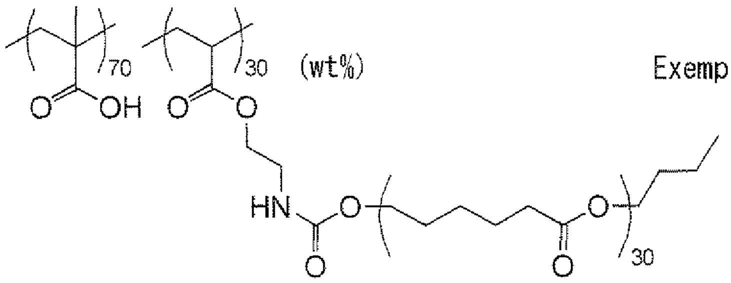

Exemplary Compound 2

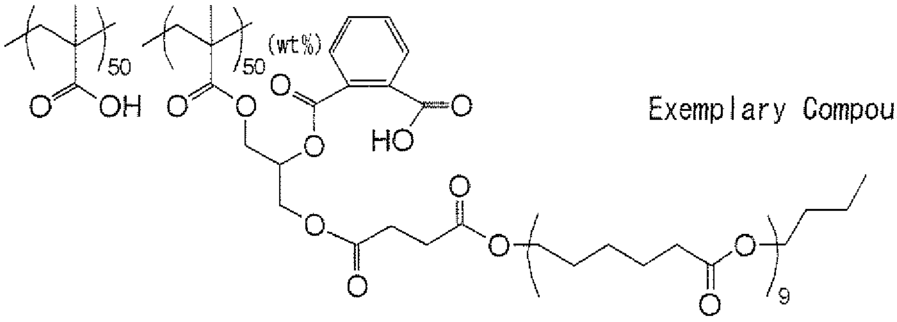

Exemplary Compound 3

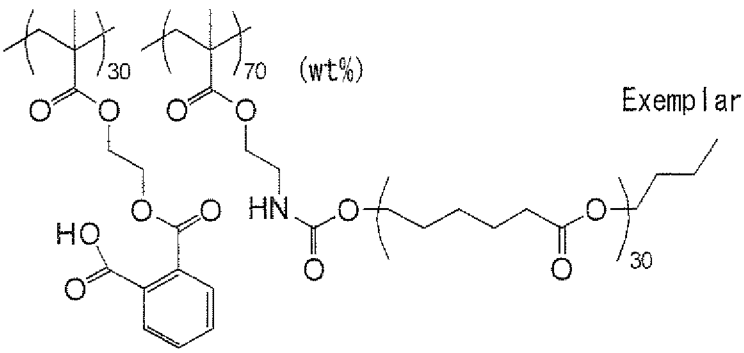

Exemplary Compound 4

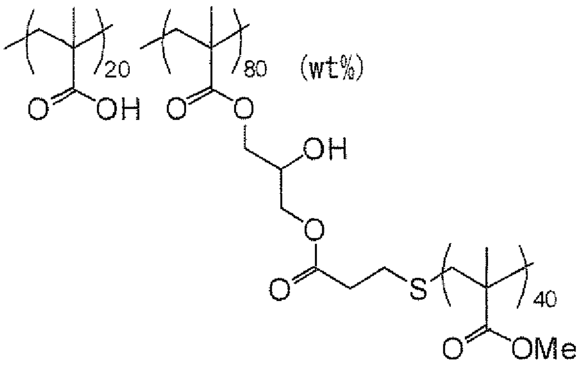

Exemplary Compound 5

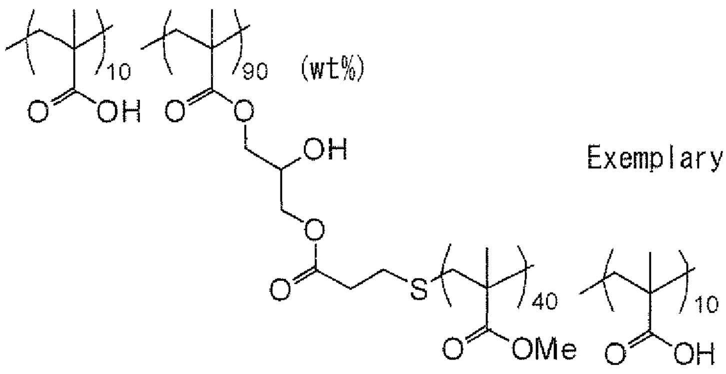

Exemplary Compound 6

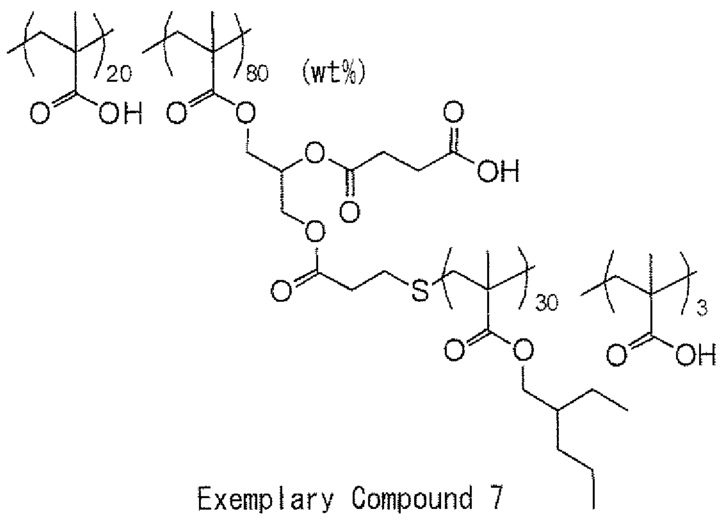

Exemplary Compound 7

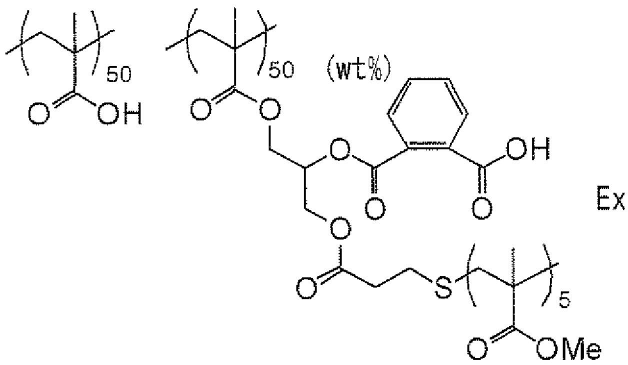

Exemplary Compound 8

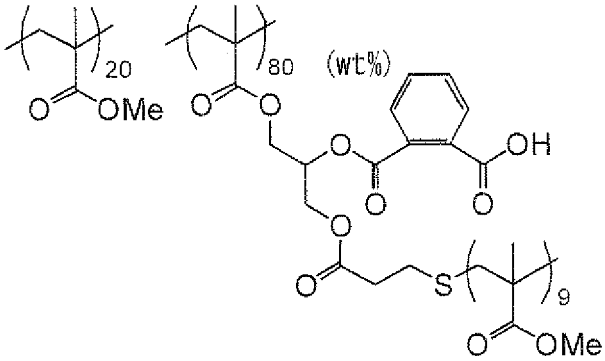

Exemplary Compound 9

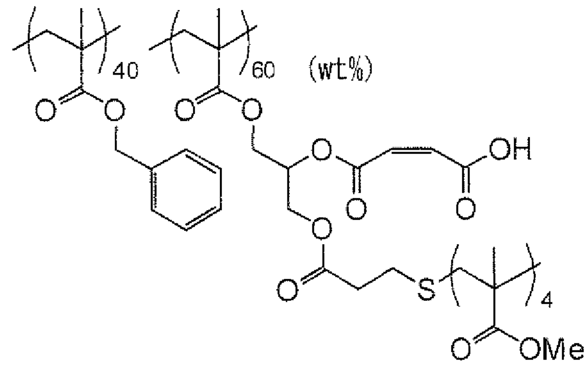

Exemplary Compound 10

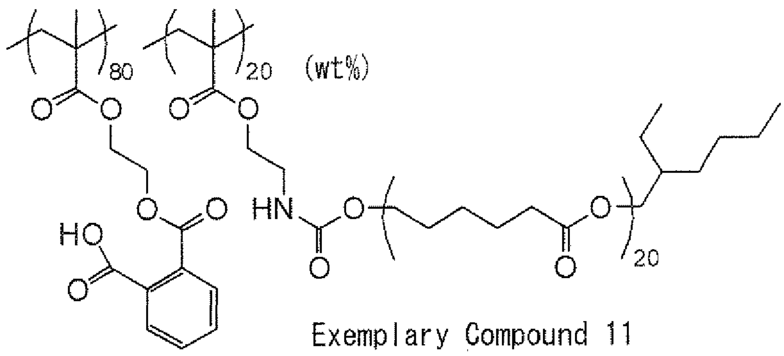

Exemplary Compound 11

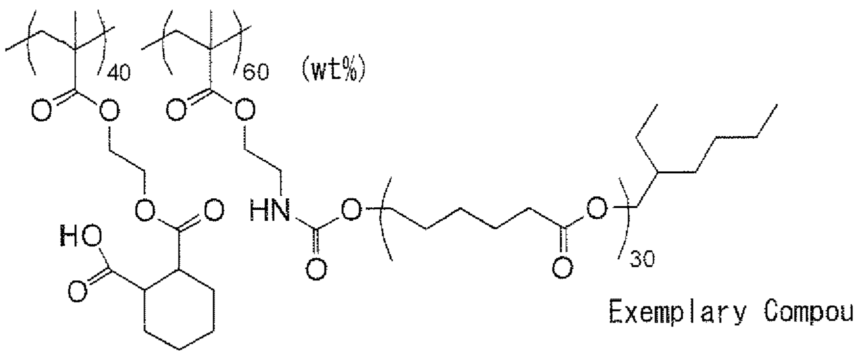

Exemplary Compound 12

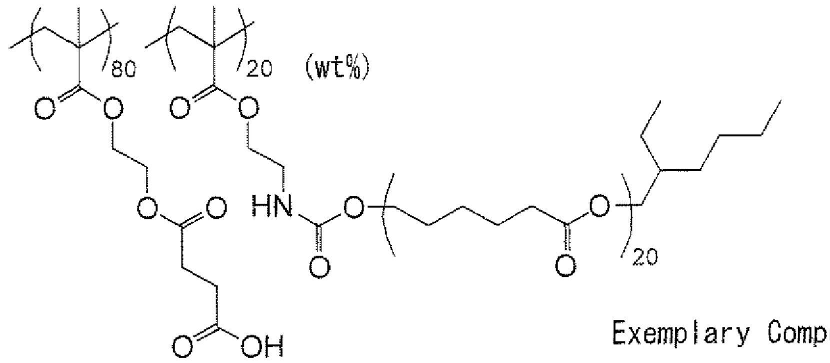

Exemplary Compound 13

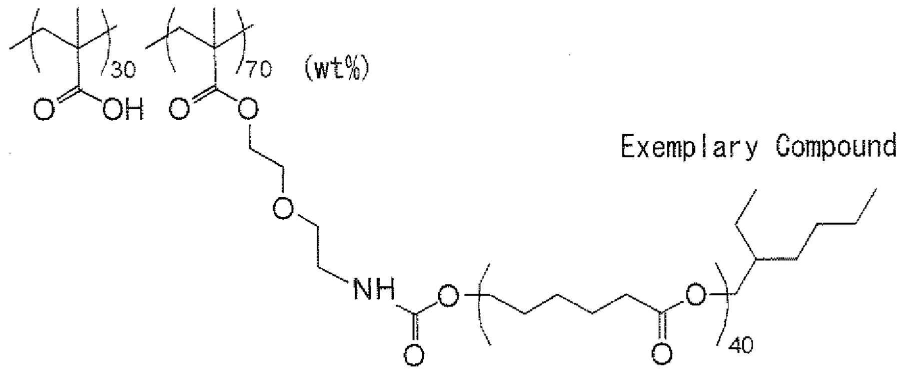

Exemplary Compound 14

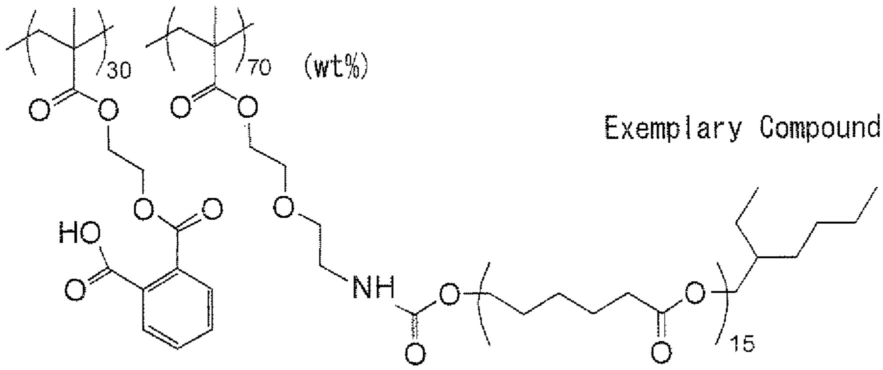

Exemplary Compound 15

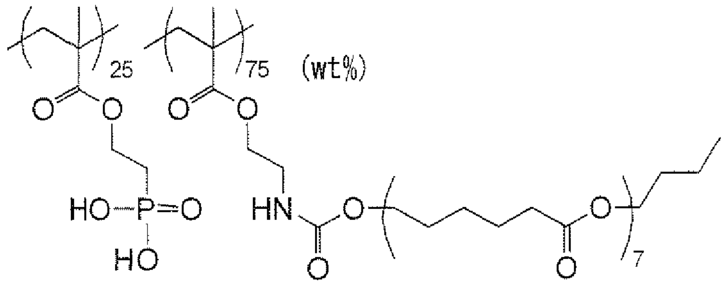

Exemplary Compound 16

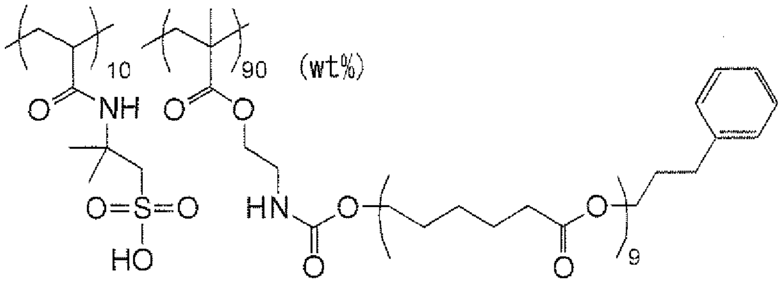

Exemplary Compound 17

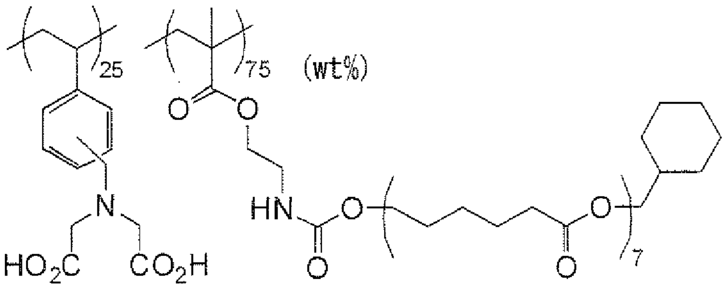

Exemplary Compound 18

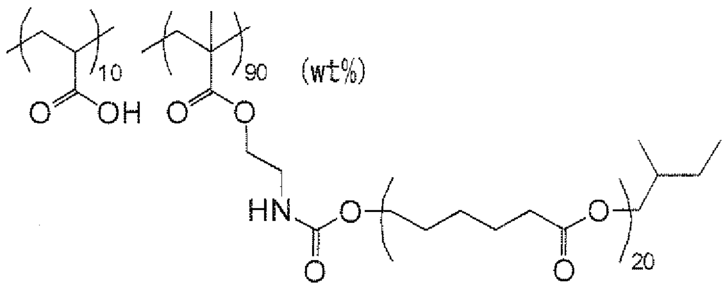

Exemplary Compound 19

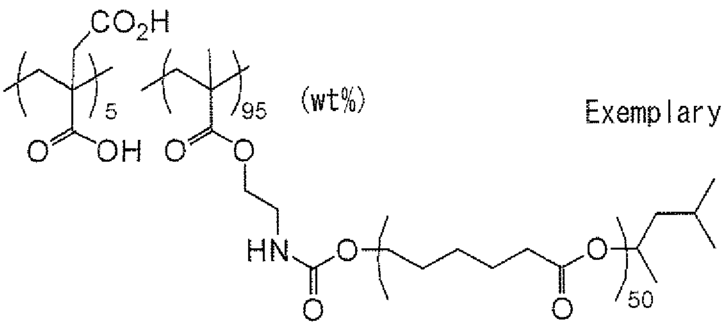

Exemplary Compound 20

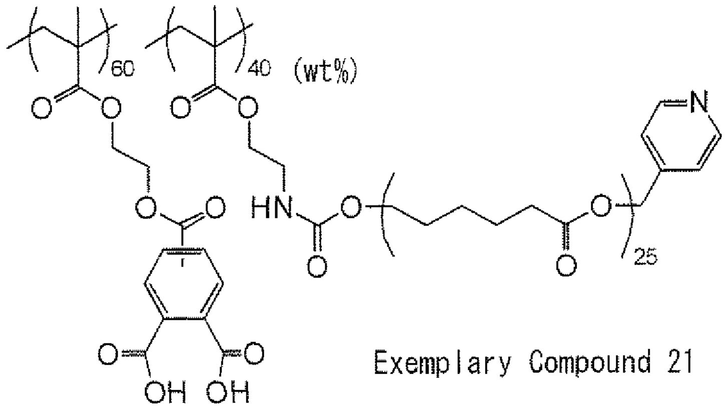

Exemplary Compound 21

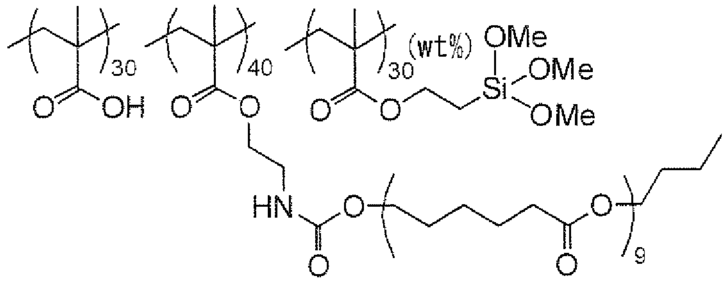

Exemplary Compound 22

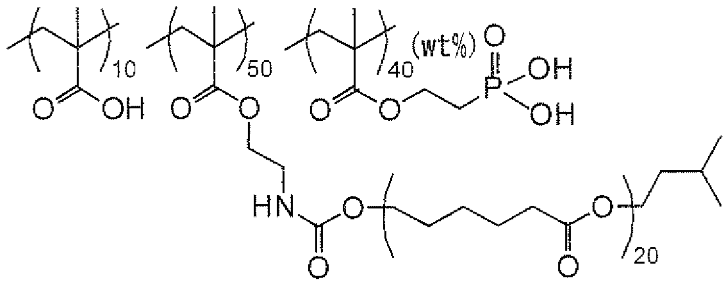

Exemplary Compound 23

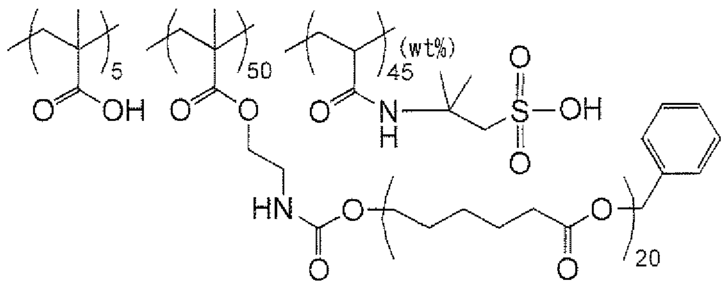

Exemplary Compound 24

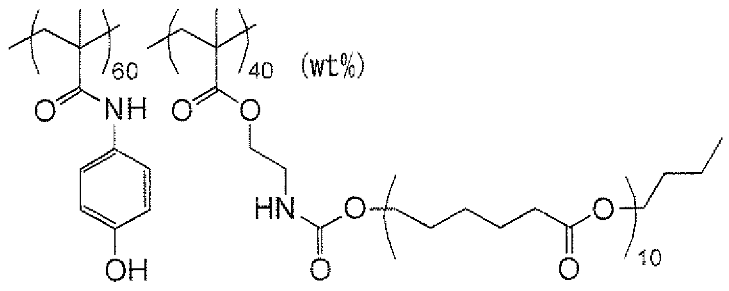

Exemplary Compound 25

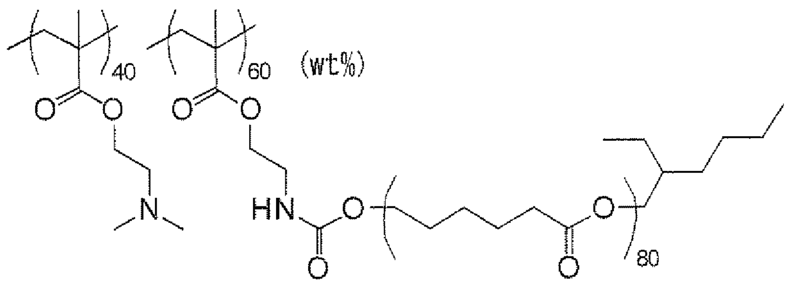

Exemplary Compound 26

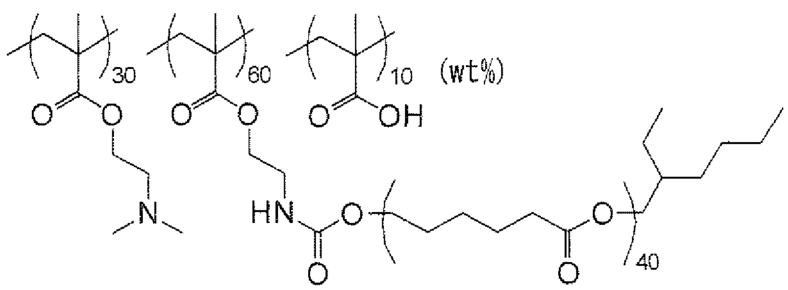

Exemplary Compound 27

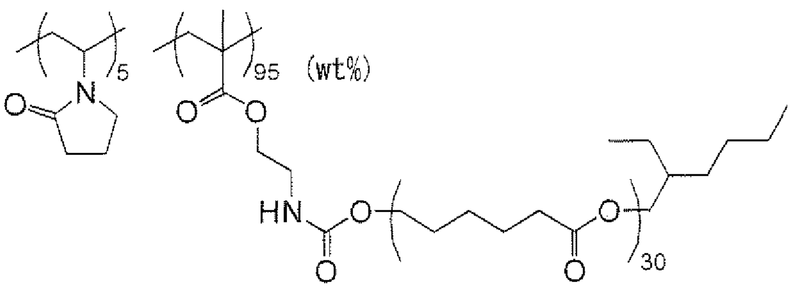

Exemplary Compound 28

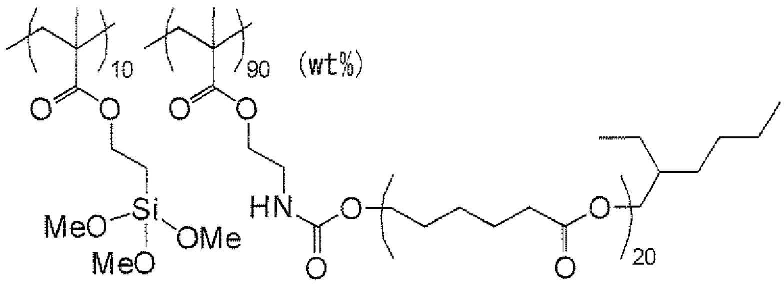

Exemplary Compound 29

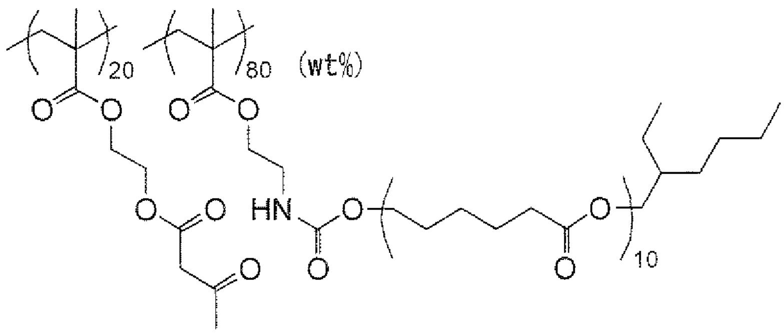

Exemplary Compound 30

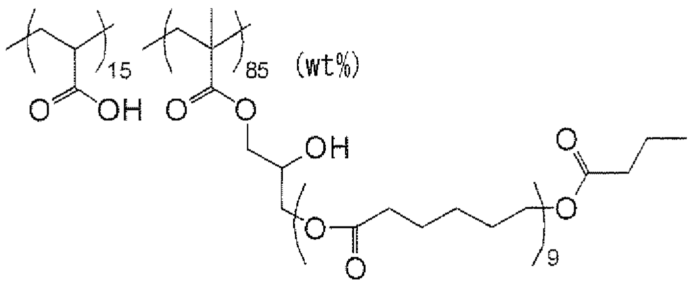

Exemplary Compound 31

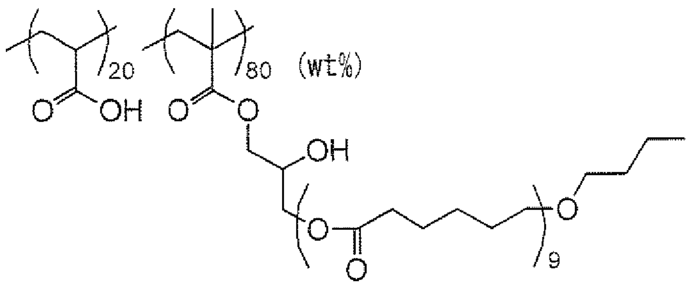

Exemplary Compound 32

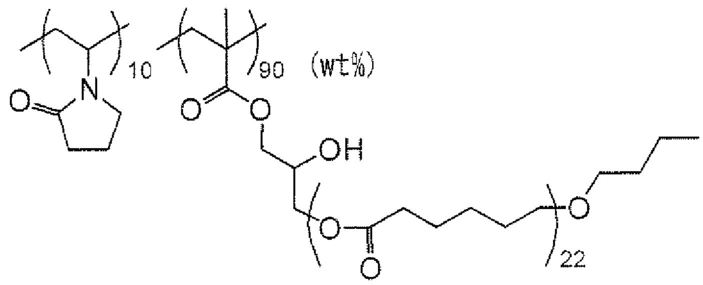

Exemplary Compound 33

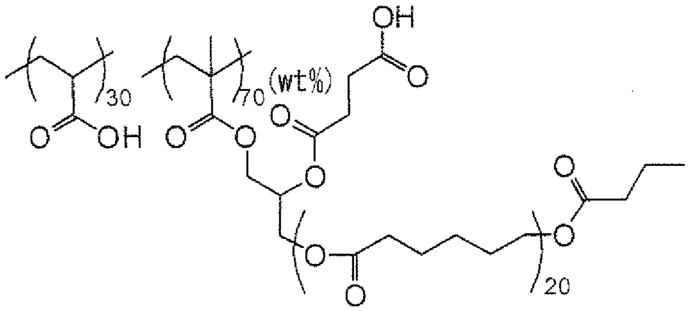

Exemplary Compound 34

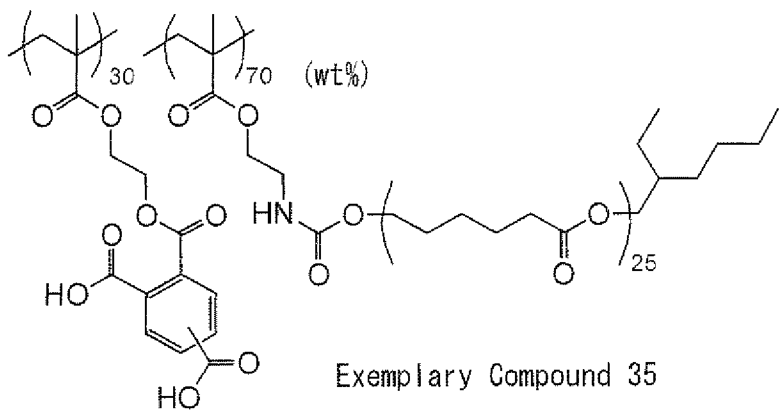

Exemplary Compound 35

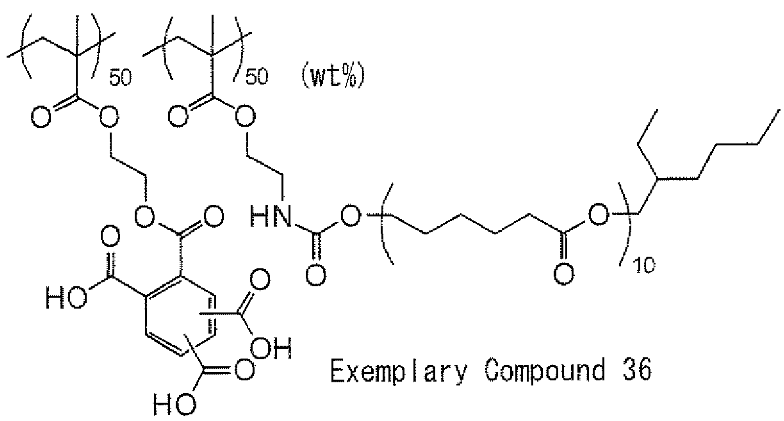

Exemplary Compound 36

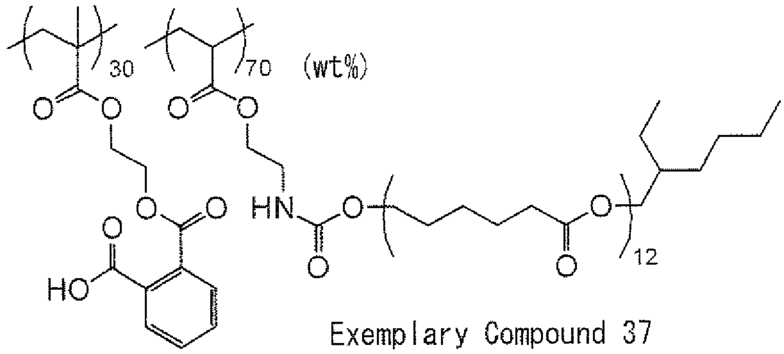

Exemplary Compound 37

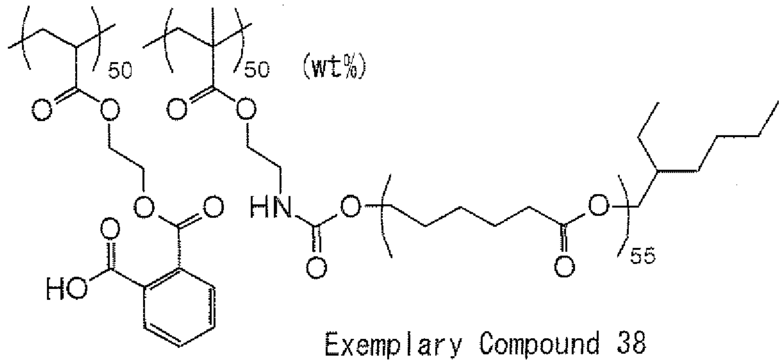

Exemplary Compound 38

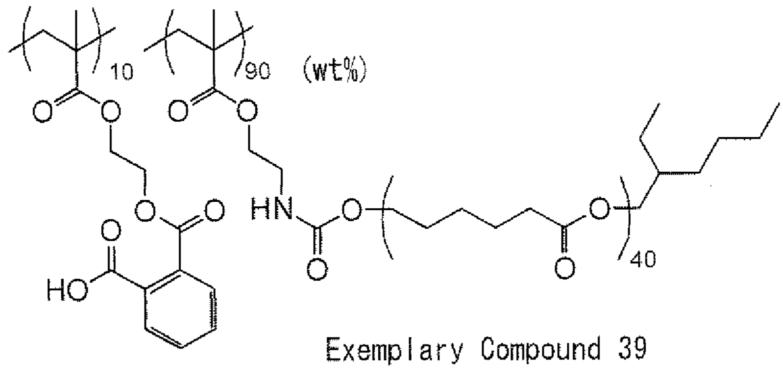

Exemplary Compound 39

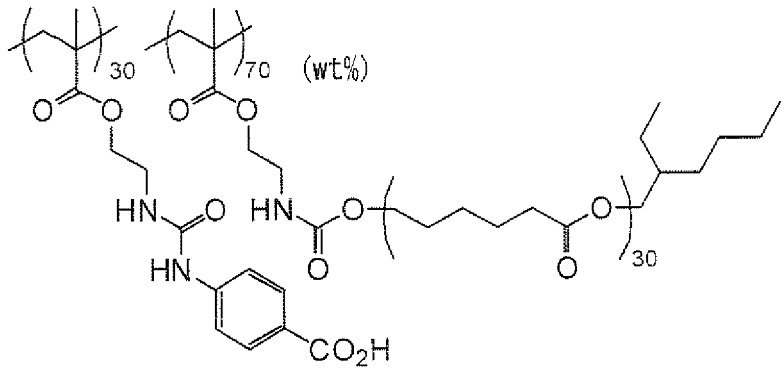

Exemplary Compound 40

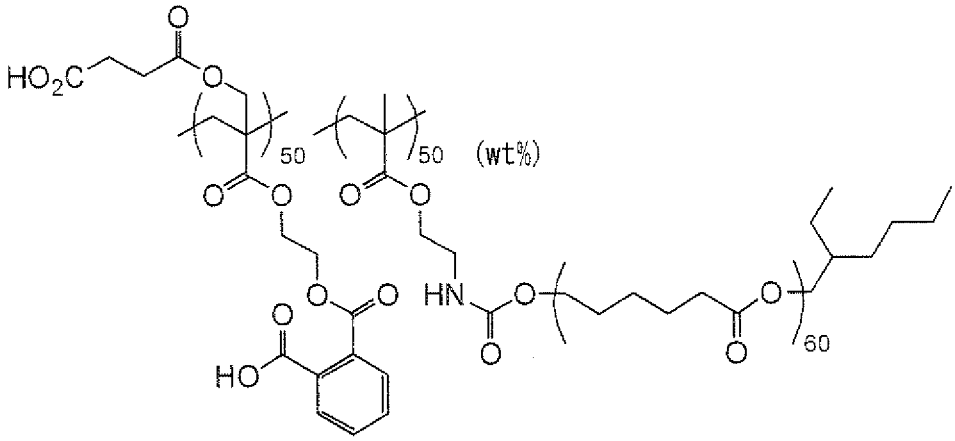

Exemplary Compound 41

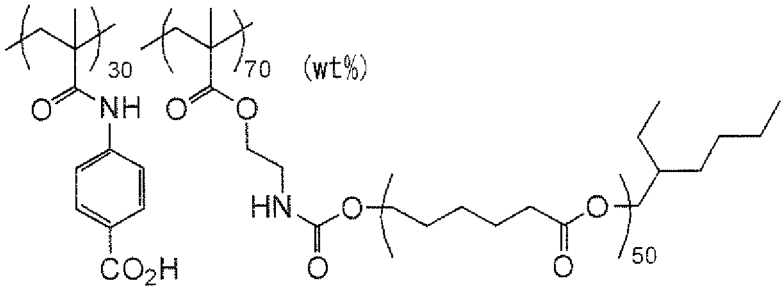

Exemplary Compound 42

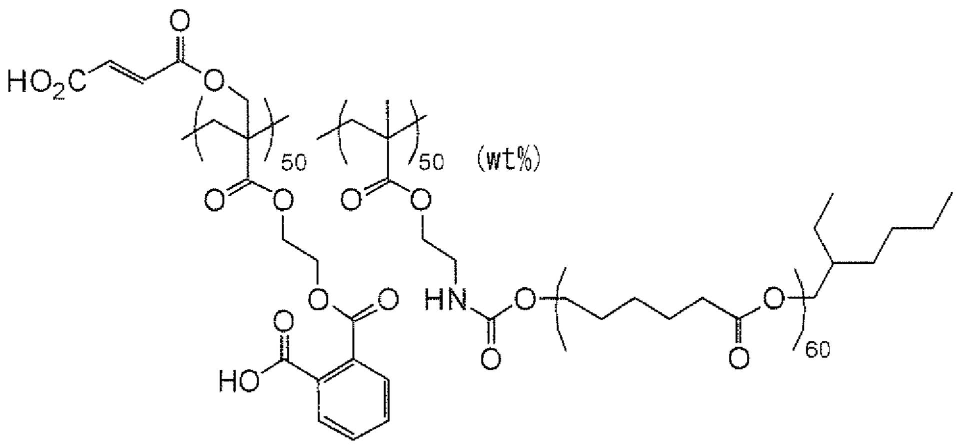

Exemplary Compound 43

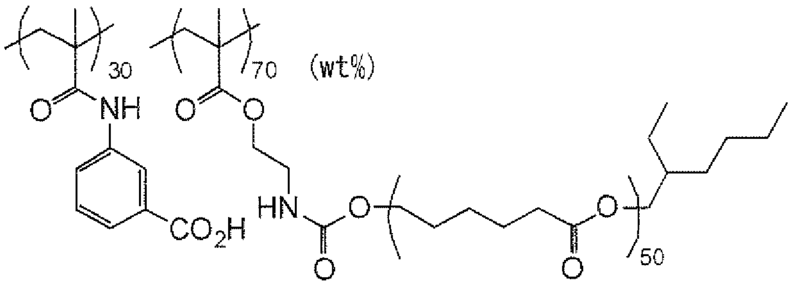

Exemplary Compound 44

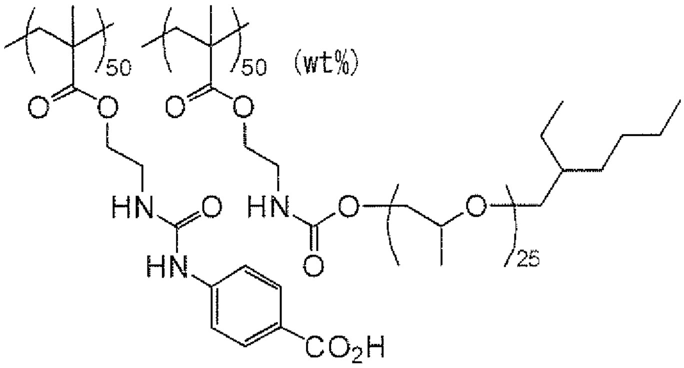

Exemplary Compound 45

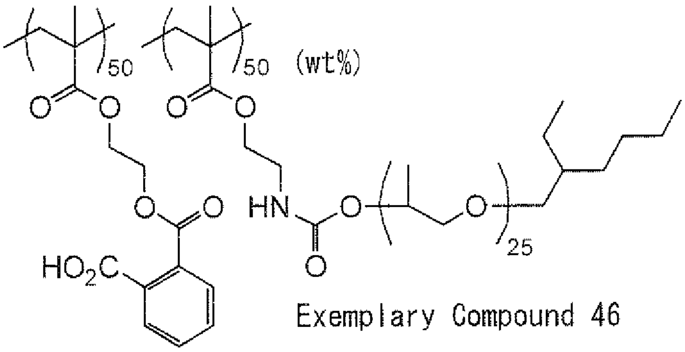

Exemplary Compound 46

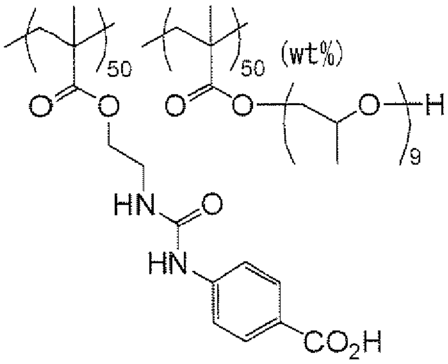

Exemplary Compound 47

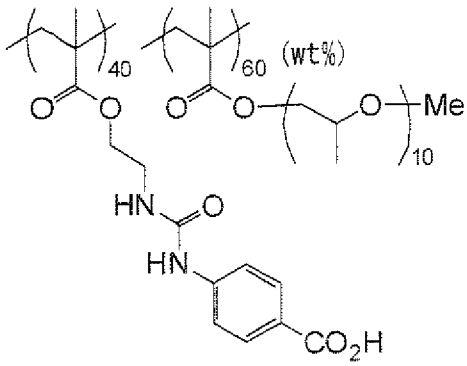

Exemplary Compound 48

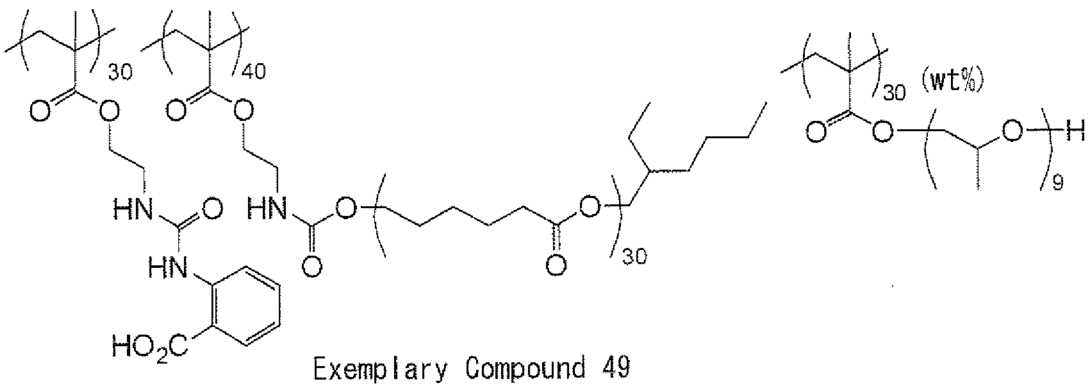

Exemplary Compound 49

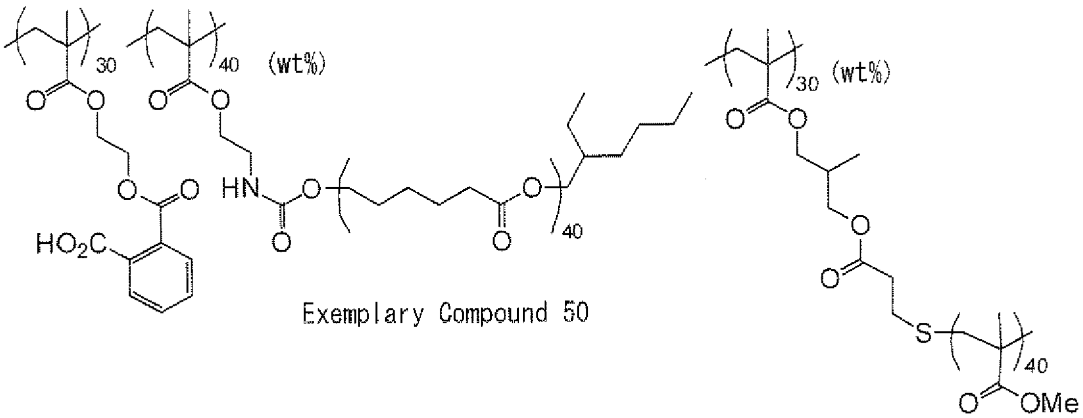

Exemplary Compound 50

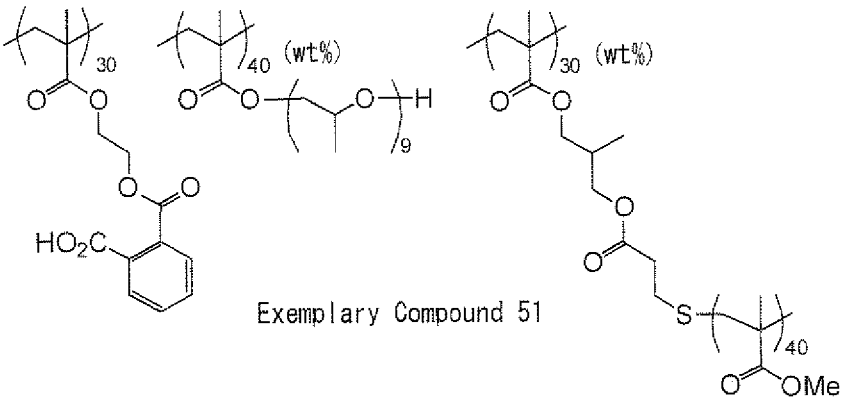

Exemplary Compound 51

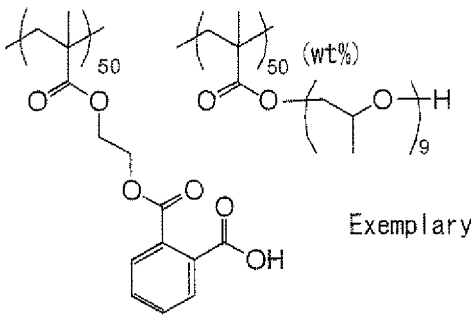

Exemplary Compound 52

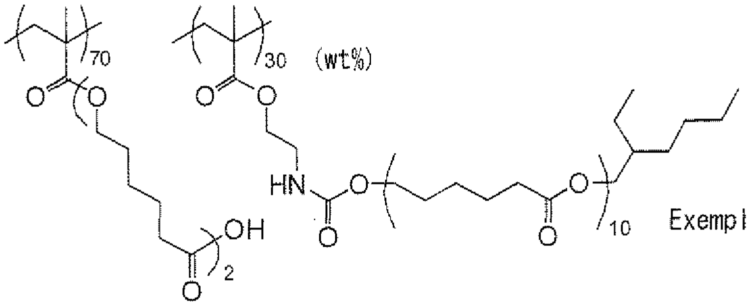

Exemplary Compound 53

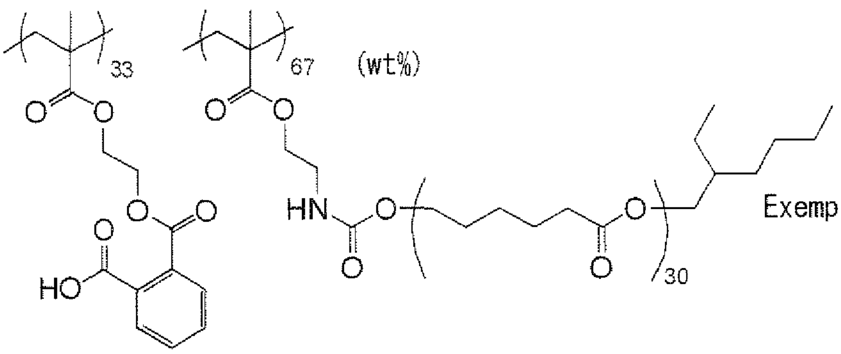

Exemplary Compound 54

(Amphoteric copolymer: specific resin B)

An amphoteric copolymer as described below is also a favorable embodiment of (B) dispersant. Specifically, preferred embodiments includes a copolymer of (b-1) a monomer having at least one selected from an amino group or a heterocyclic group containing nitrogen, (b-2) a monomer having a carboxyl group, and (b-3) a macromonomer having a weight average molecular weight of from 1,000 to 50,000. The copolymer is also referred to as specific resin B.

Hereinbelow, specific resin B is explained in greater detail.

Specific resin B is produced by copolymerizing, as starting components, (b-1) a monomer having at least one selected from an amino group or a heterocyclic group containing nitrogen, (b-2) a monomer having a carboxylic acid group, and (b-3) a macromonomer having a weight average molecular weight of from 1,000 to 50,000, and other optional monomers, if necessary.

Hereinbelow, (b-1) a monomer having at least one selected from an amino group or a heterocyclic group containing nitrogen, (b-2) a monomer having a carboxyl group, and (b-3) a macromonomer having a weight average molecular weight of from 1,000 to 50,000, which are used as the starting components for obtaining specific resin B, are explained.

<(b-1) Monomer having at least one selected from an amino group or a heterocyclic group containing nitrogen>

(b-1) monomer having at least one selected from an amino group or a heterocyclic group containing nitrogen (hereinbelow, also referred to as "monomer (b-1)") is a monomer which has at least one that is selected from an amino group or a heterocyclic group containing nitrogen, and has a weight average molecular weight of from 50 to 1,000.

Examples of the amino group contained in monomer (b-1) include a primary amino group, a secondary amino

group and a tertiary amino group. From the viewpoint of dispersion stability, a secondary amino group or a tertiary amino group is preferable. A tertiary amino group is more preferable. Preferred examples of the amino group include an amino group which has a linear or branched alkyl group having 1 to 10 carbon atoms, a cycloalkyl group having 3 to 10 carbon atoms, or an aryl group having 6 to 15 carbon atoms. Most preferred examples include an amino group which has a linear or branched alkyl group having 1 to 5 carbon atoms. Specific examples of the amino group include -NHMe, -NHEt, -NHPr, -NHiPr, -NHBu, -NH(tert-Bu), $-NMe_2$, $-NEt_2$, $-NPr_2$, $-NPh_2$, and a morpholino group (Me represents a methyl group, Et represents an ethyl group, Pr represents a propyl group, Bu represents a butyl group, and Ph represents a phenyl group).

The heterocyclic group containing nitrogen included in monomer (b-1) is a cyclic substituent which has at least one nitrogen atom in the ring structure, and the ring structure may be a saturated ring or an unsaturated ring, a single ring or a fused ring, and may be unsubstituted or substituted. The heterocyclic group containing nitrogen originating from monomer (b-1) may be contained in a side chain structure or in a main chain structure of specific resin B, but from the viewpoint of dispersibility and dispersion stability, it is preferably contained in a side chain structure.

Specific examples of the heterocyclic group containing nitrogen include pyrrolidine, pyrroline, tetrahydropyridine, piperazine, homopiperazine, piperidine, triazine, morpholine, hexamethylenetetramine, diazabicycloundecene, decahydroquinoline, diazabicyclooctane, pyrrolidinone, δ-valerolactam, succinimide, glutarimide, imidazolidone, tetrahydropyrimidone, urazole, dihydrouracil, barbituric acid, indole, carbazole, juloridine, phenoxazine, phenothiazine, oxindole, phenanthridinone, isatin, phthalimide, diiminoisoindoline, iminoisoindolinone, diiminobenzisoindoline, naphthalimide, quinazoline dione, pyrrole, porphyrin, porphyrin metal complex, phthalocyanine, phthalocyanine metal complex, naphthalocyanine, naphthalocyanine metal complex, pyrazole, imidazole, triazole, tetrazole, isoxazole, oxazole, isothiazole, thiazole, thiadiazole, thiatriazole, iminostilbene, azaindole, indazole, benzimidazole, benzotriazole, azabenzimidazole, anthranyl, benzisoxazole, benzoxazole, benzothiazole, benzofurazan, benzothiadiazole, triazolepyrimidine, triazolepyridine, purine, xanthine, pyridine, pyridazine, pyrimidine, pyrimidone, uracil, pyrazine, quinoline, acridine, cinnoline, benzocinnoline, quinoxaline, quinazoline, phenazine, phenanthroline, perimidine, and acridone. These heterocyclic groups may be either unsubstituted or substituted.

More preferred examples of the heterocyclic group containing nitrogen include indole, carbazole, phenoxazine, phenothizaine, oxindole, phenanthridinone, isatin, phthalimide, diiminoisoindoline, iminoisoindolinone, diiminobenzisoindoline, naphthalimide, quinazoline dione, pyrrole, pyrazole, imidazole, triazole, tetrazole, isoxazole, oxazole, isothiazole, thiazole, thiadiazole, thiatriazole, iminostilbene, azaindole, indazole, benzimidazole, benzotriazole, azabenzimidazole, anthranyl, benzisoxazole, benzoxazole, benzothiazole, benzofurazan, benzothiadiazole, triazolepyrimidine, triazolepyridine, purine, xanthine, pyridine, pyridazine, pyrimidine, pyrimidone, uracil, pyrazine, quinoline, acridine, cinnoline, benzocinnoline, quinoxaline, quinazoline, quinoxaline, phenazine, phenanthroline, and acridone.

Examples of the substituent which may exist in the heterocyclic group containing nitrogen of monomer (b-1) include a halogen atom, an alkyl group, a cycloalkyl group, an alkenyl group, a cycloalkenyl group, an alkynyl group, an aryl group, a heterocyclic group, a cyano group, a hydroxyl group, a nitro group, a carboxyl group, an alkoxy group, an aryloxy group, a silyloxy group, a heterocyclic oxy group, an acyloxy group, a carbamoyloxy group, an alkoxycarbonyloxy group, an aryloxycarbonyloxy group, an amino group (including an alkylamino group and an anilino group), an acylamino group, an aminocarbonylamino group, an alkoxycarbonylamino group, an aryloxycarbonylamino group, a sulfamoylamino group, an alkyl- or arylsulfonylamino group, a mercapto group, an alkylthio group, an arylthio group, a heterocyclic thio group, a sulfamoyl group, a sulfo group, an alkyl- or arylsulfinyl group, an alkyl- or arylsulfonyl group, an acyl group, an aryloxycarbonyl group, an alkoxycarbonyl group, a carbamoyl group, an aryl group or a heterocyclic azo group, an imide group, a phosphino group, a phosphinyl group, a phosphinyloxy group, a phosphinylamino group, and a silyl group.

Hereinbelow, the substituent which may exist in the heterocyclic group containing nitrogen is explained in grater detail.

Examples of the substituent include a halogen atom (for example, a fluorine atom, a chlorine atom, a bromine atom or an iodine atom), an alkyl group (a substituted or unsubstituted, a linear or branched alkyl group, preferably an alkyl group having 1 to 30 carbon atoms, for example, methyl, ethyl, n-propyl, isopropyl, t-butyl, n-octyl, 2-chloroethyl, 2-cyanoethyl or 2-ethylhexyl), a cycloalkyl group (preferably a substituted or unsubstituted cycloalkyl group having 3 to 30 carbon atoms, for example, cyclohexyl or cyclopentyl, a polycyclic cycloalkyl group, for example a bicycloalkyl group (preferably a substituted or unsubstituted bicycloalkyl group having 5 to 30 carbon atoms, for example, bicyclo[1,2,2]heptan-2-yl or bicyclo[2,2,2]octan-3-yl) or a group having a polycyclic structure such as a tricycloalkyl group. Preferably, the substituent is a monocyclic cycloalkyl group or a bicycloalkyl group, and a monocyclic cycloalkyl group is particularly preferable),

an alkenyl group (a linear or branched, substituted or unsubstituted alkenyl group, preferably an alkenyl group having 2 to 30 carbon atoms, for example, vinyl, aryl, prenyl, geranyl, oleyl), a cycloalkenyl group (preferably, a substituted or unsubstituted cycloalkenyl group having 3 to 30 carbon atoms, for example, 2-cyclopenten-1 -yl or 2-cyclohexen-1-yl, a cycloalkenyl group having a polycyclic structure, for example, a bicycloalkenyl group (preferably, a substituted or unsubstituted bicycloalkenyl group having 5 to 30 carbon atoms, for example, bicyclo[2,2,1]hept-2-en-1-yl and bicyclo[2,2,2]oct-2-en-4-yl) or a tricycloalkenyl group, or a monocyclic cycloalkenyl group is particularly preferable), an alkynyl group (preferably, a substituted or unsubstituted alkynyl group having 2 to 30 carbon atoms, for example, ethynyl, propargyl or trimethylsilylethynyl group),

an aryl group (preferably, a substituted or unsubstituted aryl group having 6 to 30 carbon atoms, for example, phenyl, p-tolyl, naphthyl, m-chlorophenyl, o-hexadecanoyl aminophenyl), a heterocyclic group (preferably, a 5- to 7-membered substituted or unsubstituted, saturated or unsaturated, aromatic or non-aromatic, monocyclic or condensed-ring heterocyclic group, and more preferably a heterocyclic group in which the atoms that constitute the ring are selected from a carbon atom, a nitrogen atom or a sulfur atom, the heterocyclic group having at least one heteroatom selected from a nitrogen atom, an oxygen atom or a sulfur atom, and still more preferably, a 5- or 6-membered aromatic heterocyclic group having 3 to 30 carbon atoms. Examples thereof include 2-furyl, 2-thienyl, 2-pyridyl, 4-pyridyl, 2-pyrimidinyl or 2-benzothiazolyl), a cyano group, a hydroxyl group, a nitro group, a carboxyl group,

an alkoxy group (preferably, a substituted or unsubstituted alkoxy group having 1 to 30 carbon atoms, for example, methoxy, ethoxy, isopropoxy, t-butoxy, n-octyloxy, 2-methoxyethoxy), an aryloxy group (preferably, a substituted or unsubstituted aryloxy group having 6 to 30 carbon atoms, for example, phenoxy, 2-methylphenoxy, 2,4-di-t-amylphenoxy, 4-t-butylphenoxy, 3-nitrophenoxy, 2-tetradecanoylaminophenoxy), a silyloxy group (preferably, a silyloxy group having 3 to 20 carbon atoms, for example, trimethylsilyloxy and t-butyl dimethylsilyloxy), a heterocyclic oxy group (preferably, a substituted or unsubstituted heterocyclic oxy group having 2 to 30 carbon atoms, and the heterocyclic moiety is preferably a heterocyclic moiety described in connection with the heterocyclic group above, for example, 1-phenyltetrazol-5-oxy, 2-tetrahydropyranyloxy),

an acyloxy group (preferably, a formyloxy group, a substituted or unsubstituted alkylcarbonyloxy group having 2 to 30 carbon atoms, a substituted or unsubstituted arylcarbonyloxy group having 6 to 30 carbon atoms, for example, formyloxy, acetyloxy, pivaloyloxy, stearoyloxy, benzoyloxy, p-methoxyphenylcarbonyloxy), a carbamoyloxy group (preferably, a substituted or unsubstituted carbamoyloxy group having 1 to 30 carbon atoms, for example, N,N-dimethylcarbamoyloxy, N,N-diethylcarbamoyloxy, morpholinocarbonyloxy, N,N-di-n-octylaminocarbonyloxy, N-n-octylcarbamoyloxy), an alkoxycarbonyloxy group (preferably, a substituted or unsubstituted alkoxycarbonyloxy group having 2 to 30 carbon atoms, for example, methoxycarbonyloxy, ethoxycarbonyloxy, t-butoxycarbonyloxy, n-octylcarbonyloxy), an aryloxycarbonyloxy group (preferably, a substituted or unsubstituted aryloxycarbonyloxy group having 7 to 30 carbon atoms, for example, phenoxy carbonyloxy, p-methoxy phenoxycarbonyloxy, and p-n-hexadecyloxyphenoxycarbonyloxy),

an amino group (preferably, an amino group, a substituted or unsubstituted alkylamino group having 1 to 30 carbon atoms, a substituted or unsubstituted arylamino group having 6 to 30 carbon atoms, a heterocyclic amino group having 0 to 30 carbon atoms, for example, amino, methylamino, dimethylamino, anilino, N-methyl-anilino, diphenylamino, N-1,3,5-triazin-2-ylamino), an acylamino group (preferably, a formylamino group, a substituted or unsubstituted alkylcarbonylamino group having 1 to 30 carbon atoms, a substituted or unsubstituted arylcarbonylamino group having 6 to 30 carbon atoms, for example, formylamino, acetylamino, pivaloylamino, lauroylamino, benzoylamino, 3,4,5-tri-n-octyloxyphenylcarbonylamino), an aminocarbonylamino group (preferably, a substituted or unsubstituted aminocarbonyl amino group having 1 to 30 carbon atoms, for example, carbamoylamino, N,N-dimethylaminocarbonylamino, N,N-diethylaminocarbonylamino, and morpholinocarbonylamino), an alkoxycarbonylamino group (preferably, a substituted or unsubstituted alkoxycarbonylamino group having 2 to 30 carbon atoms, for example, methoxycarbonylamino, ethoxycarbonylamino, t-butoxycarbonylamino, n-octadecyloxycarbonylamino, and N-methylmethoxy carbonylamino),

an aryloxycarbonylamino group (preferably, a substituted or unsubstituted aryloxy carbonylamino group having 7 to 30 carbon atoms, for example, phenoxycarbonylamino, p-chlorophenoxycarbonylamino, m-n-octyloxyphenoxycarbonylamino), a sulfamoylamino group (preferably, a substituted or unsubstituted sulfamoylamino group having 0 to 30 carbon atoms, for example, sulfamoylamino, N,N-dimethylaminosulfonylamino, and N-n-octylaminosulfonylamino), an alkyl- or arylsulfonylamino group (preferably, a substituted or unsubstituted alkylsulfonylamino group having 1 to 30 carbon atoms, a substituted or unsubstituted arylsulfonylamino group having 6 to 30 carbon atoms, for example, methylsulfonylamino, butylsulfonylamino, phenylsulfonylamino, 2,3,5-trichlorophenylsulfonylamino, and p-methylphenyl sulfonylamino), a mercapto group,

an alkylthio group (preferably, a substituted or unsubstituted alkylthio group having 1 to 30 carbon atoms, for example, methylthio, ethylthio, n-hexadecylthio), an arylthio group (preferably, a substituted or unsubstituted arylthio group having 6 to 30 carbon atoms, for example, phenylthia, p-chlorophenylthio, m-methoxyphenylthio), a heterocyclic thio group (preferably, a substituted or unsubstituted heterocyclic thio group having 2 to 30 carbon atoms, and the heterocyclic moiety is preferably a heterocyclic moiety described in connection with the heterocyclic group above, for example, 2-benzothiazolylthio, 1-phenyltetrazol-5-ylthio), a sulfamoyl group (preferably, a substituted or unsubstituted sulfamoyl group having 0 to 30 carbon atoms, for example, N-ethylsulfamoyl, N-(3-dodecyloxypropyl)sulfamoyl, N,N-dimethylsulfamoyl, N-acetylsulfamoyl, N-benzoylsulfamoyl, and N-(N'-phenylcarbamoyl)sulfamoyl), a sulfo group,

an alkyl- or arylsulfinyl group (preferably, a substituted or unsubstituted alkylsulfinyl group having 1 to 30 carbon atoms, a substituted or unsubstituted arylsulfinyl group having 6 to 30 carbon atoms, for example, methylsulfinyl, ethylsulfinyl, phenylsulfinyl, and p-methylphenylsulfinyl), an alkyl- or arylsulfonyl group (preferably, a substituted or unsubstituted

alkylsulfonyl group having 1 to 30 carbon atoms, a substituted or unsubstituted arylsulfonyl group having 6 to 30 carbon atoms, for example, methylsulfonyl, ethylsulfonyl, phenylsulfonyl, and p-methylphenylsulfonyl), an acyl group (preferably, a formyl group, a substituted or unsubstituted alkylcarbonyl group having 2 to 30 carbon atoms, a substituted or unsubstituted arylcarbonyl group having 7 to 30 carbon atoms, for example, acetyl, pivaloyl, 2-chloroacetyl, stearoyl, benzoyl, p-n-octyloxyphenylcarbonyl), an aryloxycarbonyl group (preferably, a substituted or unsubstituted aryloxycarbonyl group having 7 to 30 carbon atoms, for example, phenoxycarbonyl, o-chlorophenoxycarbonyl, m-nitrophenoxycarbonyl, and p-t-butylphenoxycarbonyl),

an alkoxycarbonyl group (preferably, a substituted or unsubstituted alkoxycarbonyl group having 2 to 30 carbon atoms, for example, methoxycarbonyl, ethoxycarbonyl, t-butoxycarbonyl, n-octadecyloxycarbonyl), a carbamoyl group (preferably, a substituted or unsubstituted carbamoyl having 1 to 30 carbon atoms, for example, carbamoyl, N-methylcarbamoyl, N,N-dimethylcarbamoyl, N,N-di-n-octylcarbamoyl, N-(methylsulfonyl)carbamoyl), and aryl- or heterocyclic azo group (preferably, a substituted or unsubstituted arylazo group having 6 to 30 carbon atoms, a substituted or unsubstituted heterocyclic azo group having 3 to 30 carbon atoms (the heterocyclic moiety is preferably a heterocyclic moiety described in connection with the heterocyclic group above), for example, phenylazo, p-chlorophenylazo, 5-ethylthio-1,3,4-thiadiazole-2-ylazo), an imide group (preferably, a substituted or unsubstituted imide group having 2 to 30 carbon atoms, for example, N-succinimide, N-phthalimide), a phosphino group (preferably, a substituted or unsubstituted phosphino group having 2 to 30 carbon atoms, for example, dimethylphosphino, diphenylphosphino, methylphenoxyphosphino), a phosphinyl group (preferably, a substituted or unsubstituted phosphinyl group having 2 to 30 carbon atoms, for example, phosphinyl, dioctyloxyphosphinyl, and diethoxyphosphinyl), and

a phosphinyloxy group (preferably, a substituted or unsubstituted phosphinyloxy group having 2 to 30 carbon atoms, for example, diphenoxyphosphinyloxy, dioctyloxyphosphinyloxy), a phosphinylamino group (preferably, a substituted or unsubstituted phosphinylamino group having 2 to 30 carbon atoms, for example, dimethoxyphosphinylamino, dimethylaminophosphinylamino), a silyl group (preferably, a substituted or unsubstituted silyl group having 3 to 30 carbon atoms, for example, trimethylsilyl, t-butyldimethylsilyl, and phenyldimethylsilyl).

Among the functional groups described above, those having a hydrogen atom may be further substituted with any one of the groups described above by eliminating the hydrogen atom. Examples of the functional group include an alkylcarbonylaminosulfonyl group, an arylcarbonylaminosulfonyl group, an alkylsulfonylaminocarbonyl group, and an arylsulfonylaminocarbonyl group. Specific examples include a methylsulfonylaminocarbonyl group, a p-methylphenylsulfonylaminocarbonyl group, an acetylaminosulfonyl group, and a benzoylaminosulfonyl group.

From the viewpoint of dispersion stability, developability, and light resistance, monomer (b-1) is preferably a monomer having an amino group, a pyridinyl group, an imidazoyl group, a phthalimide group, a naphthalimide group, a benzimidazole group, or an acridone group. A monomer having an amino group or a naphthalimide group is more preferable.

A known monomer having a weight-average molecular weight of from 50 to 1,000, the monomer having at least one selected from an amino group or a heterocyclic group containing nitrogen, can be used as monomer (b-1). From the viewpoint of a polymerization ability, the monomer is preferably an acrylic monomer or a styrene monomer. Most preferably, the monomer is an acrylic ester monomer represented by the following formula (K), or a styrene monomer represented by the following formula (L). By using a monomer such as this, specific resin B can have an amino group and a heterocyclic group containing nitrogen, which can form a strong interaction with a zinc halide phthalocyanine pigment, in a side chain, and therefore dispersion stability and light resistance of the titanium black dispersion composition and the radiation-sensitive composition are improved.

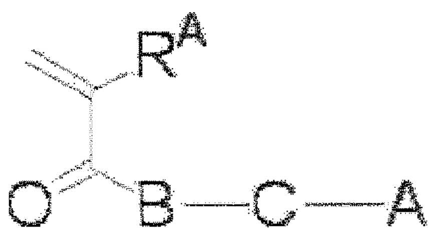

(K)

In formula (K), $R^A$ represents a hydrogen atom, a methyl group, a trifluoromethyl group, a hydroxymethyl group, a fluorine atom, or a chlorine atom. B represents an oxygen atom or $-N(R^B)-$. $R^B$ represents a hydrogen atom, an alkyl group, a cycloalkyl group, or an aryl group. C represents a divalent linking group. A represents an amino group or a heterocyclic group containing nitrogen.

In formula (K), $R^A$ is particularly preferably a hydrogen atom or a methyl group.

The divalent linking group represented by C is preferably an alkylene group having 2 to 20 carbon atoms, an alkylene aminocarbonyl group having 2 to 20 carbon atoms, a cycloalkylene group having 5 to 10 carbon atoms or an

arylene group having 6 to 10 carbon atoms, more preferably an alkylene group having 2 to 10 carbon atoms or an alkylene aminocarbonyl group having 2 to 10 carbon atoms.

The alkyl group represented by $R^B$ includes an alkyl group having 1 to 10 carbon atoms, and an alkyl group having 1 to 5 carbon atoms is preferable. The amino group or the heterocyclic group containing nitrogen, represented by A, has the same definitions as the amino group or the heterocyclic group containing nitrogen included in monomer (b-1), and the preferable ranges thereof are also the same.

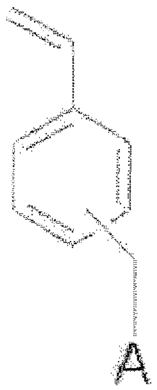

(L)

In formula (L), A represents an amino group or a heterocyclic group containing nitrogen. The amino group or the heterocyclic group containing nitrogen represented by A has the same definitions as the amino group or the heterocyclic group containing nitrogen included in monomer (b-1), and the preferable ranges thereof are also the same.

Monomer (b-1) may be used singly, or as a combination of two or more kinds thereof.

The following are specific examples of monomer (b-1). However, the invention is not limited to these examples. In specific examples (M-1) to (M-23) and (M-31) to (M-50), $R^A$ represents a hydrogen atom, a methyl group, a trifluoromethyl group, a hydroxymethyl group, a fluorine atom, or a chlorine atom.

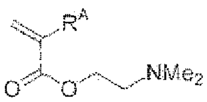

(M-1)

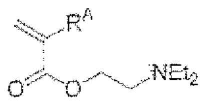

(M-2)

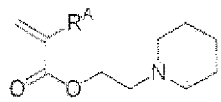

(M-3)

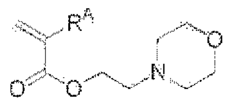

(M-4)

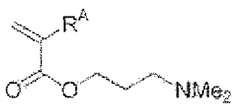

(M-5)

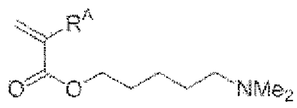

(M-6)

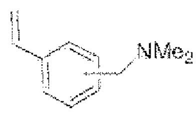

(M-7)

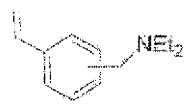

(M-8)

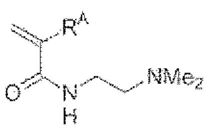

(M-9)

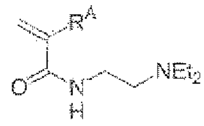

(M-10)

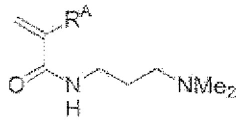

(M-11)

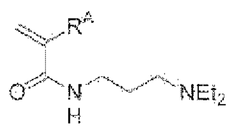

(M-12)

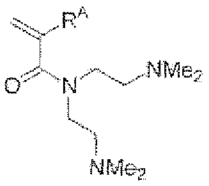 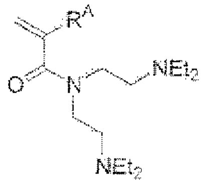 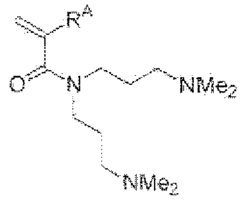 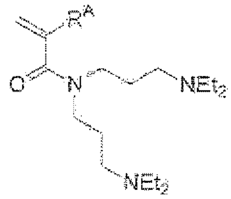

(M-13) (M-14) (M-15) (M-16)

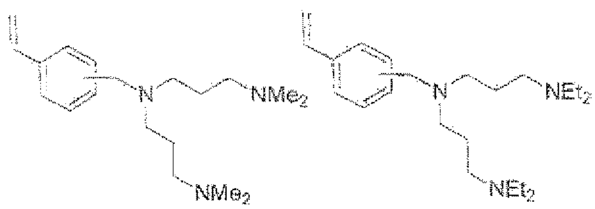 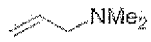 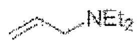

(M-17) (M-18) (M-19) (M-20)

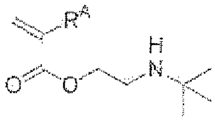 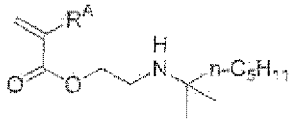 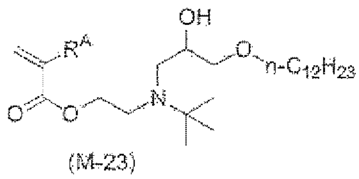

(M-21) (M-22) (M-23)

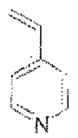 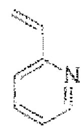 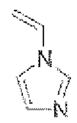

(M-31) (M-32) (M-33)

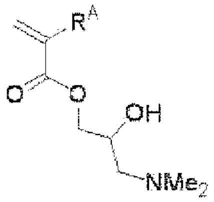 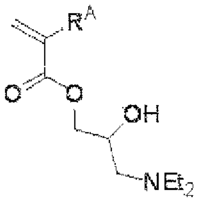 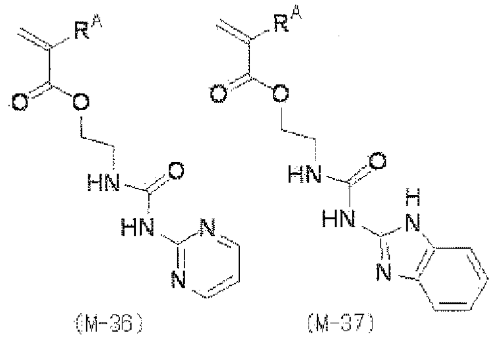

(M-34) (M-35) (M-36) (M-37)

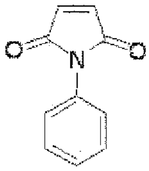
(M-38)

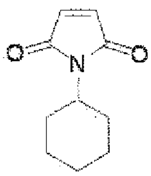
(M-39)

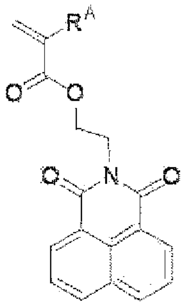
(M-40)

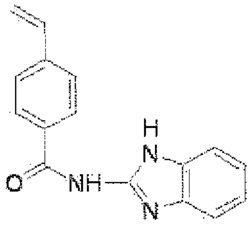
(M-41)

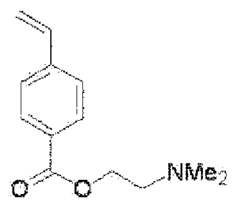
(M-42)

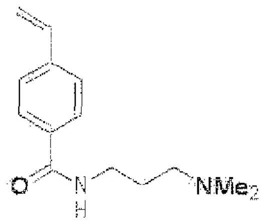
(M-43)

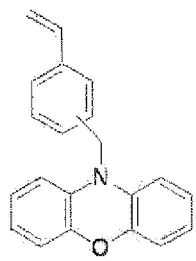
(M-44)

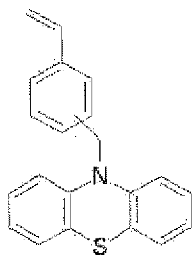
(M-45)

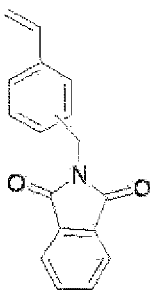
(M-46)

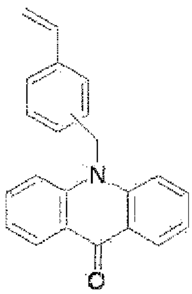
(M-47)

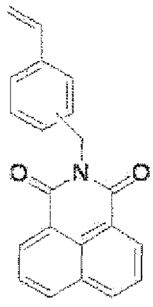
(M-48)

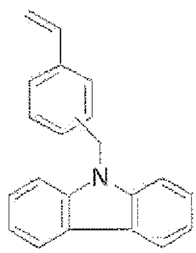
(M-49)

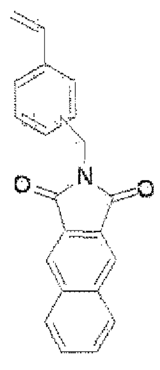
(M-50)

Among these specific examples, (M-1) to (M-6), (M-9) to (M-16), (M-21) to (M-23), (M-37), (M-40), (M-47), (M-48) and (M-49) in which $R^A$ is a hydrogen atom or a methyl group are preferable. From the viewpoint of dispersion stability of the dispersion composition, and developability of the radiation-sensitive composition including the dispersion composition, (M-1), (M-2), (M-11), (M-12), (M-37), (M-47) and (M-48) in which $R^A$ is a hydrogen atom or a methyl group are particularly preferable.

<(b-2) Monomer having carboxyl group>

Monomer (b-2) having a carboxylic group (hereinbelow, also referred to as "monomer (b-2)") has at least one carboxyl group and has a weight average molecular weight of from 50 to 500.

A known monomer having a weight average molecular weight of from 50 to 500, and having at least one carboxyl group, can be used as monomer (b-2). From the viewpoint of a polymerization ability, the monomer is preferably an acrylic monomer or a styrene monomer. Most preferably, the monomer is a (meth)acrylic ester monomer or a (meth)acrylic amide monomer.

Monomer (b-2) may be used singly, or as a combination of two or more kinds.

The following are specific examples of monomer (b-2). However, the invention is not limited to these specific examples. In specific examples (M-24) to (M-30), (M-51) and (M-52), $R^A$ represents a hydrogen atom, a methyl group, a trifluoromethyl group, a hydroxymethyl group, a fluorine atom, or a chlorine atom.

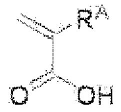

(M-24)

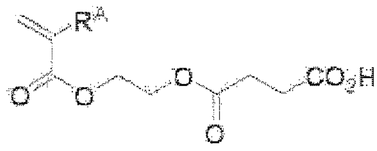

(M-25)

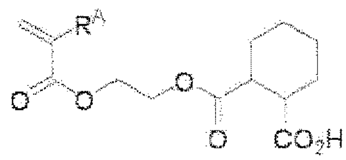

(M-26)

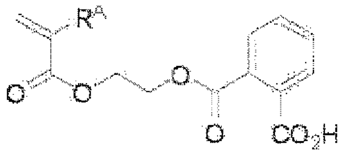

(M-27)

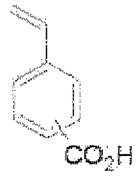

(M-28)

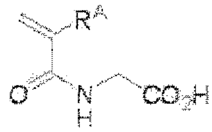

(M-29)

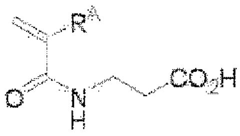

(M-30)

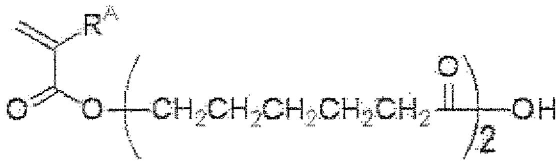

(M-51)

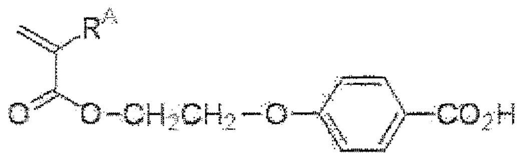

(M-52)

Among these specific examples, (M-24) and (M-29) in which $R^A$ is a hydrogen atom or a methyl group are preferable, from the viewpoint of dispersion stability of the dispersion composition, and developability of the radiation-sensitive composition including the dispersion composition, and (M-24) in which $R^4$ is a hydrogen atom or a methyl group is most preferred.

<(b-3) Macromonomer having weight average molecular weight of from 1,000 to 50,000>

Macromonomer (b-3) (hereinbelow, also referred to as "macromonomer (b-3)") has a weight average molecular weight of from 1,000 to 50,000, and it is an oligomer or a polymer having a polymerizable group at its end.

The weight average molecular weight of macromonomer (b-3) is from 1,000 to 50,000, preferably from 1,000 to 20,000, more preferably from 2,000 to 10,000, and most preferably from 2,000 to 5,000. When the weight average molecular weight of macromonomer (b-3) is within this range, dispersibility and dispersion stability of the dispersion composition, and developability of the radiation-sensitive composition including the dispersion composition are improved.

The weight average molecular weight described in the present specification is a value obtained by GPC (Gel Permeation Chromatography) and calculated in polystyrene equivalent as a reference.

A known monomer can be used as macromonomer (b-3).

Examples of macromonomer (b-3) include macromonomer AA-6 (poly(methyl methacrylate) having a methacryloyl group at a terminal), AS-6 (polystyrene having a methacryloyl group at a terminal), AN-6S (a copolymer of styrene and acrylonitrile having a methacryloyl group at a terminal), AB-6 (poly(butyl acrylate) having a methacryloyl group at a terminal), which are manufactured by TOAGOSEI CO., LTD.; PLACCEL FM5 (2-hydroxyethyl methacrylate added with 5 moles of ε-caprolactone) and FA10L (2-hydroxyethyl acrylate added with 10 moles of ε-caprolactone), which are manufactured by DAICEL CHEMICAL INDUSTRIES, LTD.; and a polyester type macromonomer disclosed in JP-A No. 2-272009. Among them, from the viewpoint of dispersibility and dispersion stability of the dispersion composition, and developability and light resistance of the radiation-sensitive composition including the dispersion composition, the polyester type macromonomer, which exhibits excellent flexibility and solvophilicity, is particularly preferable. The polyester type macromonomer represented by the following formula (M) is most preferable.

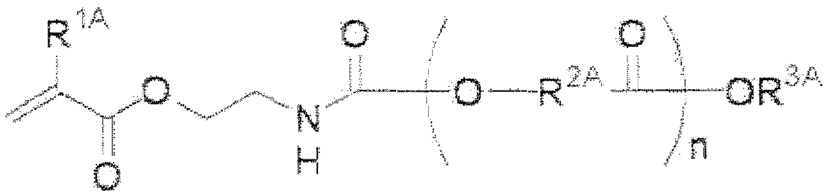

(M)

In formula (M), $R^{1A}$ represents a hydrogen atom or a methyl group. $R^{2A}$ represents an alkylene group. $R^{3A}$ represents alkyl group. n represents an integer from 5 to 100.

$R^{2A}$ is preferably a linear or branched alkylene group having 5 to 20 carbon atoms, most preferably $-(CH_2)_5-$. $R^{3A}$ is preferably a linear or branched alkyl group having 5 to 20 carbon atoms. n is preferably an integer from 5 to 30, most preferably an integer from 10 to 20.

Macromonomer (b-3) may be used singly, or as a combination of two or more kinds thereof.

Specific resin B preferably contains a repeating unit originating from monomer (b-1) in an amount of 10 to 50% by mass with respect to the total mass of specific resin B, more preferably in an amount of 15 to 45% by mass, most preferably in an amount of 20 to 40% by mass. When the content of the repeating unit originating from monomer (b-1) is within this range, dispersibility and dispersion stability of the dispersion composition, and resistance with respect to a developer of the radiation-sensitive composition including the dispersion composition, are further improved.

From the viewpoint of dispersibility, and dispersion stability, the repeating unit originating from monomer (b-1) in specific resin B preferably contains an amino group.

The repeating unit originating from monomer (b-1) in specific resin B preferably contains both of an amino group and a heterocyclic group containing nitrogen, from the viewpoint of further improvement in dispersibility and dispersion stability. More preferably, the heterocyclic group containing nitrogen is contained in a side chain structure of specific resin B.

The content ratio of the amino group to the heterocyclic group containing nitrogen in the repeating unit originating from monomer (b-1) in specific resin B (i.e., amino group : heterocyclic group containing nitrogen, mass ratio) is preferably between 100 : 0 and 5 : 95, more preferably between 100 : 0 and 10 : 90, and most preferably between 100 : 0 and 15 : 85.

The acid value of specific resin B is preferably in the range of from 10 mgKOH/g to 200 mgKOH/g, more preferably in the range of from 20 mgKOH/g to 150 mgKOH/g, and most preferably in the range of from 40 mgKOH/g to 100 mgKOH/g. When the acid value of specific resin B is within this range, dispersibility and dispersion stability of the dispersion composition, and developability of the radiation-sensitive composition including the dispersion composition, are improved. The acid value of specific resin B can be measured by carrying out titration with a base.

The repeating unit originating from monomer (b-2) is preferably contained in specific resin B such that the acid value of specific resin B is within the range above.

Specific resin B preferably contains a repeating unit originating from monomer (b-3) in an amount of 15 to 90% by mass with respect to the total mass of specific resin B, more preferably in an amount of 25 to 80% by mass, most preferably in an amount of 35 to 60% by mass. When the content of the repeating unit originating from the monomer (b-3) is within this range, dispersibility and dispersion stability of the dispersion composition, and developability of the radiation-sensitive composition including the dispersion composition, are further improved.

Specific examples of specific resin B include resins (J-1) to (J-9) and (J-12) to (J-20), which are described in the Examples together with the synthesis examples thereof, but the invention is not limited thereto.

The weight average molecular weight of specific resin B is a value obtained by measuring by GPC and calculating in polystyrene equivalent, and it is preferably from 5,000 to 30,000, more preferably from 7,000 to 25,000, and most preferably from 10,000 to 20,000. When the weight average molecular weight of specific resin B is within this range, dispersibility and dispersion stability of the dispersion composition, and developability of the radiation-sensitive composition including the dispersion composition, are further improved.

The content ratio of a repeating unit originating from monomer (b-1), a repeating unit originating from monomer (b-2) and a repeating unit originating from macromonomer (b-3) in specific resin B (i.e., b-1 : b-2 : b-3, mass ratio) is preferably 10 to 50 : 2 to 30 : 30 to 80, more preferably 20 to 50 : 5 to 20 : 40 to 70, and still more preferably 20 to 4-0 : 8 to 20 : 40 to 60.

Specific resin B may have a curing property.

In order to enhance the curing property of specific resin B, a polymerizable group may be introduced therein. As a method of introducing a polymerizable group, a known method can be used, such as a method of reacting a carboxyl group included in specific resin B and (meth)acrylate including an epoxy group (for example, glycidyl methacrylate) and a method of reacting a hydroxyl group included in specific resin B and (meth)acrylate including an isocyanate group or a cyclic acid anhydride containing a polymerizable group.

When specific resin B has a polymerizable property, it is preferable that the repeating unit having a polymerizable

group is contained in an amount of from 5 to 50% by mass with respect to the total mass of specific resin B, more preferably, in an amount of from 10 to 40% by mass.

In order to improve the solubility in a solvent or the coating property of specific resin B, it may contain repeating units other than those described above. Examples of such repeating units include a repeating unit derived from alkyl (meth)acrylate, cycloalkyl (meth)acrylate, aralkyl (meth)acrylate, (meth)acrylic acid amide, 2-hydroxyethyl (meth)acrylate, styrene etc.

It is preferable that specific resin B is produced by radical polymerization from monomer (b-1), monomer (b-2), macromonomer (b-3), and if necessary, other optional monomers as source materials. When specific resin B is produced by radical polymerization, polymerization conditions such as temperature, pressure, type and amount of a radical initiator, and type of a solvent, may be the same as those of an ordinary method.

Because the dispersion composition of the invention exhibits excellent dispersibility and dispersion stability due to specific resin B contained therein, it is possible to include therein the particles containing titanium black particles at high concentration.

(Resin including a repeating unit having an alkylene oxide structure in a side chain: specific resin C)

A resin including a repeating unit having an alkylene oxide structure in a side chain (hereinbelow, also referred to as "specific resin C") is another preferred embodiment of (B) a dispersant used in the invention, in addition to the dispersants as described above.

Examples of the monomer for forming a repeating unit having an alkylene oxide structure in a side chain include a monomer having ethylene oxide in a side chain. Examples of the monomer having ethylene oxide in a side chain include a monomer represented by the following formula (N).

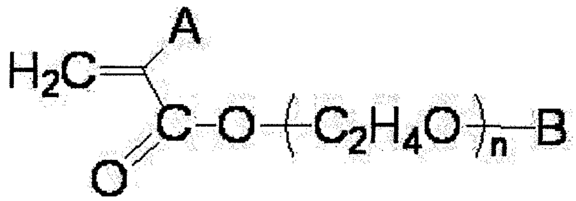

(N)

In formula (N), A represents a hydrogen atom or a methyl group. B represents a hydrogen atom, a substituted or unsubstituted aryl group, and a substituted or unsubstituted, linear or branched alkyl group. Preferred examples of B include an alkyl group having 12 or less carbon atoms or a hydrogen atom. More preferred examples of B include an alkyl group having 4 or less carbon atoms and a hydrogen atom. Most preferred example of B is a methyl group. n is 1 to 100, preferably 3 to 30, more preferably 7 to 11, and most preferably 8 to 10.

Examples of the monomer for forming a repeating unit having an alkylene oxide structure in a side chain include the followings polyalkylene glycol (meth)acrylates manufactured by NOF CORPORATION, but the invention is not limited thereto.

BLEMMER PME series (methoxypolyethylene glycol monomethacrylate, for example, BLEMMER PME-100, PME-200, PME-400, PME-1000, PME-4000), BLEMMER AME series (methoxypolyethylene glycol monomethacrylate (for example, BLEMMER AME-400), BLEMMER PLE series (lauroyloxypolyethylene glycol monomethacrylate), series (stearoxy polyethylene glycol monomethacrylate), BLEMMER ANE series (nonylhenoxypolyethylene glycol monoacrylate), BLEMMER PE series (polyethylene glycol monomethacrylate, for example, BLEMMER PE-90, PE-200, PE-350), and BLEMMER AE series (polyethylene glycol monoacrylate, for example, BLEMMER AE-90, AE-200, AE-400).

Specific resin C preferably has a group that promotes alkali solubility (hereinbelow, also referred to as an "acid group"). Examples of the acid group include a carboxylic group, a phosphoric group, a sulfonic group, and a phenolic hydroxyl group. An acid group which is soluble in an organic solvent and capable of being developed with a weak alkali aqueous solution is preferable. (Meth)acrylic acid is particularly preferable. The acid group contained in specific resin C may be used alone, or as a combination of two or more kinds thereof.

In order to introduce an acid group to specific resin C, a monomer having an acid group and/or a monomer capable of imparting an acid group to specific resin C after polymerization can be used as a monomer component for polymerization of the specific resin C. The monomer may be used alone, or as a combination of two or more kinds thereof. Examples of the monomer capable of imparting an acid group to specific resin C after polymerization include a monomer having a hydroxyl group such as 2-hydroxymethyl (meth)acrylate, and a monomer having an epoxy group such as glycidyl (meth)acrylate, a monomer having an isocyanate group such as 2-isocyanate ethyl (meth)acrylate. Further, when an acid group is introduced into specific resin C by using a monomer capable of imparting an acid group after polymerization, for example, a treatment for imparting an acid group as explained below may be carried out after

polymerization. The treatment for imparting an acid group after polymerization varies depending on the type of the monomer, and exemplary treatments include the following.

When a monomer having a hydroxyl group is used, for example, a treatment of adding an acid anhydride such as succinic anhydride, tetrahydrophthalic anhydride or maleic anhydride.

When a monomer having an epoxy group is used, for example, a treatment of adding a compound having an amino group and an acid group such as N-methylamino benzoic acid or N-methylaminophenol, and a treatment of adding an acid anhydride such as succinic anhydride, tetrahydrophthalic anhydride or maleic anhydride to a hydroxyl group generated after the addition of an acid such as (meth)acrylic acid.

When a monomer having an isocyanate group is used, for example, a treatment of adding a compound having a hydroxyl group and an acid group such as 2-hydroxybutyric acid.

In addition to the monomers described above, other specific examples of the monomer which can form specific resin C include, although not specifically limited, a monomer such as an alkyl (meth)acrylate, an aryl (meth)acrylate, a vinyl compound, and an N-substituted maleimide monomer.

Examples of the alkyl (meth)acrylate and the aryl (meth)acrylate include methyl (meth)acrylate, ethyl (meth)acrylate, propyl (meth)acrylate, butyl (meth)acrylate, isobutyl (meth)acrylate, pentyl (meth)acrylate, hexyl (meth)acrylate, octyl (meth)acrylate, phenyl (meth)acrylate, benzyl (meth)acrylate, tolyl (meth)acrylate, naphthyl (meth)acrylate, and cyclohexyl (meth)acrylate. Examples of the vinyl compound include styrene, α-methylstyrene, vinyltoluene, glycidyl methacrylate, acrylonitrile, vinyl acetate, N-vinylpyrrolidone, tetrahydrofurfuryl methacrylate, polystyrene macromonomer, and polymethyl methacrylate macromonomer. Examples of the N-substituted maleimide monomer include N-phenylmaleimide and N-cyclohexylmaleimide described in JP-A No. 10-300922. These monomers may be used alone, or as a combination of two or more kinds thereof.

Preferred examples of specific resin C include a ter- or higher polymer at least containing methoxypolyethylene glycol anonomethacrylate, methacrylic acid, and benzyl methacrylate. Most preferred example is a quadri- or higher polymer at least containing methoxypolyethylene glycol monomethacrylate, methacrylic acid, and benzyl methacrylate.

The weight average molecular weight of specific resin C is a value obtained by measuring by GPC and calculating in polystyrene equivalent, and it is preferably from 5,000 to 700,000, more preferably from 8,000 to 30,000, and most preferably from 9,000 to 11,000.

The following are specific examples of specific resin C, but the invention is not limited thereto. In this regard, the figures added to each structural unit (the main chain part) indicate the percentage by mole of the structural unit. In addition, iBu represents an isobutyl group.

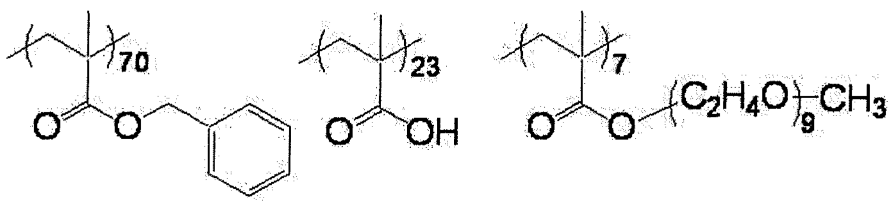

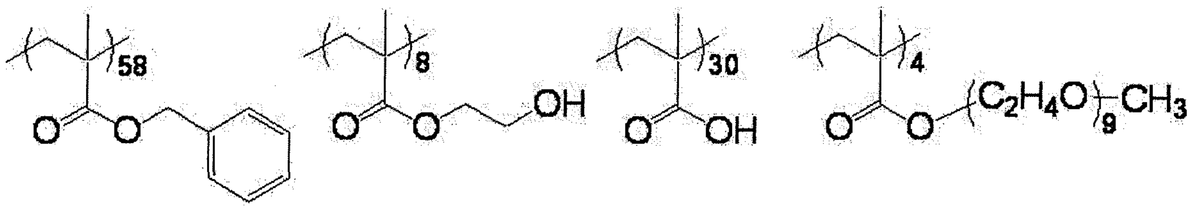

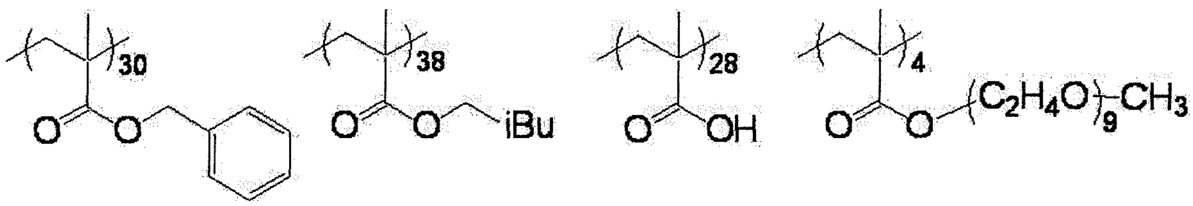

The content of the dispersant in the dispersion composition of the invention with respect to the total mass of the particles is preferably from 20 to 80% by mass, more preferably from 20 to 50% by mass, and still more preferably from 20 to 45% by mass. When the content of the dispersant is within this range, the concentration of the particles in

the dispersion composition can be sufficiently increased. For such reasons, when the radiation-sensitive composition containing the dispersion composition of the invention is used for forming a light blocking film of a solid-state imaging element, for example, improvements in resolution can be achieved as a result of reducing the film thickness. The dispersant may be used alone, or as a combination of two or more kinds thereof.

The content of the dispersant in the titanium black dispersion of the invention with respect to the total solid content of the particles (including the particles consisting of titanium black particles and other dispersed particles such as a colorant) is preferably from 1% by mass to 90% by mass and more preferably from 3% by mass to 70% by mass.

Further, the content of the dispersant in the radiation-sensitive composition of the invention with respect to the total solid content of the particles (including the particles consisting of titanium black particles and other dispersed particles such as a colorant) is preferably from 1% by mass to 90% by mass, and more preferably from 3% by mass to 70% by mass.

(C) Organic solvent

The titanium black dispersion composition and the radiation-sensitive composition contain (C) an organic solvent.

Examples of the organic solvent include the following: as esters, ethyl acetate, n-butyl acetate, isobutyl acetate, amyl formate, isoamyl acetate, isobutyl acetate, butyl propionate, isopropyl butyrate, ethyl butyrate, butyl butyrate, methyl lactate, ethyl lactate, alkyl oxyacetate (methyl oxyacetate, ethyl oxyacetate, butyl oxyacetate (for example, methyl methoxyacetate, ethyl methoxyacetate, butyl methoxyacetate, methyl ethoxyacetate, and ethyl ethoxyacetate)), 3-oxypropionic acid alkyl esters (for example, methyl 3-oxypropionate and ethyl 3-oxypropionate (for example, methyl 3-methoxypropionate, ethyl 3-methoxypropionate, methyl 3-ethoxypropionate, and ethyl 3-ethoxypropionate)), 2-oxypropionic acid alkyl esters (examples: methyl 2-oxypropionate, ethyl 2-oxypropionate, and propyl 2-oxypropionate (for example, methyl 2-methoxypropionate, ethyl 2-methoxypropionic acid, propyl 2-methoxypropionate, methyl 2-ethoxypropionate, and ethyl 2-ethoxypropionate)), methyl 2-oxy-2-methylpropionate and ethyl 2-oxy-2-methylpropionate (for example, methyl 2-methoxy-2-methylpropionate and ethyl 2-ethoxy-2-methylpropionate), methyl pyruvate, ethyl pyruvate, propyl pyruvate, methyl acetoacetate, ethyl acetoacetate, methyl 2-oxobutanonate and ethyl 2-oxobutanonate; as ethers, diethylene glycol dimethyl ether, tetrahydrofuran, ethylene glycol monomethyl ether, ethylene glycol monoethyl ether, methylcellosolve acetate, ethylcellosolve acetate, diethylene glycol monomethyl ether, diethylene glycol monomethyl ether, diethylene glycol monobutyl ether, propylene glycol monomethyl ether, propylene glycol monomethyl ether acetate, propylene glycol monoethyl ether acetate, and propylene glycol monopropyl ether acetate; as ketones, methyl ethyl ketone, cyclohexanone, 2-heptanone, and 3-heptanone; and as aromatic hydrocarbons, toluene and xylene.

The organic solvent may be used alone, or as a combination of two or more kinds thereof.

When two or more kinds of organic solvents are used in combination, a mixture solution of at least two selected from methyl 3-ethoxypropionate, ethyl 3-ethoxypropionate, ethylcellosolve acetate, ethyl lactate, diethylene glycol dimethyl ether, butyl acetate, methyl 3-methoxypropionate, 2-heptanone, cyclohexanone, ethyl carbitol acetate, butyl carbitol acetate, propylene glycol methyl ether, and propylene glycol methyl ether acetate is particularly preferable.

The content of the organic solvent in the titanium black dispersion composition of the invention with respect to the total mass of the dispersion composition is preferably 10% by mass to 80% by mass, more preferably 20% by mass to 70% by mass, and still more preferably 30% by mass to 65% by mass.

Further, the content of the organic solvent in the radiation-sensitive composition with respect to the total mass of the radiation-sensitive composition is preferably 10% by mass to 90% by mass, more preferably 20% by mass to 80% by mass, and still more preferably 25% by mass to 75% by mass.

(D) Polymerizable compound

The radiation-sensitive composition of the invention contains (D) a polymerizable compound comprising at least one compound represented by
Formula (Z-4) or Formula (Z-5):

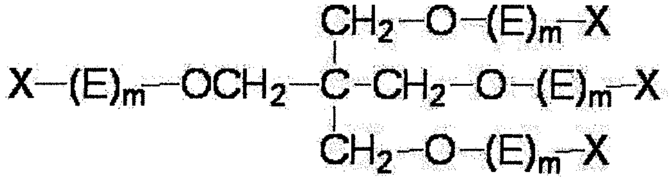

(Z-4)

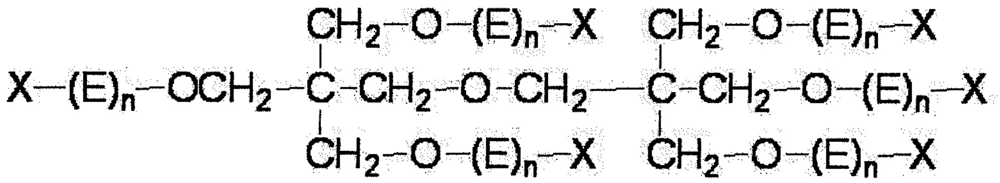
(Z-5)

In formula (Z-4) and (Z-5), each E independently represents $-((CH_2)yCH_2O)-$ or $-((CH_2)yCH(CH_3)O)-$, each y independently represents an integer from 0 to 10, and each X independently represents an acryloyl group, a methacryloyl group, a hydrogen atom, or a carboxyl group.

In formula (Z-4), the sum of the acryloyl group and the methacryloyl group is 3 or 4, each m independently represents an integer from 0 to 10, and the sum of each m is an integer from 0 to 40, provided that any one of X is a carboxyl group when the sum of each m is 0.

In formula (Z-5), the sum of the acryloyl group and the methacryloyl group is 5 or 6, each n independently represents an integer from 0 to 10, and the sum of each n is an integer from 0 to 60, provided that any one of X is a carboxyl group when the sum of each n is 0.

In formula (Z-4), m is preferably an integer from 0 to 6, and more preferably an integer from 0 to 4.

Further, the sum of each m is preferably an integer from 2 to 40, more preferably an integer from 2 to 16, and still more preferably an integer from 4 to 8.

In formula (Z-5), n is preferably an integer from 0 to 6, and more preferably an integer from 0 to 4.

Further, the sum of each n is preferably an integer from 3 to 60, more preferably an integer from 3 to 24, and still more preferably an integer from 6 to 12.

Further, the oxygen-side terminal of $-((CH_2)yCH_2O)-$ or $-((CH_2)yCH(CH_3)O)-$ in formula (Z-4) or formula (Z-5) is preferably bonded to X.

The compound represented by formula (Z-4) or formula (Z-5) may be used alone, or as a combination of two or more kinds thereof. In particular, a compound of formula (ii) in which all of the six of X are an acryloyl group is preferable.

The total content of the compound represented by formula (Z-4) or formula (Z-5) in the polymerizable compound is preferably 20% by mass or more, and more preferably 50% by mass or more.

Compounds represented by formula (Z-4) or formula (Z-5) can be produced by a method including a process of bonding an open-ring structure to pentaerythritol or dipentaerythritol via ring-opening addition reaction of ethylene oxide or propylene oxide, which is a known conventional process, and a process of introducing a (meth)acryloyl group to a terminal hydroxyl group of the open-ring structure by reacting with (meth)acryloyl chloride, for example. Each of these processes is well known in the art, and a person skilled in the art can easily synthesize the compounds represented by formula (Z-4) or formula (Z-5).

Among the compounds represented by formula (Z-4) or formula (Z-5), pentaerythritol derivatives and/or dipentaerythritol derivatives are more preferable.

Specific examples thereof include the compounds represented by the following formula (a) to formula (f) (hereinbelow, also referred to as "exemplary compounds (a) to (f)"), and among them, exemplary compounds (a), (b), (e) and (f) are preferable.

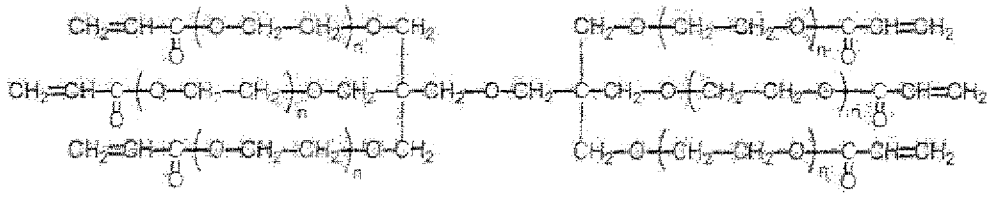
(a)

(The sum of n is 6)

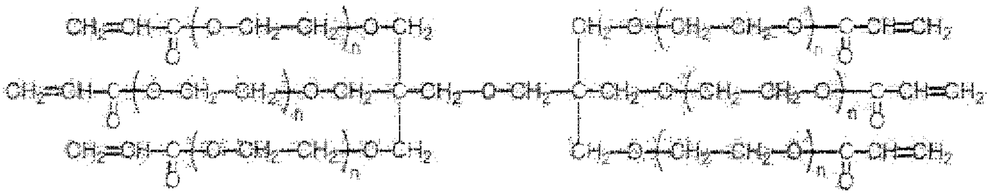
(b)

(The sum of n is 12)

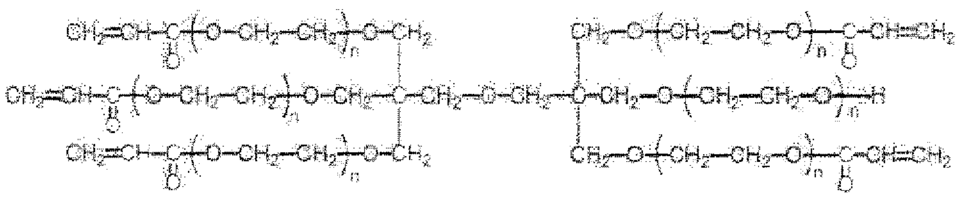

(c)

(The sum of n is 12)

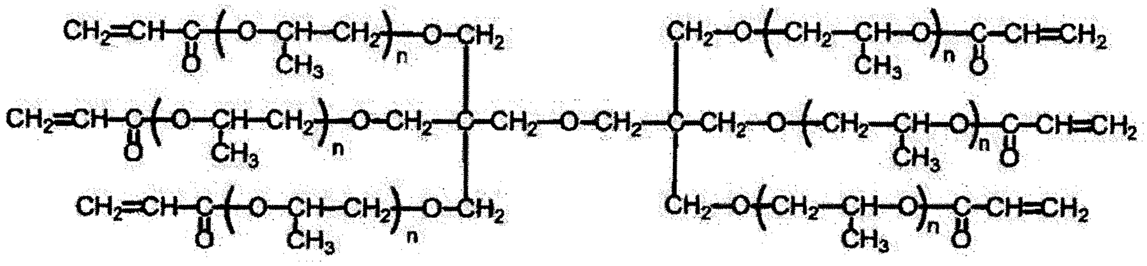

(d)

(The sum of n is 6)

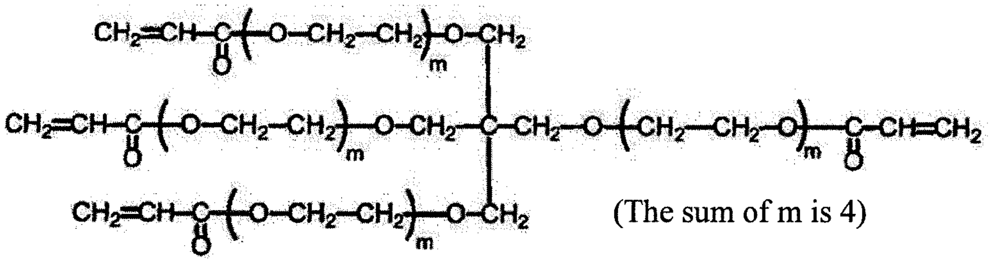

(e)

(The sum of m is 4)

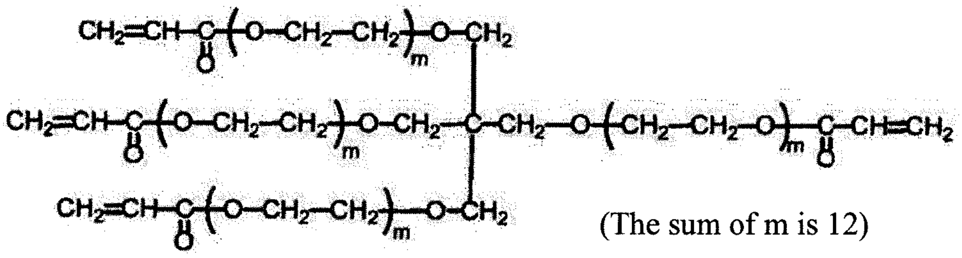

(f)

(The sum of m is 12)

Examples of the commercially available compounds represented by formula (Z-4) or formula (Z-5) include SR-494, trade name, manufactured by Sartomer Company Inc., which is a tetra-functional acrylate having four ethylene oxy chains and DPCA-60, trade name, manufactured by Nippon Kayaku Co., Ltd., which is a hexa-functional acrylate having six pentylene oxy chains, and TPA-330 trade name, manufactured by Nippon Kayaku Co., Ltd., which is a tri-functional acrylate having three isobutylene oxy chains.

Details of the methods of use of these polymerizable compounds, such as the structure of the compounds, single use or use of a combination, the amount to be added, or the like, may arbitrarily be determined in accordance with the intended performance design of the compounds. From the viewpoint of sensitivity, a structure having a high content of unsaturated groups per one molecule is preferable, and in many cases, bifunctionality or higher functionality is desirable. Further, in order to increase the strength of a cured film, trifunctionality or higher functionality is desirable. Also, it is effective to use a method of controlling both the sensitivity and the strength by using compounds having different functionalities and/or different polymerizable groups (for example, acrylic acid ester, methacrylic acid ester, styrene compound and vinyl ether compound) in combination. Further, it is desirable to use also a tri- or higher functional polymerizable compound having ethylene oxide chains with different chain length is preferable from the viewpoint that the developability of the radiation-sensitive composition can be controlled, and therefore an excellent pattern formability is obtained.

The selection and the method of use of the polymerizable compounds are also important factors for the compatibility with other components (for example, a polymerization initiator, the particles and an alkali soluble resin and the like) contained in the radiation-sensitive composition and for the dispersibility. For example, the compatibility may be increased by the use of a compound with low purity, or by the use of a combination of two or more kinds of other components. Moreover, in some cases, a specific structure may be selected for the purpose of improving the adhesion to a hard surface such as a substrate.

The content of the polymerizable compound in the radiation-sensitive composition of the invention is, compared to the total solid matter of the radiation-sensitive composition, preferably in the range of from 0.1% by mass to 90% by mass, more preferably in the range of from 1.0% by mass to 50% by mass, and still more preferably in the range of from 2.0% by mass to 30% by mass.

(E) Polymerization Initiator

The radiation-sensitive composition of the invention contains (E) a photopolymerization initiator.

The photopolymerization initiator used in the invention (hereinbelow, also referred to as a "polymerization initiator"), the following compounds known as a photopolymerization initiator may be used.

The photopolymerization initiator used in the invention is not specifically limited, as long as it has an ability of initiating polymerization of the polymerizable compound described above, and it can be suitably selected from known photopolymerization initiators. For example, it is preferable that the polymerization initiator has sensitivity with respect to light in the range of from the UV region to the visible region. Further, the polymerization initiator may be an activator that generates activated radicals by causing an interaction with a photo-excited sensitizer, or an initiator that initiates cation polymerization depending on the type of the monomers.

Further, the polymerization initiator preferably contains at least one compound having a molar absorption coefficient of about 50 in the range of from about 300 nm to about 800 nm (more preferably, from 330 nm to 500 nm).

Examples of the photopolymerization initiator used in the invention include a halogenated hydrocarbon derivative (for example, a hydrocarbon having a triazine skeleton or an oxadiazole skeleton), an acyl phosphine compound such as an acyl phosphine oxide, hexaaryl biimidazole, an oxime compound such as an oxime derivative, an organic peroxide compound, a thio compound, a ketone compound, an aromatic onium salt, ketoxime ether, an aminoacetophenone compound, and hydroxyacetophenone. Among them, the oxime compound is preferable.

Examples of the halogenated hydrocarbon compound having a triazine skeleton include compounds disclosed in Bull. Chem. Soc. Japan, 42, 2924 (1969) by Wakabayashi et al., compounds disclosed in U.K. Patent No. 1388492, compounds disclosed in JP-A No. 53-133428, compounds disclosed in German Patent No. 3337024, compounds disclosed in J. Org. Chem., 29, 1527 (1964) by F. C. Schaefer et al., compounds disclosed in JP-A No. 62-58241, compounds disclosed in JP-A No. 5-281728, compounds disclosed in JP-A No. 5-34920, and compounds disclosed in U.S. Patent No. 4212976.

Examples of the compounds disclosed in U.S. Patent No. 4212976 include compounds having an oxadiazole skeleton (for example, 2-trichloromethyl-5-phenyl-1,3,4-oxadiazole. 2-trichloromethyl-5-(4-chlorophenyl)-1,3,4-oxadiazole, 2-trichloromethyl-5-(1-naphthyl)-1,3,4-oxadiazole, 2-trichloromethyl-5-(2-naphthyl)-1,3,4-oxadiazole, 2-tribromomethyl-5-phenyl-1,3,4-oxadiazole, 2-tribromomethyl-5-(2-naphthyl)-1,3,4-oxadiazole; 2-trichloromethyl-5-styryl-1,3,4-oxadiazole, 2-trichloromethyl-5-(4-chlorostyryl)-1,3,4-oxadiazole, 2-trichloromethyl-5-(4-methoxystyryl)-1,3,4-oxadiazole, 2-trichloromethyl-5-(1-naphthyl)-1,3,4-oxadiazole, 2-trichloromethyl-5-(4-n-butoxystyryl)-1,3,4-oxadiazole, and 2-tribromomethyl-5-styryl-1,3,4-oxadiazole).

Examples of the polymerization initiator other than those described above include an acridine derivative (for example, 9-phenylacridine, 1,7-bis(9,9'-acridinyl)heptane, etc.), N-phenylglycine, etc., polyhalogen compounds (for example, carbon tetrabromide, phenyltribromomethyl sulfone, phenyltrichloromethyl ketone), coumarins (for example, 3-(2-benzofuranoyl)-7-diethylaminocoumarin, 3-(2-benzofuroyl)-7-(1-pyrrolidinyl)coumarin, 3-benzoyl-7-diethylaminocoumarin, 3-(2-methoxybenzoyl)-7-diethylaminocoumarin, 3-(4-dimethylaminobenzoyl)-7-diethylaminocoumarin, 3,3'-carbonylbis(5,7-di-n-propoxycoumarin), 3,3'-carbonylbis(7-diethylaminocoumarin), 3-benzoyl-7-methoxycoumarin, 3-(2-furoyl)-7-diethylaminocoumarin, 3-(4-diethylaminocinnamoyl)-7-diethylaminocoumarin, 7-methoxy-3-(3-pyridylcarbonyl)coumarin,3-benzoyl-5,7-dipropoxycoumarin, 7-benzotriazol-2-ylcoumarin, and coumarin compounds disclosed in JP-A No. 5-19475, JP-A No. 7-271028, JP-A No. 2002-363206, JP-A No. 2002-363207, JP-A No. 2002-363208, and JP-A No. 2002-363209, etc.), acyl phosphine oxides (for example, bis(2,4,6-trimethylbenzoyl)-phenyl phosphine oxide, bis(2,6-dimethoxybenzoyl)-2,4,4-trimethyl-pentylphenyl phosphine oxide, LucirinTPO), metallocenes (for example, bis(η 5-2,4-cyclopentadien-1-yl)-bis(2,6-difluoro-3-(1H-pyrrol-1-yl)-phenyl)titanium, η5-cyclopentadienyl-η6-cumenyl-iron(1+)-hexafluorophosphate(1-), etc.), and compounds disclosed in JP-A No. 53-133428, JP-B No. 57-1819, JP-B No. 57-6096, and U.S. Patent No. 3615455.

Examples of the ketone compound include benzophenone, 2-methylbenzophenone, 3-methylbenzophenone, 4-methylbenzophenone, 4-methoxybenzophenone, 2-chlorobenzophenone, 4-chlorobenzophenone, 4-bromobenzophenone, 2-carboxybenzophenone, 2-ethoxycarbonylbenzophenone, benzophenonetetracarboxylic acid or a tetramethyl ester thereof, 4,4'-bis(dialkylamino)benzophenones (for example, 4,4'-bis(dimethylamino)benzophenone, 4.,4'-bis dicyclohexylamino)benzophenone, 4,4'-bis(diethylamino)benzophenone, 4,4'-bis(dihydroxyethylamino)benzophenone, 4-methoxy-4'-dimethylaminobenzophenone, 4,4'-dimethoxybenzophenone, 4-dimethylaminobenzophenone, 4-dimethylaminoacetophenone, benzil, anthraquinone, 2-t-butylanthraquinone, 2-methylanthraquinone, phenanthraquinone, xanthone, thioxanthone, 2-chloro thioxanthone, 2,4-diethyl thioxanthone, fluorenone, 2-benzyl-dimethylamino-1-(4-morpholinophenyl)-1-butanone, 2-methyl-1-[4-(methylthio)phenyl]-2-morpholino-1-propanone, 2-hydroxy-2-methyl-[4-(1-methylvinyl)phenyl]propanol oligomer, benzoin, benzoin ethers (for example, benzoin methyl ether, benzoin ethyl ether, benzoin propyl ether, benzoin isopropyl ether, benzoin phenyl ether, benzil dimethyl ketal), acridone, chloroacridone, N-methylacridone, N-butylacridone, and N-butylchloroacridone.

A hydroxyacetophenone compound, an aminoacetophenone compound, and an acyl phosphine compound may also be suitably used as the polymerization initiator. More specifically, the aminoacetophenone-based initiators described in JP-A No. 10-291969 and the acyl phosphine oxide-based initiators described in Japanese Patent No. 4225898 may also be used.

Examples of the hydroxyacetophenone-based initiators include IRGACURE-184, DAROCUR-1173, IRGACURE-500, IRGACURE-2959 and IRGACURE-127 (trade names, all manufactured by BASF Japan). Examples of the aminoacetophenone-based initiators include IRGACURE-907, IRGACURE-369 and IRGACURE-379 (trade names, all manufactured by BASF Japan). The aminoacetophenone-based initiators include the compounds described in JP-ANo. 2009-191179, which have an absorption wavelength being matched to long wavelength light such as 365 nm or 405 nm. Further, as an acylphosphine-based initiator, commercially available IRGACURE-819 or DAROCUR-TPO (trade names, all manufactured by BASF Japan) can be used.

More preferred examples of the polymerization initiator include an oxime compound. Specific examples of the oxime compound include the compounds disclosed in JP-A No. 2001-233842, the compounds disclosed in JP-A No. 2000-80068, and the compounds disclosed in JP-A No. 2006-342166.

Examples of the oxime compound such as oxime derivative that is suitably used in the invention as a polymerization initiator include 3-benzoyloxyiminobutan-2-one, 3-acetoxyiminobutan-2-one, 3-propionyloxyiminobutan-2-one, 2-acetoxyiminopentan-3-one, 2-acetoxyimino-1-phenylpropan-1-one, 2-benzoyloxyimino-1-phenylpropan-1-one, 3-(4-toluenesulfonyloxy)iminobutan-2-one, and 2-ethoxycarbonyloxyimino-1-phenylpropan-1-one.

Examples of the oxime compound include the compounds disclosed in J. C. S. Perkin II (1979) pp. 1653-1660, J. C. S. Perkin II (1979) pp. 156-162, Journal of Photopolymer Science and Technology (1995) pp. 202-232, JP-ANos. 2000-66385 and 2000-80068, Japanese Patent Application National Publication (Laid-Open) No. 2004-534797, and JP-A No. 2006-342166.

As a commercially available product, IRGACURE OXE-01. (trade name, manufactured by BASF Japan) and IRGACURE OXE-02 (trade name, manufactured by BASF Japan) are also suitably used.

Further, other than the oxime compounds described above, the compounds disclosed in Japanese Patent Application National Publication (Laid-Open) No. 2009-519904, in which an oxime is bonded to the carbazole N-position, the compounds disclosed in U.S. Patent No. 7626957, in which a hetero substituent group is introduced to a benzophenone part, the compounds disclosed in JP-A No. 2010-15025 and U.S. Patent Application Laid-Open No. 2009-292039, in which a nitro group is introduced into a pigment part, the ketoxime compounds disclosed in International Publication No. 2009-131189, the compounds disclosed in U.S. Patent No. 7556910, in which a triazine skeleton and an oxime skeleton are contained in the same molecule, and the compounds disclosed in JP-A No. 2009-221114, which have an absorption maximum at 405 nm and exhibit favorable sensitivity with respect to a g-line light source, can also be used.

Preferably, the cyclic oxime compounds disclosed in JP-A No. 2007-231000 and JP-A No. 2007-322744 are also suitably used. Among the cyclic oxime compounds, the cyclic oxime compounds fused with a carbazole pigment disclosed in JP-A No. 2010-32985 and JP-A No. 2010-185072 are preferred, since these compounds exhibit a high light absorbency and are suitable from the viewpoint of increasing sensitivity.

Further, compounds disclosed in JP-A No. 2009-242469, in which an unsaturated bond is included in a specific position of an oxime compound, are also suitably used, since these compounds can increase sensitivity by regenerating activated radicals from polymerization inactive radicals.

Most preferable examples include the oxime compounds having a specific substituent disclosed in JP-A No. 2007-269779 and the oxime compounds having a thioaryl group disclosed in JP-A No. 2009-191061.

Specifically, the compounds represented by the following formula (OX-1) are preferred as an oxime compound. The oxime compound may be an *(E)*-oxime compound, a *(Z)*-oxime compound, or a mixture thereof, in terms of the N-O bond.

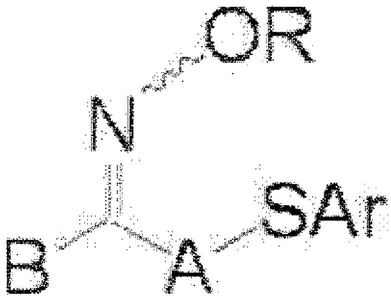

(OX-1)

In formula (OX-1), R and B each independently represent a monovalent substituent, A represents a divalent organic group, and Ar represents an aryl group.

In formula (OX-1), the monovalent substituent represented by R is preferably a monovalent non-metal atomic group.

Examples of the monovalent non-metal atomic group include an alkyl group, an aryl group, an acyl group, an alkoxycarbonyl group, an aryloxycarbonyl group, a heterocyclic group, an alkylthiocarbonyl group, and an arylthiocarbonyl group. These groups may have one or more substituents. Further, the substituent may be substituted with another substituent.

Examples of the substituent include a halogen atom, an aryloxy group, an alkoxycarbonyl group, an aryloxycarbonyl group, an acyloxy group, an acyl group, an alkyl group, and an aryl group.

As the alkyl group which may have a substituent, an alkyl group having 1 to 30 carbon atoms is preferable, and examples thereof include a methyl group, an ethyl group, a propyl group, a butyl group, a hexyl group, an octyl group, a decyl group, a dodecyl group, an octadecyl group, an isopropyl group, an isobutyl group, a sec-butyl group, a t-butyl group, a 1-ethylpentyl group, a cyclopentyl group, a cyclohexyl group, a trifluoromethyl group, a 2-ethylhexyl group, a phenacyl group, a 1-naphthoylmethyl group, a 2-naphthoylmethyl group, a 4-methylsulfanylphenacyl group, a 4-phenylsulfanylphenacyl group, a 4-dimethylaminophenacyl group, a 4-cyanophenacyl group, a 4-methylphenacyl group, a 2-methylphenacyl group, a 3-fluorophenacyl group, a 3-trifluoromethylphenacyl group, and a 3-nitrophenacyl group.

As the aryl group which may have a substituent, an aryl group having 6 to 30 carbon atoms is preferable, and examples thereof include a phenyl group, a biphenyl group, a 1-naphthyl group, a 2-naphthyl group, a 9-anthryl group, a 9-phenanthryl group, a 1-pyrenyl group, a 5-naphthacenyl group, a 1-indenyl group, a 2-azulenyl group, a 9-fluorenyl group, a terphenyl group, a quarter phenyl group, an o-, m-, or p-tolyl group, a xylyl group, an o-, m-, and p-cumenyl group, a mesityl group, a pentalenyl group, a binaphthalenyl group, ternaphthalenyl group, a quarter naphthalenyl group, a heptalenyl group, a biphenylenyl group, an indacenyl group, a fluoranthenyl group, an acenaphthylenyl group, an aceanthrylenyl group, a phenalenyl group, a fluorenyl group, an anthryl group, a bianthracenyl group, a teranthracenyl group, a quarter anthracenyl group, an anthraquinolyl group, a phenanthryl group, a triphenylenyl group, a pyrenyl group, a chrysenyl group, a naphthacenyl group, a pleiadenyl group, a picenyl group, a perylenyl group, a pentaphenyl group, a pentacenyl group, a tetraphenylenyl group, a hexaphenyl group, a hexacenyl group, a rubicenyl group, a coronenyl group, a trinaphthylenyl group, a heptaphenyl group, a heptacenyl group, a pyranthrenyl group, and an ovalenyl group.

As the acyl group which may have a substituent, an acyl group having 2 to 20 carbon atoms is preferable, and examples thereof include an acetyl group, a propanoyl group, a butanoyl group, a trifluoroacetyl group, a pentanoyl group, a benzoyl group, a 1-naphthoyl group, a 2-naphthoyl group, a 4-methylsulfanylbenzoyl group, a 4-phenylsulfanylbenzoyl group, a 4-dimethylaminobenzoyl group, a 4-diethylaminobenzoyl group, a 2-chlorobenzoyl group, a 2-methylbenzoyl group, a 2-methoxybenzoyl group, a 2-butoxybenzoyl group, a 3-chlorobenzoyl group, a 3-trifluoromethylbenzoyl group, a 3-cyanobenzoyl group, a 3-nitrobenzoyl group, a 4-fluorobenzoyl group, a 4-cyanobenzoyl group, and a 4-methoxybenzoyl group.

As the alkoxycarbonyl group which may have a substituent, an alkoxycarbonyl group having 2 to 20 carbon atoms is preferable, and specific examples thereof include a methoxycarbonyl group, an ethoxycarbonyl group, a propoxycarbonyl group, a butoxycarbonyl group, a hexyloxycarbonyl group, an octyloxycarbonyl group, a decyloxycarbonyl group, an octadecyloxycarbonyl group, and a trifluoromethyloxycarbonyl group.

Specific examples of the aryloxycarbonyl group which may have a substituent include a phenoxycarbonyl group, a 1-naphthyloxycarbonyl group, a 2-naphthyloxycarbonyl group, a 4-methylsulfanylphenyloxycarbonyl group, a 4-phenylsulfanylphenyloxycarbonyl group, a 4-dimethylaminophenyloxycarbonyl group, a 4-diethylaminophenyloxycarbonyl group, a 2-chlorophenyloxycarbonyl group, a 2-methylphenyloxycarbonyl group, a 2-methoxyphenyloxycarbonyl group, a 2-butoxyphenyloxycarbonyl group, a 3-chlorophenyloxycarbonyl group, a 3-trifluoromethylphenyloxycarbonyl group, a 3-cyanophenyloxycarbonyl group, a 3-nitrophenyloxycarbonyl group, a 4-fluorophenyloxycarbonyl group, a 4-cyanophenyloxycarbonyl group, and a 4-methoxyphenyloxycarbonyl group.

As the heterocyclic group which may have a substituent, an aromatic or aliphatic heterocycle containing a nitrogen atom, an oxygen atom, a sulfur atom, or a phosphorus atom is preferable, and specific examples thereof include a thienyl group, a benzo[b] thienyl group, a naphth[2,3-b]thienyl group, a thianthrenyl group, a furyl group, a pyranyl group, an isobenzofuranyl group, a chromenyl group, a xanthenyl group, a phenoxathiinyl group, a 2H-pyrrolyl group, a pyrrolyl group, an imidazolyl group, a pyrazolyl group, a pyridyl group, a pyrazinyl group, a pyrimidinyl group, a pyridazinyl group, an indolizinyl group, an isoindolyl group, a 3H-indolyl group, an indolyl group, a 1H-indazolyl group, a purinyl group, a 4H-quinolizinyl group, an isoquinolyl group, a quinolyl group, a phthalazinyl group, a naphthyridinyl group, a quinoxalinyl group, a quinazolinyl group, a cinnolinyl group, a pteridinyl group, a 4aH-carbazolyl group, a carbazolyl group, a β-carbolinyl group, a phenanthridinyl group, an acridinyl group, a perimidinyl group, a phenanthrolinyl group, a phenazinyl group, a phenarsazinyl group, an isothiazolyl group, a phenothiazinyl group, an isoxazolyl group, a furazanyl group, a phenoxazinyl group, an isochromanyl group, a chromanyl group, a pyrrolidinyl group, a pyrrolinyl group, an imidazolidinyl group, an imidazolinyl group, a pyrazolidinyl group, a pyrazolinyl group, a piperidyl group, a piperazinyl group, an indolinyl group, an isoindolinyl group, a quinuclidinyl group, a morpholinyl group, and a thioxanthonyl group.

Specific examples of the alkylthiocarbonyl group which may have a substituent include a methylthiocarbonyl group, a propylthiocarbonyl group, a butylthiocarbonyl group, a hexylthiocarbonyl group, an octylthiocarbonyl group, a decylthiocarbonyl group, an octadecylthiocarbonyl group, and a trifluoromethyl thiocarbonyl group.

Specific examples of the arylthiocarbonyl group which may have a substituent include a 1-naphthylthiocarbonyl group, a 2-naphthylthiocarbonyl group, a 4-methylsulfanylphenylthiocarbonyl group, a 4-phenylsulfanylphenylthiocarbonyl group, a 4-dimethylaminophenylthiocarbonyl group, a 4-diethylaminophenylthiocarbonyl group, a 2-chlorophenylthiocarbonyl group, a 2-methylphenylthiocarbonyl group, a 2-methoxyphenylthiocarbonyl group, a 2-butoxyphenylthiocarbonyl group, a 3-chlorophenylthiocarbonyl group, a 3-trifluoromethylphenylthiocarbonyl group, a 3-cyanophenylthiocarbonyl group, a 3-nitrophenylthiocarbonyl group, a 4-fluorophenylthiocarbonyl group, a 4-cyanophenylthiocarbonyl group, and a 4-methoxyphenylthiocarbonyl group.

In formula (OX-1), the monovalent substituent represented by B indicates an aryl group, a heterocyclic group, an arylcarbonyl group, or a heterocyclic carbonyl group. These groups may have one or more substituents. Examples of the substituent include the substituents described above. Further, the substituent may be substituted by another substituent.

Among them, the following structures are particularly preferred.

In the following structures, Y, X and n have the same definitions as Y, X and n in formula (OX-2) explained below, and the preferable examples are also the same.

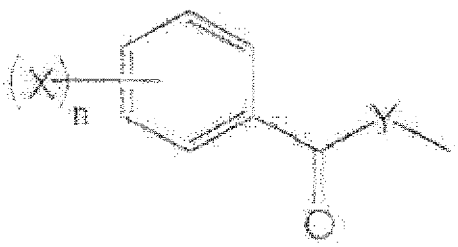

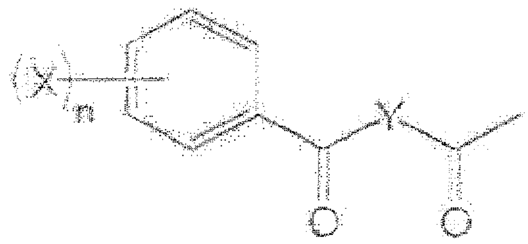

In formula (OX-1), examples of the divalent organic group represented by A include an alkylene group, a cycloalkylene group and an alkynylene group, each having 1 to 12 carbon atoms. These groups may have one or more substituents. Examples of the substituent include the substituents described above. Further, the substituent may be substituted by another substituent.

In particular, in view of increasing sensitivity and suppressing coloration due to heat and time, A in formula (OX-1) is preferably an unsubstituted alkylene group, an alkylene group substituted by an alkyl group (for example, a methyl group, an ethyl group, a tert-butyl group, or a dodecyl group), an alkylene group substituted by an alkenyl group (for example, a vinyl group or an allyl group), or an alkylene group substituted by an aryl group (for example, a phenyl group, a p-tolyl group, a xylyl group, a cumenyl group, a naphthyl group, an anthryl group, a phenanthryl group or a styryl group).

In formula (OX-1), the aryl group represented by Ar is preferably an aryl group having 6 to 30 carbon atoms. The aryl group may be substituted by another substituent. Examples of the substituent include the substituents that are described above as the substituent introduced to the substituted aryl group that are listed above as specific examples of an aryl group which may have a substituent.

In particular, in view of increasing sensitivity and suppressing coloration due to heat and time, a substituted or unsubstituted phenyl group is preferable.

In formula (OX-1), from the viewpoint of sensitivity, the structure represented by "SAr", formed from Ar in formula

(OX-1) and S that is adjacent to Ar, is preferably selected from the following structures. In the following structures, Me represents a methyl group and Et represents an ethyl group.

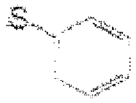
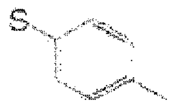
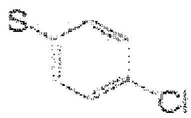
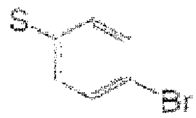
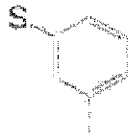
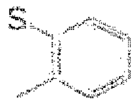
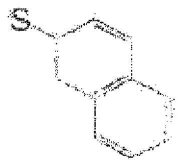
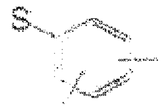
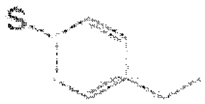
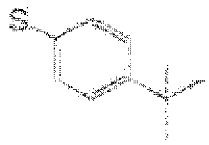
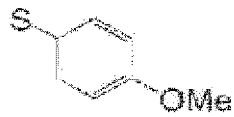
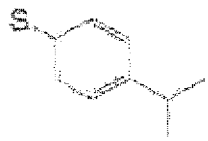
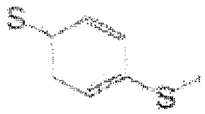
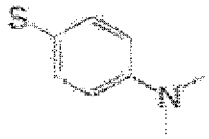
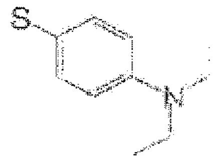
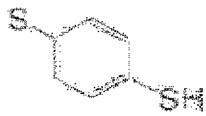
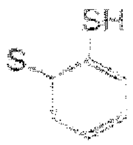
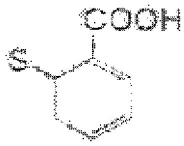
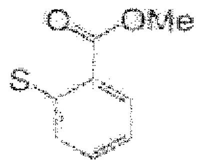
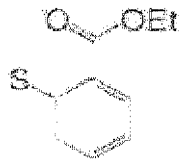
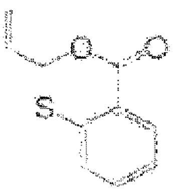

The oxime compound is preferably a compound represented by the following formula (OX-2).

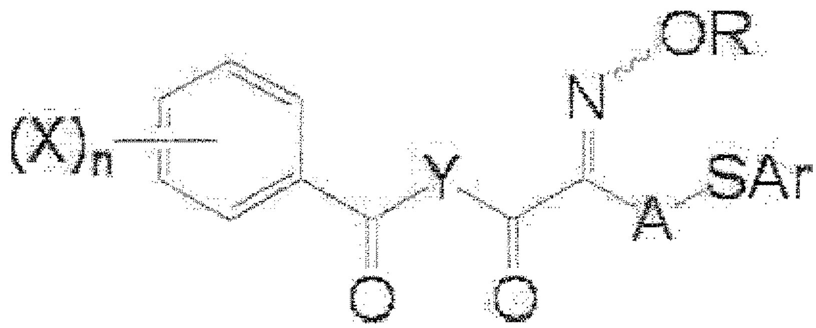

(OX-2)

In formula (OX-2), R and X each independently represent a monovalent substituent, A and Y each independently represent a divalent organic group, Ar represents an aryl group, and n is an integer from 0 to 5.

In formula (OX-2), R, A and Ar have the same definitions as R, A and Ar in formula (OX-1), and preferable examples thereof are also the same.

In formula (OX-2), examples of the monovalent substituent represented by X include an alkyl group, an aryl group, an alkoxy group, an aryloxy group, an acyloxy group, an acyl group, an alkoxycarbonyl group, an amino group, a heterocyclic group, and a halogen atom. These groups may have one or more substituents. Examples of the substituent include the substituents described above. Further, the substituent may be substituted by another substituent.

Among them, from the viewpoint of solubility in a solvent and improvement in absorption efficiency at a long wavelength range, X in formula (OX-2) is preferably an alkyl group.

Further, n in formula (2) represents an integer from 0 to 5, and an integer from 0 to 2 is preferable.

In formula (OX-2), the divalent organic group represented by Y include the following structures. In the structures, * represents a site to be bonded to the carbon atom adjacent to Y in formula (OX-2).

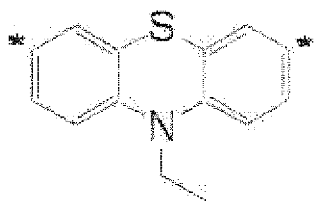
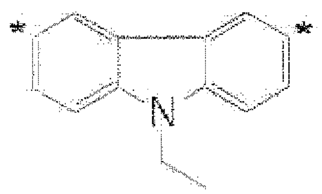
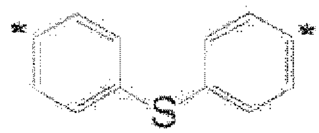
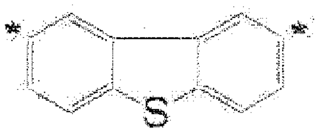
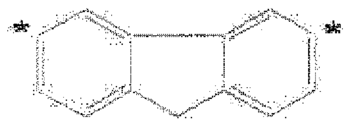
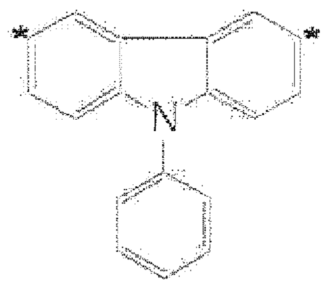
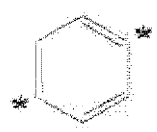
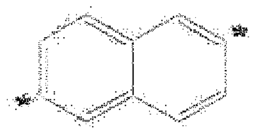
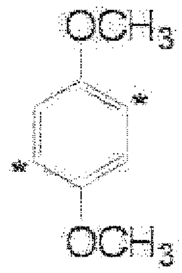
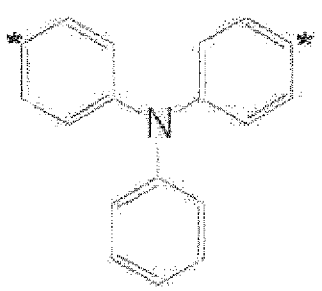
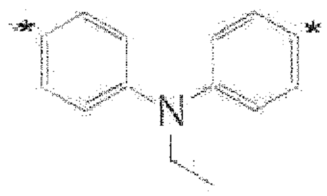

Among them, from the viewpoint of increasing sensitivity, the following structures are preferred.

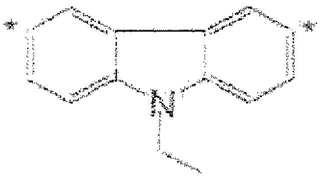

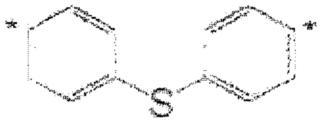

Further, the oxime compound is preferably a compound represented by the following formula (OX-3).

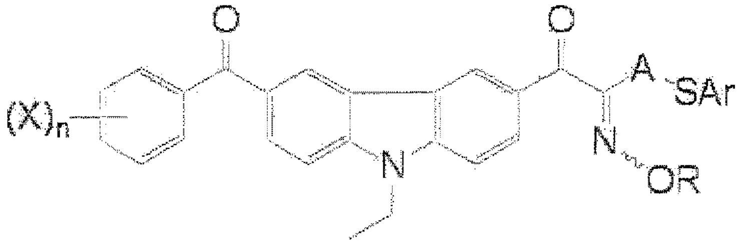

(OX-3)

In formula (OX-3), R and X each independently represent a monovalent substituent, A represents a divalent organic group, Ar represents an aryl group, and n is an integer from 0 to 5.

In formula (OX-3), R, X, A, Ar and n have the same definitions as R, X, A, Ar and n in formula (OX-2), respectively, and preferable examples thereof are also the same.

The following structures (C-4) to (C-15) are specific example of the oxime compound suitably used in the invention. However, the invention is not limited to these examples.

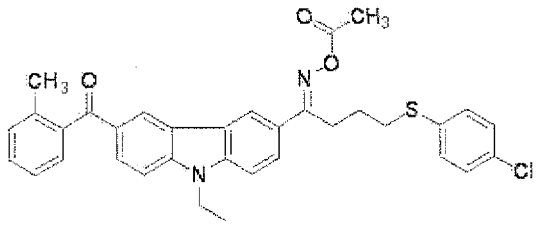

(C-4)

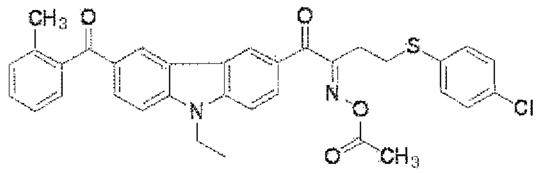

(C-5)

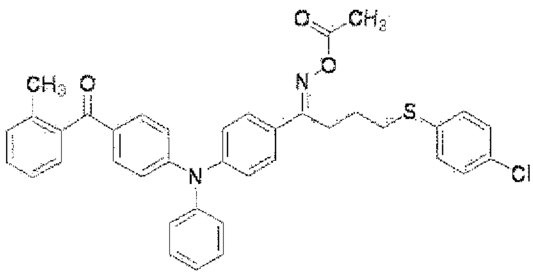

(C-6)

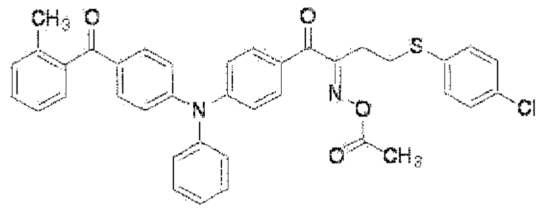

(C-7)

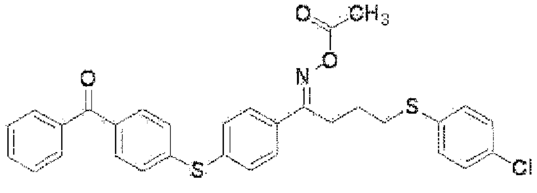

(C-8)

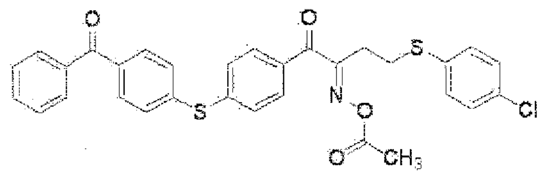

(C-9)

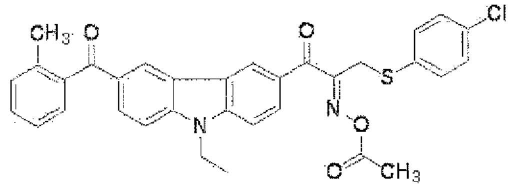

(C-10)

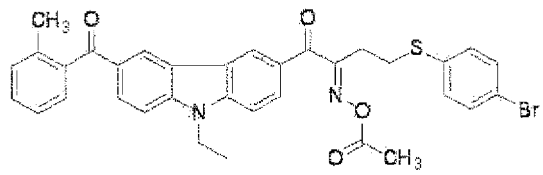

(C-11)

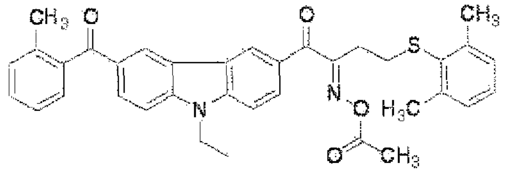

(C-12)

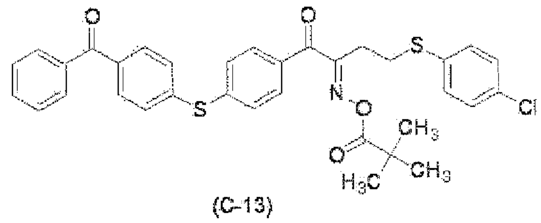

(C-13)

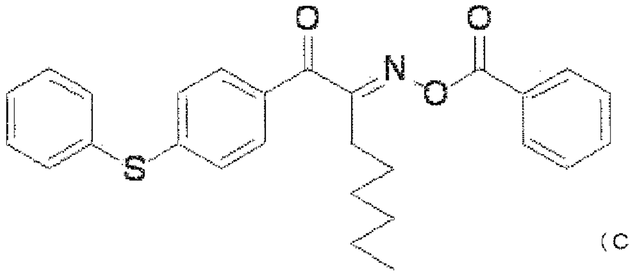

(C－14)

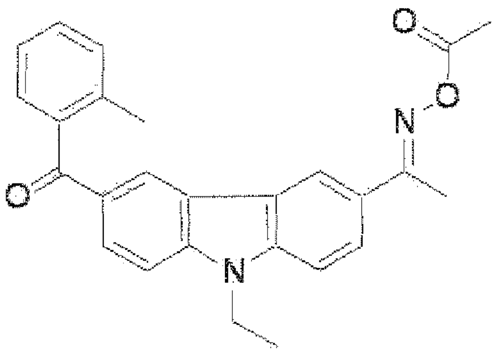

(C－15)

The oxime compound has a maximum absorption wavelength in the wavelength range of from 350 nm to 500 nm, preferably in the wavelength range of 360 nm to 480 nm. The oxime compound having a high absorbance at from 365 nm and 455 nm is particularly preferable.

The molar absorption coefficient of the oxime compound is preferably from 1,000 to 300,000 at 365 nm or 405 nm in view of sensitivity, more preferably from 2,000 to 300,000, most preferably from 5,000 to 200,000.

The molar absorption coefficient of a compound can be measured by a known method. Specifically, for example, the molar absorption coefficient is preferably measured with a UV and visible light spectrophotometer (CARRY5, trade name, manufactured by Varian) with ethyl acetate as a solvent at a concentration of 0.01 g/L.

The polymerization initiator used in the invention may be used alone, or as a combination of two or more kinds thereof, if necessary.

From the viewpoint of exposure sensitivity, the polymerization initiator used in the radiation-sensitive composition of the invention is preferably a compound selected from the group consisting of a trihalomethyl triazine compound, a benzil dimethyl ketal compound, an α-hydroxy ketone compound, an α-amino ketone compound, an acyl phosphine compound, a phosphine oxide compound, a metallocene compound, an oxime compound, a triallylimidazole dimer, an onium compound, a benzothiazole compound, a benzophenone compound, an acetophenone compound and derivatives thereof, a cyclopentadiene-benzene-iron complex and a salt thereof, a halomethyl oxadiazole compound, and a 3-aryl-substituted coumarin compound.

A trihalomethyl triazine compound, an α-amino ketone compound, an acyl phosphine compound, a phosphine oxide compound, an oxime compound, a triallyl imidazole dimer, an onium compound, a benzophenone compound, and an acetophenone compound are more preferable, and at least one compound selected from the group consisting of a trihalomethyl triazine compound, an α-amino ketone compound, an oxime compound, a triallyl imidazole dimer, and a benzophenone compound is most preferable.

In particular, when the radiation-sensitive composition of the invention is used for manufacturing a light blocking film of a solid-state imaging element, it is important that the polymerizable composition be curable and developable without generating residues in an unexposed region, since a fine pattern needs to be formed in a sharp form. From this point of view, an oxime compound is especially preferable to be used as a polymerization initiator. In particular, when a fine pattern is formed in a solid-state imaging element, a stepper is used for carrying out exposure for curing. However, the exposing machine (stepper) tends to be damaged by halogen. Therefore, the amount of the polymerization initiator to be added needs to be low. In consideration of this, it is most preferable to use an oxime compound as the polymerization initiator in the formation of a fine pattern of a solid-state imaging element or the like.

The amount of the polymerization initiator contained in the radiation-sensitive composition of the invention is preferably from 0.1% by mass to 50% by mass, more preferably from 0.5% by mass to 30% by mass, and still more preferably from 1% by mass to 20% by mass, with respect to the total solid content in the radiation-sensitive composition. When the amount falls within these ranges, favorable sensitivity and pattern formability can be obtained.

(F) Other additives

For the radiation-sensitive composition of invention, various additives may be used together with the polymerizable compound and the photopolymerization initiator, according to purposes.

(F-1) Alkali soluble resin

The radiation-sensitive composition of the invention preferably contains (F-1) an alkali soluble resin. By including the alkali soluble resin, developability and pattern formability can be improved.

The alkali soluble resin can be suitably selected from alkali soluble resins that is a linear organic macromolecular polymer and has at least one group that promotes alkali solubility in the molecule (preferably, a molecule whose main chain is an acryl-based copolymer or a styrene-based copolymer). From the viewpoint of heat resistance, a polyhydroxystyrene-based resin, a polysiloxane-based resin, an acryl-based resin, an acrylamide-based resin, and an acryl/acrylamide copolymer resin are preferable. From the viewpoint of controlling developability, an acryl-based resin, an acrylamide-based resin, and an acryl/acrylamide copolymer resin are preferable.

Examples of the group that promotes alkali solubility (hereinbelow, also referred to as an "acid group") include a carboxyl group, a phosphate group, a sulfonic acid group, and a phenolic hydroxyl group, and those soluble in an organic solvent and developable with a weak alkali aqueous solution are preferred. In particular, (meth)acrylic acid is preferable. The acid group may be used alone or as a combination of two or more kinds thereof.

Examples of the monomer capable of introducing an acid group after polymerization include a monomer having a hydroxyl group such as 2-hydroxyethyl (meth)acrylate, a monomer having an epoxy group such as glycidyl (meth)acrylate, and a monomer having an isocyanate group such as 2-isocyanate ethyl (meth)acrylate. The monomer capable of introducing an acid group may be used alone or as a combination of two or more kinds thereof. In order to introduce an acid group into an alkali soluble binder, for example, a monomer having an acid group and/or a monomer capable of imparting an acid group after polymerization (hereinbelow, also referred to as a "monomer for introducing an acid group") may be used as a monomer component for polymerization. Further, when an acid group is introduced by using a monomer capable of providing an acid group after polymerization, a treatment for introduction of an acid group, as described below, is required after the polymerization.

The production of an alkali soluble resin may be carried out by a known radical polymerization method. The polymerization conditions for producing an alkali soluble resin by radical polymerization, i.e., the temperature, the pressure, the type and the amount of a radical initiator, the type of a solvent, etc., can be easily determined by a skilled person in the pertinent art, or can be experimentally determined.

As for the linear organic macromolecular polymer used as an alkali soluble resin, a polymer having carboxylic acid in a side chain is preferable. Examples thereof include a methacrylic acid copolymer, an acrylic acid copolymer, an itaconic acid copolymer, a crotonic acid copolymer, a maleic acid copolymer, a partially esterified maleic acid copolymer, an alkali soluble phenol resin such as novolac resin, an acidic cellulose derivative having carboxylic acid in a side chain, and a polymer having a hydroxyl group to which an acid anhydride has been added. In particular, (meth)acrylic acid and a copolymer of (meth)acrylic acid and a monomer copolymerizable with (meth)acrylic acid are suitable as the alkali soluble resin. Examples of the monomer copolymerizable with (meth)acrylic acid include alkyl (meth)acrylate, aryl (meth)acrylate, and a vinyl compound. Examples of the alkyl (meth)acrylate and the aryl (meth)acrylate include methyl

(meth)acrylate, ethyl (meth)acrylate, propyl (meth)acrylate, butyl (meth)acrylate, isobutyl (meth)acrylate, pentyl (meth)acrylate, hexyl (meth)acrylate, octyl (meth)acrylate, phenyl (meth)acrylate, benzyl (meth)acrylate, tolyl (meth)acrylate, naphthyl (meth)acrylate, and cyclohexyl (meth)acrylate. Examples of the vinyl compound include styrene, α-methylstyrene, vinyltoluene, glycidyl methacrylate, acrylonitrile, vinyl acetate, N-vinylpyrrolidone, tetrahydrofurfuryl methacrylate, a polystyrene macromonomer, a polymethyl methacrylate macromonomer, and N-substituted maleimide monomers described in JP-A No. 10-300922 such as N-phenylmaleimide and N-cyclohexylmaleimide. The monomer copolymerizable with (meth)acrylic acid may be used alone or as a combination of two or more types.

As (A) a polymer component which is an essential component, it is also preferable that the alkali soluble resin contains polymer (a), which is obtained by polymerizing a monomer component that essentially contains a compound represented by formula (ED) (hereinbelow, it may be referred to as an "ether dimer"). By using polymer (a), a cured coating film that exhibits excellent heat resistance and transparency can be produced from the radiation-sensitive composition of the invention.

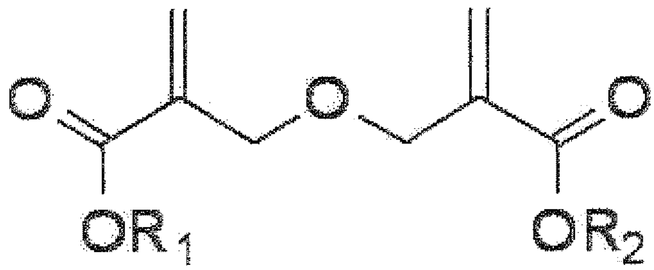

Formula (ED)

In formula (ED), $R^1$ and $R^2$ each independently represent a hydrogen atom or a hydrocarbon group having 1 to 25 carbon atoms which may have a substituent.

In formula (ED), the hydrocarbon group having 1 to 25 carbon atoms which may have a substituent group, represented by $R^1$ and $R^2$, is not specifically limited. However, examples thereof include a linear or branched alkyl group such as methyl, ethyl, n-propyl, isopropyl, n-butyl, isobutyl, t-butyl, t-amyl, stearyl, lauryl, and 2-ethylhexyl; an aryl group such as phenyl; a cycloaliphatic group such as cyclohexyl, t-butylcyclohexyl, dicyclopentadienyl, tricyclodecanyl, isobornyl, adamantyl, and 2-methyl-2-adamantyl; an alkyl group substituted by an alkoxy group such as 1-methoxyethyl and 1-ethoxyethyl; and an alkyl group substituted by an aryl group such as benzyl. Among these, a substituent group having a primary or secondary carbon atom such as methyl, ethyl, cyclohexyl or benzyl, which is difficult to dissociate by acid or heat, is preferable from the viewpoint of heat resistance.

Specific examples of the ether dimer include

dimethyl-2,2'-[oxybis(methylene)]bis-2-propenoate,
diethyl-2,2'-[oxybis(methylene)]bis-2-propenoate,
di(n-propyl)-2,2'-[oxybis(methylene)]bis-2-propenoate,
di(isopropyl)-2,2'-[oxybis(methylene)]bis-2-propenoate,
di(n-butyl)-2,2'-[oxybis(methylene)]bis-2-propenoate,
di(isobutyl)-2,2'-[oxybis(methylene)]bis-2-propenoate,
di(t-butyl)-2,2'-[oxybis(methylene)]bis-2-propenoate,
di(t-amyl)-2.2'-[oxybis(methylene)]bis-2-propenoate,
di(stearyl)-2,2'-[oxybis(methylene)]bis-2-propenoate,
di(lauryl)-2,2'-[oxybis(methylene)]bis-2-propenoate,
di(2-ethylhexyl)-2,2'-[oxybis(methylene)]bis-2-propenoate,
di(1-methoxyethyl)-2,2'-[oxybis(methylene)]bis-2-propenoate,
di(1-ethoxyethyl)-2,2'-[oxybis(methylene)]bis-2-propenoate,
dibenzyl-2,2'-[oxybis(methylene)]bis-2-propenoate,
diphenyl-2,2'-[oxybis(methylene)]bis-2-propenoate,
dicyclohexyl-2,2'-[oxybis(methylene)]bis-2-propenoate,
di(t-butylcyclohexyl)-2,2'-[oxybis(methylene)]bis-2-propenoate,
di(dicyclopentadienyl)-2,2'-[oxybis(methylene)]bis-2-propenoate,
di(tricyclodecanyl)-2,2'-[oxybis(methylene)]bis-2-propenoate,
di(isobornyl)-2,2'-[oxybis(methylene)]bis-2-propenoate,
diadamantyl-2,2'-[oxybis(methylene)]bis-2-propenoate, and

di(2-methyl-2-adamantyl)-2,2'-[oxybis(methylene)]bis-2-propenoate. Of these,
dimethyl-2,2'-[oxybis(methylene)]bis-2-propenoate,
diethyl-2,2'-[oxybis(methylene)]bis-2-propenoate,
dicyclohexyl-2,2'-[oxybis(methylene)]bis-2-propenoate, and
dibenzyl-2,2'-[oxybis(methylene)]bis-2-propenoate are particularly preferable.

The ether dimer can be a single type or two or more types. The structural body derived from the compound represented by formula (ED) may be copolymerized with other monomers.

In order to improve crosslinking efficiency of the radiation-sensitive composition of the invention, an alkali soluble resin having a polymerizable group may be used. As an alkali soluble resin having a polymerizable group, an alkali soluble resin having an allyl group, a (meth)acryloyl group, or an aryloxyalkyl group in a side chain thereof is useful. Examples of the polymer having a polymerizable group include DIANAL NR series (manufactured by MITSUBISHI RAYON CO., LTD.), PHOTOMER 6173 (COOH-containing polyurethane acrylic oligomer, manufactured by Diamond Shamrock Co. Ltd.), VISCOAT R-264, KS RESIST 106 (all manufactured by OSAKA ORGANIC CHEMICAL INDUSTRY LTD.), CYCLOMER P series, PLACCEL CF200 series (all manufactured by DAICEL CHEMICAL INDUSTRIES, LTD.), and EBECRYL 3800 (manufactured by Daicel-UCB Co., Ltd.). Examples of the alkali soluble resin having a polymerizable group include a urethane-modified acrylic resin containing a polymerizable double bond, which is obtained by reacting a compound in which an isocyanate group has been reacted with an OH group in advance, in such a manner that one isocyanate group is left unreacted, and having a (meth)acryloyl group, with an acrylic resin containing a carboxyl group; an acrylic resin containing an unsaturated group, which is obtained by reacting an acrylic resin containing a carboxyl group with a compound having an epoxy group and a polymerizable double bond in the molecule; an acid pendant-type epoxy acrylate resin; an acrylic resin containing a polymerizable double bond, which is obtained by reacting an acrylic resin containing an OH group with a dibasic acid anhydride having a polymerizable double bond; a resin obtained by reacting an acrylic resin containing an OH group with a compound having an isocyanate group and a polymerizable group, and a resin obtained by base treatment of a resin having an ester group in a side chain thereof, wherein the ester group has a leaving group such as a halogen atom and a sulfonate group at the $\alpha$ position or the $\beta$ position as described in JP-A Nos. 2002-229207 and 2003-335814.

As an example of the alkali soluble resin, a benzyl (meth)acrylate/(meth)acrylic acid copolymer or a multi-component copolymer formed of benzyl (meth)acrylate/(meth)acrylic acid/other monomer are preferable. Other examples of the alkali soluble resin include a copolymer including 2-hydroxyethyl methacrylate, a copolymer of 2-hydroxypropyl (meth)acrylate/polystyrene macromonomer/benzyl methacrylate/methacrylic acid, a copolymer of 2-hydroxy-3-phenoxypropylacrylate/polymethyl methacrylate macromonomer/benzyl methacrylate/methacrylic acid, a copolymer of 2-hydroxyethyl methacrylate/polystyrene macromonomer/methyl methacrylate/methacrylic acid, and a copolymer of 2-hydroxyethyl methacrylate/polystyrene macromonomer/benzyl methacrylate/methacrylic acid copolymer, which are described in JP-A No. 7-140654.

Among the alkali soluble resins described above, an alkali soluble resin having a polymerizable group in a side chain is preferable as an alkali soluble resin.

The acid value of the alkali soluble resin is preferably from 10 mgKOH/g to 200 mgKOH/g, more preferably from 10 mgKOH/g to 100 mgKOH/g, and still more preferably from 15 to 80 mgKOH/g.

Further, the weight average molecular weight (Mw) of the alkali soluble resin is preferably from 5,000 to 20,000, more preferably from 8,000 to 18,000, and still more preferably from 10,000 to 15,000.

The content of the alkali soluble resin in the radiation-sensitive composition of the invention is preferably from 0.1% by mass to 40.0% by mass with respect to the total solid content of the composition. From the viewpoint of suppressing exfoliation of a cured film such as a light blocking film and suppressing generation of development residues at the same time, the content of the alkali soluble resin is more preferably from 1.0% by mass to 40.0% by mass, and still more preferably from 5.0% by mass to 30.0% by mass.

(F-2) Colorant

In the radiation-sensitive composition of the invention, (F-2) a colorant other than an inorganic pigment, such as known organic pigments or dyes, can be used in combination in order to exhibit a desired light blocking property.

The colorant which can be used in combination include an organic pigment such as the pigments described in paragraphs [0030] to [0044] of JP-A No. 2008-224982 and pigments such as C. 1. Pigment Green 58 and C. I. Pigment Blue 79 in which a Cl substituent is substituted by OH. The following are preferred examples of (F-2) colorant, but the invention is not limited to these examples.

C. I. Pigment Yellow 11, 24, 108, 109, 110, 138, 139, 150, 151, 154, 167, 180, 185,
C. I. Pigment Orange 36, 38, 62, 64,

C. I. Pigment Red 122, 150, 171, 175, 177, 209 224, 242, 254, 255,
C. I. Pigment Violet 19, 23, 29, 32,
C. I. Pigment Blue 15:1, 15:3, 15:6, 16, 22, 60, 66,
C. I. Pigment Green 7, 36, 37, 58,
C. I. Pigment Black 1

Examples of the dye that can be used as (F-2) colorant are not specifically limited, and a known dye can be appropriately selected and used. Examples thereof include dyes described in JP-A No. 64-90403, JP-ANo. 64-91102, JP-A No. 1-94301, JP-A No. 6-11614, Japanese Patent Registration No. 2592207, U.S. Patent No. 4,808,501, U.S. Patent No. 5,667,920, U.S. Patent No. 5,059,500, JP-A No. 5-333207, JP-A No. 6-35183, JP-A No. 6-51115, JP-A No. 6-194828, JP-A No. 8-211599, JP-A No. 4-249549, JP-A No. 10-123316, JP-A No. 11-302283, JP-A No. 7-286107, JP-A No. 2001-4823, JP-A No. 8-15522, JP-A No. 8-29771, JP-A No. 8-146215, JP-A No. 11-343437, JP-A No. 8-62416, JP-A No. 2002-14220, JP-A No. 2002-14221, JP-A No. 2002-14222, JP-A No. 2002-14223, JP-A No. 8-302224, JP-A No. 8-73758, JP-A No. 8-179120 or JP-A No. 8-151531.
Examples of the chemical structure of the dye include chemical structures such as pyrazolazo structure, anilinoazo structure, triphenyl methane structure, anthraquinone structure, anthrapyridone structure, benzylidene structure, oxonol structure, pyrazolo triazolazo structure, pyridone azo structure, cyanine structure, phenothiazine structure, pyrrolopyrazol azomethine structure, xanthene structure, phthalocyanine structure, benzopyran structure, inidigo structure, and pyromethene structure.
From the viewpoint of obtaining both the curing property and light blocking property when combined with the (A) particles essentially contained in the radiation-sensitive composition of the invention, the (F-2) colorant in the composition of the invention is preferably at least one organic pigment selected from a group consisting of an orange pigment, a red pigment, and a violet pigment. Most preferably, it is a combination with a red pigment.
The orange pigment, red pigment, and violet pigment, which may be used in combination with the particles of the invention, can be suitably selected from various pigments belonging to C. I. Pigment Orange, C. I. Pigment Red and C. I. Pigment Violet that are described above, depending on the desired light blocking property. From the viewpoint of increasing the light blocking property, C. I. Pigment Violet 29, C. I. Pigment Orange 36, 38, 62, 64 and C. I. Pigment Red 177, 254, 255, etc. are preferable.

(F-3) Sensitizer

The radiation-sensitive composition of the invention may contain (F-3) a sensitizer for the purpose of improving radical generation efficiency of (E) photopolymerization initiator, and shifting the sensitive wavelength to a longer wavelength.
The sensitizer that can be used in the invention is preferably a sensitizer capable of sensitizing the photopolymerization initiator via an electron transfer mechanism or an energy transfer mechanism.
Preferred examples of the sensitizer include the compounds that are disclosed in paragraphs [0085] to [0098] of JP-A No. 2008-214395.
The content of the sensitizer is, from the viewpoint of sensitivity and storage stability, preferably within the range of from 0.1% by mass to 30% by mass, more preferably within the range of from 1% by mass to 20% by mass, and still more preferably within the range of from 2% by mass to 15% by mass, with respect to the total solid content in the radiation-sensitive composition.

(F-4) Polymerization Inhibitor

In the radiation-sensitive composition of the invention, in order to prevent unnecessary heat polymerization of the polymerizable compound during the manufacture or the storage of the composition, it is preferable to add a small amount of (F-4) a polymerization inhibitor.
Examples of the polymerization inhibitor that can be used in the invention include hydroquinone, p-methoxyphenol, di-t-butyl-p-cresol, pyrogallol, t-butyl catechol, benzoquinone, 4,4'-thiobis(3-methyl-6-t-butylphenol), 2,2'-methylenebis(4-methyl-6-t-butylphenol) and a N-nitrosophenylhydroxylamine cerium salt. Among them, p-methoxyphenol is preferable.
The addition amount of the polymerization inhibitor is preferably from about 0.01% by mass to about 5% by mass with respect to the total solid content in the radiation-sensitive composition.
If necessary, higher fatty acid derivatives such as behenic acid and behenic acid amide may be added for the purpose of preventing inhibition of the polymerization caused by oxygen. The derivative may be unevenly distributed on the surface of the coating film in the process of drying after the coating. The addition amount of the higher fatty acid derivative with respect to the total composition is preferably from about 0.5% by mass to about 10% by mass.

(F-5) Adhesion promoter

The radiation-sensitive composition of the invention may contain (F-5) an adhesion promoter in order to improve the adhesion with respect to a hard surface of a support etc.
Examples of the adhesion promoter include a silane coupling agent and a titanium coupling agent.
Preferred examples of the silane coupling agent include γ-methacryloxypropyl trimethoxysilane, γ-methacryloxypropyl triethoxysilane, γ-acryloxypropyl trimethoxysilane, γ-acryloxypropyl triethoxysilane, γ-mercaptopropyl trimethoxysilane, γ-aminopropyl triethoxysilane, and phenyl trimethoxysilane. The silane coupling agent is more preferably γ-methacryloxypropyl trimethoxysilane.
The content of the adhesion promoter is preferably from 0.5% by mass to 30% by mass, and more preferably within the range of from 0.7% by mass to 20% by mass, with respect to the total solid content of the radiation-sensitive composition.

(F-6) Surfactant

The radiation-sensitive composition of the invention may contain a surfactant of various kinds, in view of improving coatability. Examples of the surfactant that can be used include a fluorinated surfactant, a nonionic surfactant, a cationic surfactant, an anionic surfactant and a silicone surfactant. Among them, the fluorinated surfactant is preferable.
When the radiation-sensitive composition of the invention includes a fluorinated surfactant, the liquid property (in particular, fluidity) of the composition as a coating liquid can be further improved, thereby improving uniformity in coating thickness and reducing the amount of the coating liquid to be used.
More specifically, when a film is formed from a coating liquid prepared from the radiation-sensitive composition containing a fluorinated surfactant, the interfacial tension between the coating liquid and a surface of a substrate to be coated is lowered, whereby wettability with respect to the substrate and coatability of the composition may be improved. Therefore, a coating layer having an even thickness can be obtained with a smaller amount of the coating liquid even when the thickness of the coating layer is a few micrometers.
The fluorine content of the fluorinated surfactant is preferably from 3% by mass to 40% by mass, more preferably from 5% by mass to 30% by mass, and still more preferably from 7% by mass to 25% by mass. When the fluorine content is within the range, sufficient effects of obtaining a uniform thickness of a coating layer and reducing the amount of the coating liquid can be achieved. In addition, sufficient solubility in the radiation-sensitive composition can be obtained.
Examples of the fluorinated surfactant include MEGAFAC F171, MEGAFAC F172, MEGAFAC F173, MEGAFAC F176, MEGAFAC F177, MEGAFAC F141, MEGAFAC F142, MEGAFAC F143, MEGAFAC F144, MEGAFAC R30, MEGAFACK F437, MEGAFAC F475, MEGAFAC F479, MEGAFAC F482, MEGAFAC F554, MEGAFAC F780, MEGAFAC F781 (trade names, all manufactured by DIC CORPORATION), FLUORAD FC430, FLUORAD FC431, FLUORAD FC171 (trade names, all manufactured by Sumitomo 3M Limited), and SURFLON S-382, SURFLON SC-101, SURFLON SC-103, SURFLON SC-104, SURFLON SC-105, SURFLON SC1068, SURFLON SC-381, SURFLON SC-383, SURFLON S393, SURFLON KH-40 (trade names, all manufactured by ASAHI GLASS CO., LTD.).
Specific examples of the nonionic surfactant include glycerol, trimethylol propane, trimethylol ethane, and ethoxylates and propoxylates thereof (for example, glycerol propoxylate and glycerin ethoxylate), polyoxyethylene lauryl ether, polyoxyethylene stearyl ether, polyoxyethylene oleyl ether, polyoxyethylene octylphenyl ether, polyoxyethylene nonylphenyl ether, polyethylene glycol dilauate, polyethylene glycol distearate, and sorbitan fatty acid esters (trade names: PLURONIC L10, L31, L61, L62, 10R5, 17R2, 25R2, TETRONIC 304, 701, 704, 901, 904, 150R1, all manufactured by BASF Japan).
Specific examples of the cationic surfactant include phthalocyanine derivative EFKA-745 (trade name, manufactured by EFKA Co.), organosiloxane polymer KP341 (manufactured by Shin-Etsu Chemical Co., Ltd.), (meth)acrylic acid (co)polymers POLYFLOW 75, No. 90, and No. 95 (trade names, manufactured by Kyoeisha Chemical Co., Ltd.) and W001 (trade name, manufactured by Yusho Co Ltd.).
Specific examples of the anionic surfactant include W004, W005, and W017 (trade names, manufactured by Yusho Co Ltd.).
Examples of the silicone surfactant include TORAY SILICONE DC3PA, TORAY SILICONE SH7PA, TORAY SILICONE DC11PA, TORAY SILICONE SH21PA, TORAY SILICONE SH28PA, TORAY SILICONE SH29PA, TORAY SILICONE SH30PA, TORAY SILICONE SH8400 (trade names, all manufactured by Dow Corning Toray Co., Ltd.), TSF-4440, TSF-4300, TSF-4445, TSF-4460, TSF-4452 (trade names, all manufactured by Momentive Performance Materials Inc.), KP341, KF6001, KF6002 (trade names, all manufactured by Shin-Etsu Silicone), and BYK307, BYK323, BYK330 (trade names, all manufactured by BYK-Chemie GmbH).
The surfactant may be used singly, or as a combination of two or more kinds thereof.
The addition amount of the surfactant in the radiation-sensitive composition is preferably from 0.001% by mass to 2.0% by mass, and more preferably from 0.005% by mass to 1.0% by mass, with respect to the total mass of the

radiation-sensitive composition.

(F-7) Other additives

In order to further improve sensitivity with respect to actinic rays of the sensitizing dye or the initiator, or in order to suppress inhibition of polymerization of the polymerizable compound caused by oxygen, a known co-sensitizer may be contained in the radiation-sensitive composition. Further, in order to improve physical properties of the cured film, any one of known additives such as a diluting agent, a plasticizer, or a lipophilizer may be added, if necessary.

Method of producing titanium black dispersion composition

The method of producing the titanium black dispersion composition of the invention is not specifically limited. However, the method preferably includes a step of obtaining the particles containing titanium black and Si atoms by a method as previously described, and a step of carrying out a dispersion treatment of a mixture liquid containing the particles containing titanium black and Si atoms, a dispersant and an organic solvent. The dispersion treatment may be carried out by using, for example, a stirrer, a homogenizer, a high-pressure emulsifier, a wet grinder, or a wet disperser.

Further, the dispersion treatment may be performed by two or more dispersion treatments (i.e., multi-step dispersion).

Method of producing black radiation-sensitive composition

The method of producing the black radiation-sensitive composition of the invention is not specifically limited, and one example thereof is a method of mixing the titanium black dispersion composition, (D) a polymerizable compound, (E) a photopolymerization initiator, and various additives that are optionally used in combination.

The black radiation-sensitive composition obtained by the above process may be used after filtrating the same with a filter having a pore size of from 0.01 μm to 3.0 μm, preferably from 0.05 μm to 0.5 μm.

Black cured film and method of producing black cured film

Hereinbelow, the black cured film of the invention and a method of producing the black cured film are explained.

The black cured film of the invention is a black cured film for solid-state imaging elements, and it is obtained by curing the radiation-sensitive composition of the invention.

The black cured film of the invention can be used as a light blocking film, an anti-reflection film, and other types of films of solid-state imaging elements.

The black cured film of the invention can be formed on a silicone substrate of a solid-state imaging element from the black radiation-sensitive composition of the invention.

A solid-state imaging element may be formed in advance on a silicone substrate, or it may be formed after the formation of the black cured film.

Further, color pixels may be formed after the formation of the black cured film, or may be formed before the formation of the black cured film.

The film thickness of the black cured film is not specifically limited. However, from the viewpoint of achieving the effects of the invention more efficiently, the thickness is preferably in the range of from 0.5 μm to 8.0 μm, more preferably in the range of from 1.0 μm to 7.0 μm, and still more preferably in the range of from 2.0 μm to 5.0 μm, in terms of the film thickness after drying.

The size of the black cured film (i.e., the side length) after the pattern formation is preferably in the range of from 10 μm to 400 μm from the viewpoint of achieving the effects of the invention more efficiently, more preferably in the range of from 50 μm to 300 μm, and still more preferably in the range of from 200 μm to 300 μm.

The method of producing the black cured film of the invention preferably includes applying the radiation-sensitive composition of the invention onto a silicone substrate to form a black radiation-sensitive composition layer (hereinbelow, also simply referred to as a "radiation-sensitive composition layer forming process"), exposing the black radiation-sensitive composition layer to light in a patterned manner (hereinbelow, simply referred to as an "exposure process"), and developing the black radiation-sensitive composition layer after exposure to form a pattern (hereinbelow, simply referred to as a "development process").

Hereinbelow, each process of the method of producing the black cured film of the invention is explained.

Black radiation-sensitive composition layer forming process

First, the substrate used in the black radiation-sensitive composition layer forming process is explained.

Examples of the substrate used for a color filter include a photoelectric conversion element substrate for use in solid-state imaging elements etc., such as a silicone substrate and a plastic substrate.
The plastic substrate preferably has a gas barrier layer and/or a solvent-resistant layer on its surface.
In the radiation-sensitive composition layer forming process, the method of applying the radiation-sensitive composition onto the substrate is not specifically limited. However, a method using a slit nozzle, such as a spin coating method, a slit and spin method or a spinless coating method is preferred.
When a coating film is formed on a substrate from the radiation-sensitive composition, the thickness of the coating film (after pre-baking treatment) is preferably in the range of from 0.5 μm to 8.0 μm, more preferably in the range of from 1.0 μm to 7.0 μm, and still more preferably in the range of from 2.0 μm to 5.0 μm, in the case of a light blocking film for solid-state imaging elements.
In the radiation-sensitive composition layer forming process, the pre-baking treatment is generally carried out after the coating process. If necessary, the radiation-sensitive composition layer may be subjected to a vacuum treatment before carrying out the pre-baking treatment.
The vacuum drying is typically performed at a vacuum level of from 0.1 torr to 1.0 torr, and preferably from 0.2 torr to 0.5 torr.
The pre-baking treatment may be carried out with a hot plate or an oven etc., at a temperature range of from 50°C to 140°C, and preferably from 70°C to 110°C, for a time period of from 10 seconds to 300 seconds. A high frequency treatment may be carried out in combination with the pre-baking treatment. It is also possible to carry out the high frequency treatment alone.

Exposure process

In the exposure process, the radiation-sensitive composition layer formed by the radiation-sensitive composition layer forming process is cured by exposing the same to light through a mask pattern. The radiation ray used for the exposure is preferably ultraviolet ray such as g line, h line, i line, or j line.
In particular, in the case of producing a light blocking film for solid-state imaging elements, the exposure is preferably carried out with a stepper and i-line ray.

Development process

In the development process, the non-exposed area (i.e., uncured area) of the radiation-sensitive composition layer after the light exposure is dissolved in a developer, whereby only cured portions remain on a substrate after the development. The developing temperature is generally from 20°C to 30°C and the developing time is generally from 20 seconds to 90 seconds. The developer is not particularly limited as long as it can dissolve the uncured portions of the coating film of the radiation-sensitive composition while not dissolving the cured portions, and for example, a combination of various kinds of organic solvents or an aqueous alkali solution may be used.
Examples of the organic solvent used for development include (C) an organic solvent that can be used for producing the radiation-sensitive composition of the invention, as described above.
Examples of the aqueous alkali solution include an aqueous alkali solution obtained by dissolving an alkali compound in water at a concentration of from 0.001 % by mass to 10% by mass, preferably from 0.01% by mass to 1% by mass, the alkali compound being selected from, for example, sodium hydroxide, potassium hydroxide, sodium carbonate, sodium hydrogen carbonate, sodium silicate, sodium metasilicate, ammonia water, ethylamine, diethylamine, dimethyl ethanolamine, tetramethyl ammonium hydroxide, tetraethyl ammonium hydroxide, choline, pyrrole, piperidine, and 1,8-diazabicyclo[5.4.0]-7-undecene.
The developer is preferably an aqueous solution of an organic alkali, and an appropriate amount of a water soluble organic solvent such as methanol or ethanol or a surfactant may be added thereto, for example.
The development may be carried out by any one of a paddle mode, a dip mode, a shower mode or a spray mode, and a swing mode, a spin mode, an ultrasonic mode or the like may be combined therewith. It is also advantageous to wet a surface to be developed with water or the like before contacting the developer, in order to prevent causing unevenness in development. Further, the development may be carried out while tilting the substrate.

Post-curing process

After the process of forming a pattern by development, it is desirable to carry out a post-curing process for further curing the obtained pattern. The post-curing process is carried out by heating and/or exposing to light (UV irradiation). By further curing the formed pattern, dissolution of the pattern during formation thereof can be suppressed, and the solvent resistance of the pixels formed in a patterned manner in the light blocking film can be improved. The post-curing process is preferably carried out by UV irradiation.

The post-curing process by heating (post-heating, post-baking) is carried out after carrying out a rinse treatment in which the remaining developer is removed, and then drying the obtained pattern. The rinse treatment is generally carried out with pure water. However, the rinse treatment may be carried out by using water that has been used at an initial stage of the washing and using pure water only at the last stage of the washing, in order to save the amount of water to be used; by carrying out washing while tilting the substrate; or by carrying out in combination with ultrasonication.
After carrying out rinsing, dehydrating and drying, the heating treatment is carried out generally at the temperature of about 200°C to about 250°C. The heating treatment (post-baking) may be carried out in a continuous manner or in a batch manner by using a heating means such as a hot plate, a convection oven (hot air circulation dryer), a high frequency heater or the like, such that the coating film after the development may satisfy the conditions as described above. The heating time is preferably from 30 seconds to 30000 seconds, more preferably from 60 seconds to 1000 seconds.
The post-curing process (i.e., UV irradiation process) by light exposure (i.e., post-exposure) can be carried out by using g line, h line, i line, KrF, ArF, UV ray, electron beam or X ray, etc. However, g line, h line, i line, and UV ray are preferable. UV ray is particularly preferable. It is preferable that the pattern obtained after the development process is exposed to UV ray at an irradiation amount of at least ten times as much as the amount of the exposure carried out in the exposure process. The irradiation amount of UV ray is preferably from 12 times to 200 times, more preferably from 15 times to 100 times, as much as the exposure amount during the exposure process. The light source may be selected from a high pressure mercury lamp and a low pressure mercury lamp, etc.
During the post-curing process, the post-exposure and the post-heating may be carried out in combination. In that case, either the post-exposure or the post-heating may be carried out first. However, it is preferred to carry out the post exposure prior to the post-heating. This is because the curing can be promoted by the post-exposure, thereby suppressing the shape deformation due to heat sagging, drooping or footing of the pattern, which may occur during the post-heating.
Through the processes as mentioned above, colored pixels for color separation are formed on a silicone substrate having a light blocking film, and are used as a solid-state imaging element. The colored pixels consisting of plural colors can be produced by repeating the pattern forming process (and, optionally, the post-curing process, as needed) by the number of times corresponding to the number of colors to be used for the colored pixels, and a color filter for color separation consisting of a desired number of color hues can be produced.

<Solid-state imaging element>

The solid-state imaging element of the invention includes the black cured film as described above.
The solid-state imaging element of the invention may include for example, a light blocking film (black matrix) consisting of the black cured film of the invention as described above, and if necessary, a patterned color filter formed of pixels of other colors (e.g., three or four colors).
Since the solid-state imaging element of the invention exhibits suppressed reduction in the light blocking performance in the peripheral area, the amount of residues in the formed pattern can be reduced, and favorable linearity of the pattern can be achieved, noise can be reduced and color reproducibility can be improved.
The constitution of the solid-state imaging element of the invention is not particularly limited as long as it has the black cured film such as a light blocking film (for example, a black matrix) as described above, and functions as a solid-state imaging element. Examples thereof include a constitution in which a light-receiving element including plural photodiodes, polysilicone or the like that form a light-receiving area of a solid-state imaging element (e.g., CCD image sensor, CMOS image sensor or the like) is arranged on a substrate, and the black matrix of the invention is formed on the surface opposite to the side of the substrate on which the light receiving element is formed.

EXAMPLES

Hereinbelow, the invention is explained in detail with reference to the Examples, but the invention is not limited to these Examples, as long as it does not depart from the idea of the invention. In addition, unless otherwise specified, the term "part(s)" is based on mass. The room temperature corresponds to 25°C.

(Preparation of titanium black)

100 g of titanium oxide MT-150A (trade name, manufactured by TAYCA CORPORATION) with a particle diameter of 15 nm, 25 g of silica particles AEROPERL (registered trademark) 300/30 (manufactured by Evonik Co., Ltd.) with a BET surface area of 300 $m^2/g$, and 100 g of DISPERBYK190 (trade name, manufactured by BYK-Chemie GmbH) were weighed, added with 71 g of ion exchange water, and processed with MAZERSTAR KK-400W (trade name, manufactured by KURABO) at a revolution number of 1360 rpm and a rotation number of 1047 rpm for 20 minutes,

thereby yielding a homogenous aqueous mixture solution. A quartz container was filled with the aqueous solution and heated at 920°C under an oxygen atmosphere by using a small rotary kiln (manufactured by Motoyama Inc.). Thereafter, nitrogen reduction was carried out by purging with nitrogen, and an ammonia gas was allowed to flow at the same temperature for 5 hours at a rate of 100 mL/min. After the completion of the reaction, a powder was collected and ground with a mortar and a pestle, thereby obtaining a powder of titanium black A having a specific surface area of 73 $m^2/g$ (i.e., dispersed material).

Powders of titanium black B, titanium black C, titanium black X and titanium black Y were obtained in the same manner as the above, while changing the amount of silica particles AEROPERL to 12.5 g, 10 g, 5 g and 30 g, respectively.

(Synthesis of dispersant 1)

To a 3-neck 500 mL flask, 600.0 g of ε-caprolactone and 22.8 g of 2-ethyl-1-hexanol were added and dissolved under stirring while introducing a nitrogen gas. 0.1 g of monobutyl tin oxide were added thereto and heated to 100°C. Eight hours later, loss of the starting materials was confirmed by gas chromatography, and the mixture was cooled to 80°C. 0.1 g of 2,6-di-t-butyl-4-methylphenol were added, and then 27.2 g of 2-methacryloyloxy ethyl isocyanate were added. Five hours later, loss of the starting materials was confirmed by 1H-NMR, and cooled to room temperature. 200 g of a solid precursor M1 (represented by the following structure) were obtained. The compound was identified by 1H-NMR, IR, and mass analysis.

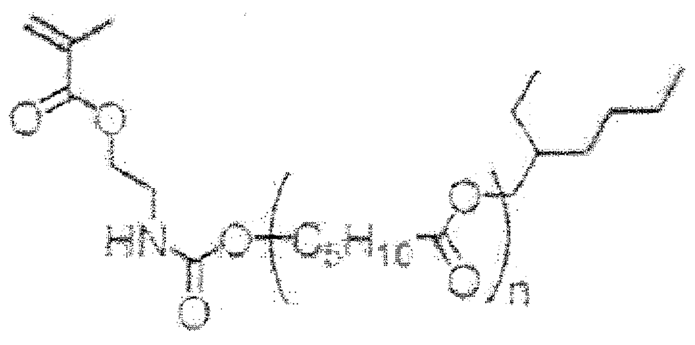

M1

To a 3-neck 500 mL flask purged with nitrogen, 30.0 g of precursor M1, 70.0 g of NK ESTER CB-1 (trade name, 2-methacryloyloxy ethyl phthalic acid, manufactured by Shin-Nakamura Chemical Co., Ltd.), 2.3 g of dodecyl mercaptan, and 233.3 g of propylene glycol monomethyl ether acetate were added and stirred with a stirrer (trade name: THREE-ONE MOTOR, manufactured by Shinto Scientific Co., Ltd.). The temperature was increased to 75°C by heating while purging the flask with nitrogen. To the mixture, 0.2 g of dimethyl 2,2-azobis(2-methylpropionate) (trade name: V-601, manufactured by Wako Pure Chemical Industries, Ltd.) were added and heated for 2 hours at 75°C under stirring. Two hours later, 0.2 g of V-601 were further added. After heating and stirring for 3 hours, a solution (30% by mass) of the following dispersant 1 was obtained.

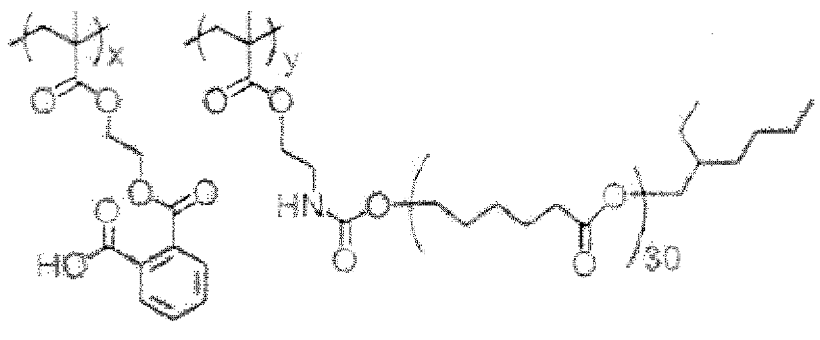

Dispersant 1

The composition ratio, the acid value, and the weight average molecular weight (Mw) of the dispersant I are

shown below. The weight average molecular weight is a value in terms of polystyrene equivalents measured by gel permeation chromatography (GPC). The GPC was carried out using HLC-8020GPC (trade name, manufactured by Tosoh Corporation) with columns (TSKGEL SUPER HZM-H, TSKGEL SUPER HZ4000 and TSKGEL SUPER HZ200, all trade names, manufactured by Tosoh Corporation company).

- Composition ratio: x = 35 (% by mass), y = 65 (% by mass)
- Acid value: 80 mgKOH/g
- Mw: 30,000

(Synthesis of dispersant 2)

To a 3-neck 1000 mL flask, 210 g of I -methoxy-2-propanol were added and heated to 85°C under a nitrogen stream. Then, a solution prepared by adding 63.4 g of benzyl methacrylate, 64.7 g of isobutyl methacrylate, 29.0 g of methacrylic acid, 24.0 g of BLEMMER PME-400 (trade name, manufactured by NOF CORPORATION, methoxypolyethylene glycol monomethacrylate), and 4.15 g of V-601 (manufactured by Wako Pure Chemical Industries, Ltd.) to 212 g of 1-methoxy-2-propanol was added dropwise over 2 hours. After the completion of the dropwise addition, the reaction was allowed to continue by heating for 5 hours.

Subsequently, the heating was stopped and a solution containing a quadri-copolymer having the following structure and the monomer ratio (i.e., dispersant 2) was obtained. The solid content concentration of dispersant 2 was 30% by mass, the weight average molecular was 11000, and the acid value was 43.0 mgKOH/g.

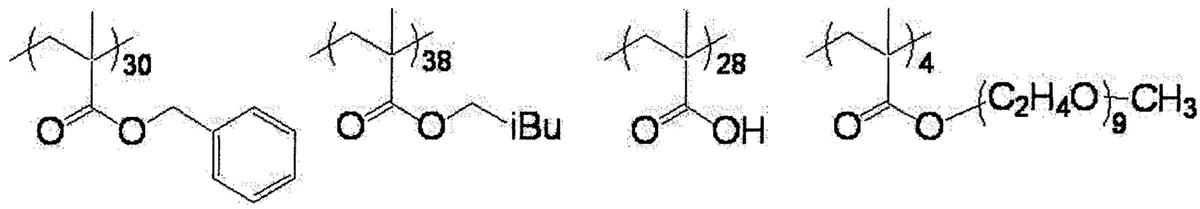

Dispersant 2

Reference Examples 1 to 4 and Comparative Examples 1 to 3

1. Preparation of titanium black dispersion composition

<Preparation of titanium black dispersion composition A>

The following components for Composition 1 were mixed for 15 minutes with a stirrer (trade name: EUROSTAR, manufactured by IKA) to obtain the dispersion a.

(Composition 1)

| | |
|---|---|
| • (A) Particles: titanium black A prepared above | 25 parts |
| • (B) Dispersant: 30% by mass solution of dispersant 1 prepared above | 25 parts |
| • (C) Organic solvent: propylene glycol monomethyl ether acetate | 50 parts |

Dispersion a, obtained by the above process, was subjected to a dispersion treatment by using ULTRA APEX MILL UAM015 (trade name, manufactured by KOTOBUKI INDUSTRIES CO., LTD.) under the following conditions, thereby obtaining titanium black dispersion composition A of Reference Example 1.

(Conditions for dispersion)

- Bead diameter: φ 0.05 mm

- Bead filling ratio: 75% by volume
- Mill speed: 8 m/sec
- Amount of mixture liquid for dispersion treatment: 500 g
- Circulating flow amount (pump supply amount): 13 kg/hour
- Liquid temperature: 25 to 30°C
- Cooling water: tap water
- Volume of circular path in bead mill: 0.15 L
- Number of passes: 90 passes

<Preparation of titanium black dispersion compositions B, C, X, Y, and Z>

Titanium black dispersion compositions B, C, X, Y and Z of Reference Examples 2 and 3 and Comparative Examples 1 to 3 were obtained in the same manner as titanium black dispersion composition A prepared in Reference Example 1, except that titanium black A was changed to titanium black B, C, X, Y, or titanium black 13M-T (trade name, manufactured by Mitsubishi Materials Corporation), respectively.

<Preparation of titanium black dispersion composition H>

Titanium black dispersion composition H was obtained in the same manner as titanium black dispersion composition B prepared in Reference Example 2, except that the 30% by mass solution of dispersant 1 was changed to a 30% by mass solution of dispersant 2.

-Evaluation of titanium black dispersion composition-

The Si/Ti ratio and the particle diameter of the particles contained in the titanium black compositions obtained in the above processes were measured and evaluated.

<Si/Ti ratio>

A test sample collected from each of titanium black dispersion compositions A, B, C, H, X, Y and Z was placed on a commercially available quartz boat, and heated at 500°C in an electric furnace for 60 min under an oxygen flow at 100 mL/min. The atomic mass of Si and the atomic mass of Ti of a powder obtained by the heat treatment were measured with S-4800 (trade name, manufactured by Hitachi Technologies Corporation) and INCA ENERGY PENTAFET-X3 (manufactured by Oxford), and the Si/Ti ratio was calculated. The results are shown in Table 1.

<Particle diameter of the particles >

Titanium black dispersion compositions A, B, C, H, X, Y and Z were diluted 100 times with propylene glycol monomethyl ether acetate, and the resultant was dropped on a carbon foil and dried. The average particle diameter of the particles and the ratio (%) of the particles having a particle diameter of 20 nm or less were evaluated from the observation carried out with a TEM. For the evaluation, the particle diameter was converted into a circle, and the number of samples was 400.

As a result, the average particle diameters of the particles contained in titanium black dispersion compositions A, B, C, H, X, Y and Z were 20 nm, 21 nm, 21 nm, 21 nm, 32 nm, 15 nm and 75 nm, respectively.

Further, the results of the ratio (%) of the particles having a particle diameter of 20 nm or less are as shown in Table 1.

<Evaluation of stability over time >

100 g of the test sample collected from each of titanium black dispersion compositions A, B, C, X, Y and Z was added to a glass bottle. After storing the same at room temperature for four months, 5 g of a supernatant were collected. The collected liquid was applied onto a glass wafer with a spin coater, and the absorbance at a wavelength of 500 nm (OD1) was measured with a spectrophotometer (UV-3600, trade name, manufactured by Shimadzu Corp.)

The absorbance at a wavelength of 500 nm (OD0) of the titanium black dispersion composition before the storage was also measured in the same manner as the absorbance of the composition after the storage.

The ratio of the absorbance after the storage with respect to the absorbance after the storage was calculated according to the following equation, and the stability over time was evaluated.

$$\text{Stability over time (\%)} = (\text{absorbance OD0 at wavelength of 500 nm after storage/ absorbance OD1 at wavelength of 500 nm before storage}) \times 100$$

[Table 1]

| | Titanium black dispersion composition | Particle diameter | Ratio of particles being 20 nm or less | Si/Ti ratio | Stability over time |
|---|---|---|---|---|---|
| Ref. Example 1 | A | 20 nm | 98% | 0.27 | 5% |
| Ref. Example 2 | B | 21 nm | 96% | 0.41 | 3% |
| Ref. Example 3 | C | 21 nm | 95% | 0.20 | 4% |
| Ref. Example 4 | H | 21 nm | 96% | 0.41 | 7% |
| Comparative Example 1 | X | 32 nm | 88% | 0.18 | 23% |
| Comparative Example 2 | Y | 15 nm | 97% | 0.35 | 2% |
| Comparative Example 3 | Z | 75 nm | 70% | 0 | 60% |

As shown in Table 1, titanium black dispersion composition A, B, C and H of the Reference Examples exhibit excellent stability over time as compared with titanium black dispersion compositions X and Z of the Comparative Examples.

2. Preparation of black radiation-sensitive composition

(Preparation of binder solution 1)

To a 3-neck 1000 mL flask, 159 g of 1-methoxy-2-propanol were added and heated to 85°C under a nitrogen stream. Then, a solution prepared by adding 63.4 g of benzyl methacrylate, 72.3 g of methacrylic acid and 4.15 g of V-601 (manufactured by Wako Pure Chemical Industries, Ltd.) to 159 g of 1-methoxy-2-propanol was added dropwise over 2 hours. After the completion of the dropwise addition, the reaction was allowed to continue by heating for 5 hours.

Subsequently, the heating was stopped and a solution containing a copolymer of benzyl methacrylate/methacrylic acid (30/70 molar ratio) was obtained.

Next, 120.0 g of the copolymer solution obtained were transferred to a 3-neck 300 mL flask, added with 16.6 g of glycidyl methacrylate and 0.16 g of p-methoxyphenol, and dissolved under stirring. After dissolving the components, 3.0 g of triphenylphosphine were added and heated at 100°C to cause addition reaction. Loss of glycidyl methacrylate was confirmed by gas chromatography, and then the heating was stopped. To the reaction liquid, 184 g of 1-methoxy-2-propanol were added, thereby preparing binder solution 1 having a weight average molecular weight of 12,000 (measured by GPC and calculated in polystyrene equivalent), an acid value of 35 mgKOH/g, and a solid content concentration of 30% by mass.

(Preparation of binder solution 2)

CYCLOMER P ACA230A (trade name, manufactured by DAICEL CHEMICAL INDUSTRIES, LTD., solid content: 55%, weight average molecular weight: 14000, acid value: 20 mgKOH/g) was added with 1-methoxy-2-propanol to prepare binder solution 2 with solid matter content of 30% by mass.

(Preparation of black radiation-sensitive composition A)

The following components for Composition 2 were mixed with a stirrer, thereby preparing black radiation-sensitive composition A of Reference Example 1.

(Composition 2)

| | |
|---|---|
| • Titanium black dispersion composition A | 50 parts |
| • (F-1) Alkali soluble resin: binder solution 1 | 17.0 parts |
| • (D) Photopolymerizable compound: KAYARAD DPHA (dipentaerythritol hexaacrylate, manufactured by Nippon Kayaku Co., Ltd.) | 5.0 parts |
| • (E) Photopolymerization initiator: IRGACURE OXE02 (manufactured by BASF, having the following structure) | 2.5 parts |

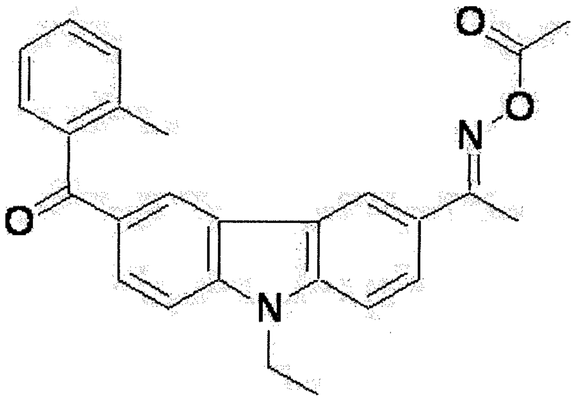

| | |
|---|---|
| • (F-4) Polymerization inhibitor: p-methoxyphenol | 0.003 parts |
| • (F-6) Surfactant: MEGAFAC F781 (fluorinated surfactant, manufactured by DIC CORPORATION) | 0.01 parts |
| • (C) Organic solvent: propylene glycol monomethyl ether acetate | 10 parts |
| • (C) Organic solvent: cyclohexanone | 10 parts |

(Preparation of black radiation-sensitive composition B, C, H, X, Y and Z)

Titanium black dispersion compositions B, C, H, X, Y and Z of Reference Examples 2 to 4 and Comparative Examples 1 to 3 were prepared in the same manner as black radiation-sensitive composition A, except that titanium black dispersion A was is changed to titanium black dispersion B, C, H, X, Y or Z.

-Evaluation of black radiation-sensitive composition-

The Si/Ti ratio, the particle diameter, and the stability over time of the particles contained in the black radiation-sensitive compositions obtained above were evaluated.

<Si/Ti ratio>

A test sample collected from each of the black radiation-sensitive compositions A, B, C, H, X, Y and Z was placed on a commercially available quartz boat, and heated at 500°C in an electric furnace for 60 min under an oxygen flow at 100 mL/min. The Si atom weight and the Ti atom weight of a powder obtained by the heat treatment were determined with S-4800 (trade name, manufactured by Hitachi Technologies Corporation) and INCA ENERGY PENTAFET-X3 (manufactured by Oxford), and the Si/Ti ratio was calculated.

As a result, it was found that the Si/Ti ratio in the particles of each black radiation-sensitive composition was the same as the Si/Ti ratio in the particles contained in the titanium black dispersion compositions A, B, C, H, X, Y and Z, respectively.

The results are shown in Table 2.

<Particle diameter of particles>

The black radiation-sensitive compositions A, B, C, H, X, Y, and Z were diluted 100 times with propylene glycol monomethyl ether acetate, respectively, and the resultant was dropped on a carbon foil and dried. The average particle diameter of the particles was measured with a TEM.

As a result, it was found that the average particle diameter of the particles contained in each black radiation-sensitive composition was the same as the particle diameter of the particles of titanium black dispersion compositions A, B, C, H, X, Y and Z, respectively.

The results are shown in Table 2.

<Evaluation of stability over time>

100 g of a test sample collected from each of black radiation-sensitive compositions A, B, C, X, Y and Z were added to a glass bottle. After storing the same at room temperature for four months, 5 g of a supernatant were collected. The collected liquid was applied onto a glass wafer with a spin coater, and an absorbance at a wavelength of 500 nm (OD1) was measured with a spectrophotometer (UV-3600, trade name, manufactured by Shimadzu Corp.).

An absorbance at a wavelength of 500 nm (OD0) of the black radiation-sensitive composition before the storage was also measured in the same manner as the absorbance of the composition after the storage.

The ratio of the absorbance after the storage with respect to the absorbance before the storage was calculated according to the following equation, and stability over time was evaluated.

$$\text{Stability over time (\%)} = (\text{absorbance OD0 at wavelength of 500 nm after storage/ absorbance OD1 at wavelength of 500 nm before storage}) \times 100$$

The results are shown in Table 2.

3. Formation of light blocking film (black cured film)

Each of black radiation-sensitive compositions A, B, C, X, Y and Z, obtained above, was applied to a silicone wafer as a substrate by spin coating, and heated on a hot plate at 120°C for 2 minutes, thereby forming a black radiation-sensitive composition coating layer. Subsequently, the coating layer was exposed to light through a photo mask with a line and space pattern of 10 μm/10 μm at an exposure amount of 100 mJ/cm$^2$, using an i-line stepper, while changing the exposure amount from 100 mJ/cm$^2$-by an amount of 100 mJ/cm$^2$. The coating film after the light exposure was subjected to paddle development using with a 0.3% aqueous tetramethylammonium hydroxide solution at 23°C for 60 seconds. Thereafter, the resultant was rinsed with a spin shower and pure water, and further washed with pure water, thereby obtaining a light blocking film with a pattern shape of Reference Examples 1 to 3 and Comparative Examples 1 to 3.

-Evaluation of light blocking film-

The Si/Ti ratio, the particle diameter, and the residue of the particles included in the light blocking film (cured film) with a pattern shape, obtained above, was evaluated.

<Si/Ti ratio>

A substrate with a light blocking film formed thereon was splitted to generate a cross-section of a light blocking film.

The atomic mass of Si and the atomic mass of Ti were measured by observing the cross-section with S-4800 (trade name, manufactured by Hitachi High-Technologies Corporation) and INCA ENERGY PENTAFET-X3 (manufactured by Oxford), and the Si/Ti ratio was calculated.

As a result, it was found that the Si/Ti ratio in the particles contained in each light blocking film was the same as the Si/Ti ratio in the particles of titanium black dispersion compositions A, B, C, X, Y and Z (i.e., the results given in Table 1), respectively.

<Particle diameter of the particles>

A test sample was scraped off from each light blocking film with a spatula, and the test sample was placed on

a commercially available quartz boat and heated at 500°C in an electric furnace for 60 min under an oxygen flow at 100 mL/min. A powder obtained after the heat treatment was diluted 100 times with propylene glycol monomethyl ether acetate, and the solution was then dropped on a carbon foil and dried. The resultant was observed with a TEM, and the average particle diameter of the dispersed material was measured.

As a result, it was found that the average particle diameter of the particles contained in each light blocking film was the same as the average particle diameter of the particles in the titanium black dispersion compositions A, B, C, X, Y and Z (i.e., results given in the Table 1), respectively.

<Evaluation of residues>

The developed portions of the light blocking film with a pattern shape were observed with a scanning electron microscope (trade name: S-4800, manufactured by Hitachi Technologies Corporation), and the presence or the absence of development residues on the substrate was evaluated.

When no residues having the size of 10 nm or larger were shown on the substrate, it was determined that the film was favorable as a light blocking film. The results are given in Table 2.

[Table 2]

| | Radiation-sensitive composition | Particle diameter | Ratio of particles being 20 nm or less | Si/Ti ratio | Stability over time | Residues |
|---|---|---|---|---|---|---|
| Ref. Example 1 | A | 20 nm | 98% | 0.27 | 5% | Favorable |
| Ref. Example 2 | B | 21 nm | 96% | 0.41 | 3% | Favorable |
| Ref. Example 3 | C | 21 nm | 95% | 0.20 | 4% | Favorable |
| Ref. Example 4 | H | 21 nm | 96% | 0.41 | 7% | Favorable |
| Comparative Example 1 | X | 32 nm | 88% | 0.18 | 24% | Residues found over the entire surface |
| Comparative Example 2 | Y | 15 nm | 97% | 0.35 | 2% | Residues found over the entire surface |
| Comparative Example 3 | Z | 75 nm | 70% | 0 | 60% | Residues found over the entire surface |

As shown in Table 2, black radiation-sensitive compositions A, B, C and H of the Reference Examples exhibited excellent stability over time as compared with black radiation-sensitive compositions X, Y, and Z of the Comparative Examples. Further, when a light blocking film is formed from the compositions of the Reference Examples, development residues were not found in the developed portions (i.e., portions outside the region at which the light blocking film is formed).

Reference Example 5

Black radiation-sensitive composition D was produced in the same manner as black radiation-sensitive composition B in Reference Example 2, except that binder solution 1 was changed to binder solution 2.

Example 6

Black radiation-sensitive composition E was produced in the same manner as black radiation-sensitive composition D of Reference Example 5, except that the polymerizable compound was changed to the following polymerizable compounds.

- KAYARAD DPHA (dipentaerythritol hexaacrylate, manufactured by Nippon Kayaku Co., Ltd.) 2.5 parts
- ATM-35E (manufactured by Shin-Nakamura Chemical Co., Ltd., having the structure shown below) 2.5 parts

ATM-35E 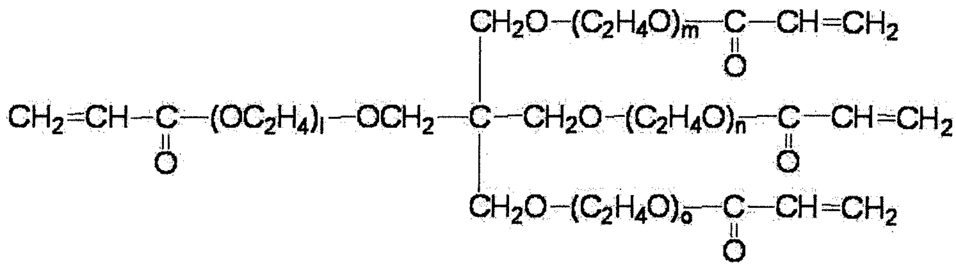

l+m+n+o=35

Reference Example 7

Black radiation-sensitive composition F was produced in the same manner as black radiation-sensitive composition B of Reference Example 2, except that the polymerizable compound was changed to the following polymerizable compounds.

- KAYARAD DPHA (dipentaerythritol hexaacrylate, manufactured by Nippon Kayaku Co., Ltd.) 2.5 parts
- A-TMMT (manufactured by Shin-Nakamura Chemical Co., Ltd., with the structure shown below) 2.5 parts

A-TMMT $C\text{-}(CH_2OCO\text{-}CH{=}CH_2)_4$

Example 8

Black radiation-sensitive composition G was produced in the same manner as the black radiation-sensitive composition F in Example 6, except that the photopolymerization initiator was changed to the photopolymerization initiator shown below.

- IRGACURE OXE1 (manufactured by BASF, with the structure shown below) 2.5 parts

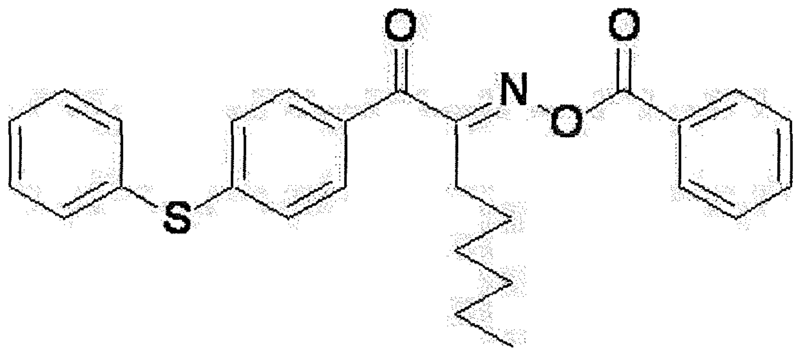

The black radiation-sensitive compositions obtained in Reference Examples 5 and 7 and Examples 6 and 8 were evaluated in the same manner as Reference Example 1.
The results are shown in Table 3.

Table 3

| | Radiation -sensitive compositio n | Particle diameter | Ratio of particles being 20 nm or less | Si/Ti ratio | Stability over time | Residues |
|---|---|---|---|---|---|---|
| Ref. Example 5 | D | 21 nm | 96% | 0.41 | 6% | Favorable |
| Example 6 | E | 21 nm | 96% | 0.41 | 6% | Favorable |

(continued)

| | Radiation -sensitive compositio n | Particle diameter | Ratio of particles being 20 nm or less | Si/Ti ratio | Stability over time | Residues |
|---|---|---|---|---|---|---|
| Ref. Example 7 | F | 21 nm | 96% | 0.41 | 2% | Favorable |
| Example 8 | G | 21 nm | 96% | 0.41 | 2% | Favorable |

As shown in Table 3, the black radiation-sensitive compositions of Examples 6 and 8 exhibited excellent stability over time. Further, when a light blocking film is formed from the compositions, development residues were not found in the developed portions (i.e., portions outside the region at which the light blocking film is formed).

## Claims

**1.** A black radiation-sensitive composition comprising:

(D) a photopolymerizable compound comprising at least one compound represented by Formula (Z-4) or Formula (Z-5):

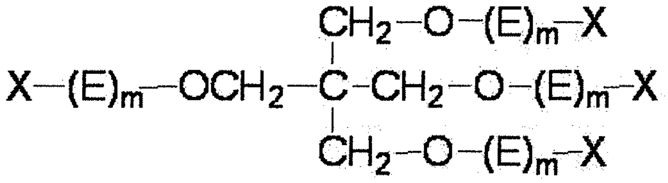

(Z-4)

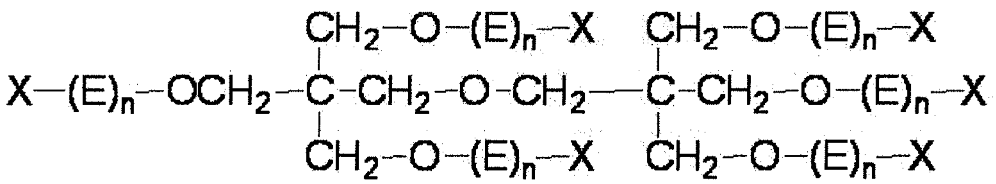

(Z-5)

wherein each E independently represents $-((CH_2)_yCH_2O)-$ or $-((CH_2)_yCH(CH_3)O)-$; each y independently represents an integer from 0 to 10; each X independently represents an acryloyl group, a methacryloyl group, a hydrogen atom or a carboxyl group; in Formula (Z-4) the sum of the acryloyl group/s and the methacryloyl group/s is 3 or 4, each m independently represents an integer from 0 to 10, and the sum of all m's is an integer from 0 to 40 provided that any one of X is a carboxyl group when the sum of all m's is 0; and in Formula (Z-5) the sum of the acryloyl group/s and the methacryloyl group/s is 5 or 6, each n independently represents an integer from 0 to 10, and the sum of all n's is an integer from 0 to 60 provided that any one of X is a carboxyl group when the sum of all n's is 0;
(E) a photopolymerization initiator; and
a titanium black dispersion composition comprising:

(A) particles comprising titanium black and Si atoms dispersed within the composition;
(B) a dispersant; and
(C) an organic solvent;

wherein 90% or more of the particles have a particle diameter in the range of 16-30 nm and the mass ratio (Si/Ti) of Si atoms to Ti atoms in the component (A) is from 0.20 to 0.50;
wherein the particle diameter of the dispersed particles is measured by dropping a liquid sample consisting of a 100-fold dilution of the titanium black dispersion composition in propylene glycol monomethyl ether acetate on carbon foil; drying the sample; obtaining a transmission electron microscope image of the dried sample; and calculating the particle diameter of each of 400 particles by determining the projected outer surface area of each particle and calculating the diameter of a sphere having the same outer surface; and

wherein the Si/Ti ratio is calculated by elemental analysis of a solution obtained by drying a sample of the titanium black dispersion composition by heating in an oxygen atmosphere; dissolving 20 mg of the dried sample in 0.1 mL of HF, 1 mL of 10 % aq. $HNO_3$, 1 mL of 5% aq. $H_2SO_4$ and 1 mL of 3% aq. HCl with the aid of microwave dissolution conducted at 180°C; and dissolving the obtained mixture in 100 mL of water ready for elemental analysis.

**2.** A black radiation-sensitive composition according to Claim 1, wherein the photopolymerizable initiator comprises an oxime compound.

**3.** A black radiation-sensitive composition according to Claim 1 or Claim 2, further comprising a fluorinated surfactant.

**4.** A black cured film obtainable by curing the black radiation-sensitive composition according to any preceding claim.

**5.** A solid-state imaging element comprising the black cured film according to Claim 4.

**6.** A method of producing a black cured film, the method comprising:

forming a black radiation-sensitive composition layer by applying the black radiation-sensitive composition according to any one of Claims 1 to 3 onto a silicon substrate;
exposing the black radiation-sensitive composition layer to light in a patterned manner; and
forming a pattern by developing the exposed black radiation-sensitive composition layer.

## Patentansprüche

**1.** Gegenüber schwarzer Strahlung empfindliche Zusammensetzung, welche umfasst:

(D) eine photopolymerisierbare Verbindung, die mindestens eine Verbindung gemäß Formel (Z-4) oder Formel (Z-5) umfasst:

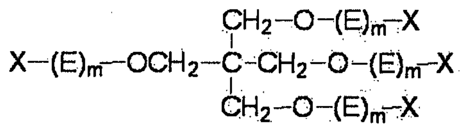

(Z-4)

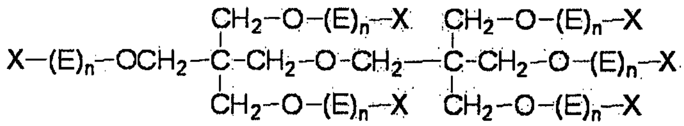

(Z-5)

wobei jedes E unabhängig $-((CH_2)_yCH_2O)-$ oder $-((CH_2)_yCH(CH_3)O)-$ ist; jedes y unabhängig eine ganze Zahl von 0 bis 10 ist; jedes X unabhängig eine Acryloylgruppe, eine Methacryloylgruppe, ein Wasserstoffatom oder eine Carboxylgruppe ist; in Formel (Z-4) die Summe der Acryloylgruppe/n und der Methacryloylgruppe/n 3 oder 4 beträgt, jedes m unabhängig eine ganze Zahl von 0 bis 10 ist und die Summe aller m eine ganze Zahl von 0 bis 40 ist, unter der Voraussetzung, dass jedes X eine Carboxylgruppe ist, wenn die Summe aller m 0 beträgt; und in Formel (Z-5) die Summe der Acryloylgruppe/n und der Methacryloylgruppe/n 5 oder 6 beträgt, jedes n unabhängig eine ganze Zahl von 0 bis 10 ist, und die Summe aller n eine ganze Zahl von 0 bis 60 ist, unter der Voraussetzung, dass jedes X eine Carboxylgruppe ist, wenn die Summe aller n 0 beträgt;
(E) einen Initiator für die Photopolymerisation; und eine Titanschwarz-Dispersionszusammensetzung, welche umfasst:

(A) Titanschwarz und Si-Atome umfassende Partikel, die in der Zusammensetzung dispergiert sind;
(B) ein Dispergiermittel; und
(C) ein organisches Lösungsmittel;

wobei 90% der Partikel oder mehr einen Partikeldurchmesser im Bereich von 16-30 nm aufweisen und das Gewichtsverhältnis (Si/Ti) der Si-Atome zu den Ti-Atomen in der Komponente (A) 0,20 bis 0,50 beträgt;

wobei der Partikeldurchmesser der dispergierten Partikel ermittelt wird durch Tropfen einer flüssigen Probe, die aus einer 100-fachen Verdünnung der Titanschwarz-Dispersionszusammensetzung in Propylenglycol-monomethyletheracetat besteht, auf eine Kohlenstofffolie; Trocknen der Probe; Aufnahme eines Bildes der getrockneten Probe mittels Transmissions-Elektronenmikroskopie; und Errechnen des Partikeldurchmessers von jeweils 400 Partikeln mittels Bestimmung der projizierten äußeren Oberfläche jeden Partikels und Berechnen des Durchmessers einer Kugel mit derselben äußeren Oberfläche; und
wobei das Si/Ti-Verhältnis durch Elementaranalyse einer Lösung, welche durch Trocknen einer Probe der Titanschwarz-Dispersionszusammensetzung mittels Erhitzen in einer Sauerstoffatmosphäre; Lösen von 20 mg der getrockneten Probe in 0,1 mL HF, 1 mL 10%-iger wässriger $HNO_3$, 1 mL 5%-iger wässriger $H_2SO_4$ und 1 mL 3%-iger wässriger HCl mit Hilfe von 180°C durchgeführtem Mikrowellen-Lösen; und Lösen der erhaltenen Mischung in 100 mL Wasser für die Elementaranalyse berechnet wird.

2. Gegenüber schwarzer Strahlung empfindliche Zusammensetzung gemäß Anspruch 1, wobei der Initiator für die Photopolymerisation eine Oximverbindung umfasst.

3. Gegenüber schwarzer Strahlung empfindliche Zusammensetzung gemäß Anspruch 1 oder Anspruch 2, die ferner ein fluoriertes Tensid umfasst.

4. Schwarzer gehärteter Film, welcher durch Härten der gegenüber schwarzer Strahlung empfindlichen Zusammensetzung gemäß einem der vorhergehenden Ansprüche erhalten werden kann.

5. Festkörper-Bildgebungselement, das den schwarzen gehärteten Film gemäß Anspruch 4 umfasst.

6. Verfahren zur Herstellung eines schwarzen gehärteten Films, wobei das Verfahren umfasst:

Bilden einer Schicht aus einer gegenüber schwarzer Strahlung empfindlichen Zusammensetzung durch Aufbringen der gegenüber schwarzer Strahlung empfindlichen Zusammensetzung gemäß einem der Ansprüche 1 bis 3 auf ein Siliziumsubstrat;
Belichten der gegenüber schwarzer Strahlung empfindlichen Schicht in strukturierter Weise mit Licht; und
Bilden einer Struktur durch Entwickeln der belichteten Schicht aus der gegenüber schwarzer Strahlung empfindlichen Zusammensetzung.

**Revendications**

1. Composition sensible au rayonnement noire comprenant :

(D) un composé photopolymérisable comprenant au moins un composé représenté par la formule (Z-4) ou la formule (Z-5) :

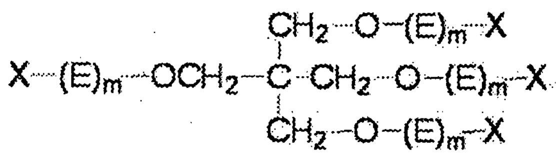

(Z-4)

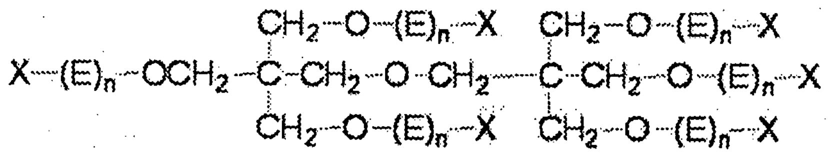

(Z-5)

dans laquelle chaque E représente indépendamment $-((CH_2)_yCH_2O)-$ ou $-((CH_2)_yCH(CH_3)O)-$; chaque y représente indépendamment un entier entre 0 et 10; chaque X représente indépendamment un groupe acryloyle, un groupe méthacryloyle, un atome d'hydrogène ou un groupe carboxyle; dans la formule (Z-4), la somme du ou des groupe(s) acryloyle et du ou des groupe(s) méthacryloyle est de 3 ou 4, chaque m représente indépendamment un entier entre 0 et 10, et la somme de tous les m est un entier entre 0 et 40 à condition qu'un quelconque X soit un groupe carboxyle lorsque la somme de tous les m est de 0; et dans la formule (Z-5), la

somme du ou des groupe(s) acryloyle et du ou des groupe(s) méthacryloyle est de 5 ou 6, chaque n représente indépendamment un entier entre 0 et 10, et la somme de tous les n est un entier entre 0 et 60 à condition qu'un quelconque X soit un groupe carboxyle lorsque la somme de tous les n est de 0 ;
(E) un initiateur de photopolymérisation ; et
une composition de dispersion de noir de titane comprenant :

(A) des particules comprenant du noir de titane et des atomes de Si dispersés dans la composition ;
(B) un dispersant; et
(C) un solvant organique;

dans laquelle 90% ou plus des particules ont un diamètre particulaire dans la plage de 16 à 30 nm et le rapport massique (Si/Ti) des atomes de Si sur les atomes de Ti dans le composant (A) est de 0,2 à 0,5 ;
dans laquelle le diamètre particulaire des particules dispersées est mesuré en déposant au goutte-à-goutte un échantillon liquide constitué d'une dilution au centième de la composition de dispersion de noir de titane dans de l'acétate de monométhyléther de propylèneglycol sur un film de carbone; en séchant l'échantillon; en obtenant une image au microscope électronique à transmission de l'échantillon séché; et en calculant le diamètre particulaire de chacune des 400 particules en déterminant la surface externe projetée de chaque particule et en calculant le diamètre d'une sphère ayant la même surface externe; et
dans laquelle le rapport Si/Ti est calculé par analyse élémentaire d'une solution obtenue en séchant un échantillon de la composition de dispersion de noir de titane en chauffant dans une atmosphère d'oxygène ; en dissolvant 20 mg de l'échantillon séché dans 0,1 ml de HF, 1 ml de $HNO_3$ dilué à 10% dans de l'eau, 1 ml de $H_2SO_4$ dilué à 5 % dans de l'eau et 1 ml de HCl dilué à 3 % dans de l'eau avec l'aide d'une dissolution aux micro-ondes réalisée à 180 °C; et en dissolvant le mélange obtenu dans 100 ml d'eau prête pour une analyse élémentaire.

**2.** Composition sensible au rayonnement noire selon la revendication 1, dans laquelle l'initiateur photopolymérisable comprend un composé d'oxime.

**3.** Composition sensible au rayonnement noire selon la revendication 1 ou la revendication 2, comprenant en outre un tensioactif fluoré.

**4.** Film noir durci pouvant être obtenu en faisant durcir la composition sensible au rayonnement noir selon une quelconque revendication précédente.

**5.** Élément d'imagerie à l'état solide comprenant le film durci noir selon la revendication 4.

**6.** Procédé pour produire un film durci noir, le procédé comprenant :

la formation d'une couche de composition sensible au rayonnement noire en appliquant la composition sensible au rayonnement noire selon l'une quelconque des revendications 1 à 3 sur un substrat de silicium ;
l'exposition de la couche de composition sensible au rayonnement noire à de la lumière selon un motif; et
la formation d'un motif en développant la couche de composition sensible au rayonnement noir exposée.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2007115921 A
- JP 2002285007 A
- US 2008318018 A
- JP 2008266045 A
- JP 2007302836 A
- JP 49005432 A
- JP 57205322 A
- JP 60065069 A
- JP 61201610 A
- JP 2272009 A
- JP 10300922 A
- GB 1388492 A
- JP 53133428 A
- DE 3337024
- JP 62058241 A
- JP 5281728 A
- JP 5034920 A
- US 4212976 A
- JP 5019475 A
- JP 7271028 A
- JP 2002363206 A
- JP 2002363207 A
- JP 2002363208 A
- JP 2002363209 A
- JP 57001819 B
- JP 57006096 B
- US 3615455 A
- JP 10291969 A
- JP 4225898 B
- JP 2009191179 A
- JP 2001233842 A
- JP 2000080068 A
- JP 2006342166 A
- JP 2000066385 A
- JP 2004534797 A
- JP 2009519904 A
- US 7626957 B
- JP 2010015025 A
- US 2009292039 A
- WO 2009131189 A
- US 7556910 B
- JP 2009221114 A
- JP 2007231000 A
- JP 2007322744 A
- JP 2010032985 A
- JP 2010185072 A
- JP 2009242469 A
- JP 2007269779 A
- JP 2009191061 A
- JP 2002229207 A
- JP 2003335814 A
- JP 7140654 A
- JP 2008224982 A
- JP 6490403 A
- JP 6491102 A
- JP 1094301 A
- JP 6011614 A
- JP 2592207 B
- US 4808501 A
- US 5667920 A
- US 5059500 A
- JP 5333207 A
- JP 6035183 A
- JP 6051115 A
- JP 6194828 A
- JP 8211599 A
- JP 4249549 A
- JP 10123316 A
- JP 11302283 A
- JP 7286107 A
- JP 2001004823 A
- JP 8015522 A
- JP 8029771 A
- JP 8146215 A
- JP 11343437 A
- JP 8062416 A
- JP 2002014220 A
- JP 2002014221 A
- JP 2002014222 A
- JP 2002014223 A
- JP 8302224 A
- JP 8073758 A
- JP 8179120 A
- JP 8151531 A
- JP 2008214395 A


### Non-patent literature cited in the description


- **WAKABAYASHI.** *Bull. Chem. Soc. Japan,* 1969, vol. 42, 2924
- **F. C. SCHAEFER.** *J. Org. Chem.,* 1964, vol. 29, 1527

- *J. C. S. Perkin II,* 1979, 1653-1660
- *J. C. S. Perkin II,* 1979, 156-162
- *Journal of Photopolymer Science and Technology,* 1995, 202-232